# EUROPEAN PATENT APPLICATION

(11) **EP 4 206 356 A1**
(43) Date of publication of application: **05.07.2023**
(21) Application number: 21860663.0
(22) Date of filing: 17.08.2021
(51) Int. Cl.: C23C 16/455, C23C 16/40, H01L 21/336, H01L 21/365, H01L 21/8242, H01L 27/108, H01L 27/11556, H01L 27/1156, H01L 29/788, H01L 29/792

(54) **METHOD FOR FORMING FILM OF METAL OXIDE, AND METHOD FOR MANUFACTURING STORAGE DEVICE**

(30) Priority: 26.08.2020 JP 2020142860
(71) Applicant: Semiconductor Energy Laboratory Co., Ltd., Atsugi-shi, Kanagawa 243-0036 (JP)
(72) Inventor: YAMAZAKI, Shunpei, Atsugi-shi, Kanagawa 243-0036 (JP); EGI, Yuji, Atsugi-shi, Kanagawa 243-0036 (JP); JINBO, Yasuhiro, Atsugi-shi, Kanagawa 243-0036 (JP); KUNITAKE, Hitoshi, Atsugi-shi, Kanagawa 243-0036 (JP)
(74) Representative: Grünecker Patent- und Rechtsanwälte PartG mbB
(86) International application number: PCT/IB2021/057536
(87) International publication number: WO 2022/043824

(57) **Abstract**

A method for depositing a metal oxide is provided. The deposition method of a metal oxide includes a first step of introducing a first precursor into a first chamber, a second step of introducing a second precursor into the first chamber, a third step of introducing a third precursor into the first chamber, a fourth step of introducing an oxidizer in a plasma state into the first chamber after each of the first step, the second step, and the third step, and a fifth step of performing microwave treatment. Performing each of the first to fourth steps one or more times is regarded as one cycle, and the fifth step is performed in a second chamber after the one cycle is repeated a plurality of times. The first to third precursors are different kinds of precursors, the microwave treatment is performed using an oxygen gas and an argon gas, the metal oxide includes a crystal region, and a c-axis of the crystal region is substantially parallel to a normal vector of a surface where the metal oxide is formed or a normal vector of a surface of the metal oxide.

## Description

### Technical Field

One embodiment of the present invention relates to a metal oxide and a deposition method thereof and a memory device and a manufacturing method thereof.

Note that one embodiment of the present invention is not limited to the above technical field. The technical field of the invention disclosed in this specification and the like relates to an object, a method, or a manufacturing method. One embodiment of the present invention relates to a process, a machine, manufacture, or a composition of matter.

Note that in this specification and the like, a semiconductor device generally means a device that can function by utilizing semiconductor characteristics. Thus, a semiconductor element such as a transistor or a diode or a circuit including a semiconductor element is a semiconductor device. A display device, a light-emitting device, a lighting device, an electro-optical device, a memory device, an imaging device, a communication device, a data processing device, an electronic device, and the like may include a semiconductor element or a semiconductor circuit. A display device, a light-emitting device, a lighting device, an electro-optical device, a memory device, an imaging device, a communication device, an electronic device, and the like may also be referred to as semiconductor devices.

### Background Art

In recent years, with an increasing amount of data to process, a semiconductor device having a larger storage capacity has been required. To increase storage capacity per unit area, stacking memory cells is effective (see Patent Document 1 and Patent Document 2). Stacking memory cells can increase storage capacity per unit area in accordance with the number of stacked layers including memory cells. Patent Document 3 and Patent Document 4 disclose memory devices that use an oxide semiconductor. Patent Document 5 discloses a semiconductor memory that uses an oxide semiconductor as a charge storage layer.

Non-patent Document 1 discloses a CAAC-IGZO as a crystalline oxide semiconductor. Non-patent Document 1 also discloses the growth mechanism and the like of the CAAC-IGZO.

### [References]

### [Patent Documents]

[Patent Document 1] United States Patent Application Publication No. 2011/0065270A1
[Patent Document 2] United States Patent No. 9634097B2
[Patent Document 3] Japanese Published Patent Application No. 2018-207038
[Patent Document 4] Japanese Published Patent Application No. 2019-8862
[Patent Document 5] Japanese Published Patent Application No. 2018-157205

### [Non-Patent Document]

[Non-Patent Document 1] Noboru Kimizuka and Shunpei Yamazaki, "PHYSICS AND TECHNOLOGY OF CRYSTALLINE OXIDE SEMICONDUCTOR CAAC-IGZO" FUNDAMENTALS (the United States), Wiley-SID Series in Display Technology, 2017, pp. 94-97

### Summary of the Invention

### Problems to be Solved by the Invention

In Patent Document 1 and Patent Document 2, a plurality of memory elements (also referred to as memory cells) are stacked and connected in series, so that a three-dimensional memory cell array (also referred to as a memory string) is formed.

In Patent Document 1, a semiconductor provided in a columnar shape is in contact with an insulator including a charge accumulation layer. In Patent Document 2, a semiconductor provided in a columnar shape is in contact with an insulator functioning as a tunnel dielectric. In both Patent Document 1 and Patent Document 2, writing of data to the memory cells is performed by extraction and injection of charge through the insulator. In this case, trap centers might be formed at the interface where the semiconductor and the insulator are in contact with each other. The trap centers can shift the threshold voltage of the transistor by trapping electrons, in some cases. In addition, one or both of the inside of the insulator and the interface where the semiconductor and the insulator are in contact with each other deteriorate due to the extraction and injection of charge, resulting in the leakage and loss of charge held in the charge accumulation layer in some cases. This can adversely affect the reliability of the memory device.

An object of one embodiment of the present invention is to provide a novel metal oxide and a deposition method thereof. Another object of one embodiment of the present invention is to provide a deposition apparatus for a novel metal oxide. Another object of one embodiment of the present invention is to provide a highly reliable memory device and a manufacturing method thereof. Another object of one embodiment of the present invention is to provide a memory device with a large storage capacity and a manufacturing method thereof. Another object of one embodiment of the present invention is to provide a memory device that occupies a small area and a manufacturing method thereof. Another object of one embodiment of the present invention is to provide a memory device with low manufacturing cost and a manufacturing method thereof. Another object of one embodiment of the present invention is to provide a highly reliable semiconductor device and a manufacturing method thereof. Another object of one embodiment of the present invention is to provide a semiconductor device with low manufacturing cost and a manufacturing method thereof. Another object of one embodiment of the present invention is to provide a novel semiconductor device and a manufacturing method thereof.

Note that the description of these objects does not preclude the existence of other objects. One embodiment of the present invention does not need to achieve all the objects. Other objects will be apparent from and can be derived from the description of the specification, the drawings, the claims, and the like.

### Means for Solving the Problems

One embodiment of the present invention is a method for depositing a metal oxide, including a first step of introducing a first precursor into a first chamber; a second step of introducing a second precursor into the first chamber; a third step of introducing a third precursor into the first chamber; a fourth step of introducing an oxidizer in a plasma state into the first chamber after each of the first step, the second step, and the third step; and a fifth step of performing microwave treatment. Performing each of the first to fourth steps one or more times is regarded as one cycle, and the fifth step is performed in a second chamber after the one cycle is repeated a plurality of times. The first to third precursors are different kinds of precursors, the microwave treatment is performed using an oxygen gas and an argon gas, the metal oxide includes a crystal region, and a c-axis of the crystal region is substantially parallel to a normal vector of a surface where the metal oxide is formed or a normal vector of a surface of the metal oxide.

One embodiment of the present invention is a method for depositing a metal oxide, including a first step of introducing a first precursor into a first chamber; a second step of introducing a second precursor into the first chamber; a third step of introducing a third precursor into the first chamber; a fourth step of introducing an oxidizer into the first chamber after each of the first step, the second step, and the third step; and a fifth step of performing microwave treatment. Performing each of the first to fourth steps one or more times is regarded as one cycle, and the fifth step is performed in a second chamber after the one cycle is repeated a plurality of times. The first to third precursors are different kinds of precursors, the microwave treatment is performed using an oxygen gas and an argon gas, the metal oxide includes a crystal region, and a c-axis of the crystal region is substantially parallel to a normal vector of a surface where the metal oxide is formed or a normal vector of a surface of the metal oxide.

In the above method for depositing a metal oxide, the first chamber and the second chamber are preferably the same chamber.

In the above method for depositing a metal oxide, the one cycle is preferably repeated a plurality of times after the fifth step.

Another embodiment of the present invention is a method for depositing a metal oxide, including a first step of introducing a first precursor into a chamber; a second step of introducing a second precursor into the chamber; a third step of introducing a third precursor into the chamber; and a fourth step of introducing an oxidizer in a plasma state into the chamber after each of the first step, the second step, and the third step. The oxidizer turns into the plasma state by being applied with a microwave with a frequency of 2.45 GHz, performing each of the first to fourth steps one or more times is regarded as one cycle, and the one cycle is repeated a plurality of times. The first to third precursors are different kinds of precursors, the metal oxide includes a crystal region, and a c-axis of the crystal region is substantially parallel to a normal vector of a surface where the metal oxide is formed or a normal vector of a surface of the metal oxide.

Another embodiment of the present invention is a method for depositing a metal oxide, including a first step of introducing a first precursor into a chamber; a second step of introducing a second precursor into the chamber; a third step of introducing a third precursor into the chamber; and a fourth step of introducing an oxidizer into the chamber after each of the first step, the second step, and the third step. A microwave is applied to at least one of the first precursor to the third precursor, performing each of the first to fourth steps one or more times is regarded as one cycle, and the one cycle is repeated a plurality of times. The first to third precursors are different kinds of precursors, the metal oxide includes a crystal region, and a c-axis of the crystal region is substantially parallel to a normal vector of a surface where the metal oxide is formed or a normal vector of a surface of the metal oxide.

In the above method for depositing a metal oxide, it is preferable that the first precursor contain indium, the second precursor contain an element *M* (*M* is any one or more of gallium, aluminum, and yttrium), the third precursor contain zinc, and the oxidizer contain one or more selected from ozone, oxygen, and water.

Another embodiment of the present invention is a method for manufacturing a memory device including a first insulator; a first conductor containing a first opening over the first insulator; a second insulator containing a second opening over the first conductor; a second conductor containing a third opening over the second insulator; a third insulator over the second conductor; and a metal oxide provided in the first opening to the third opening. The method for manufacturing a memory device includes a step of forming the first insulator; a step of forming the first conductor over the first insulator; a step of forming the second insulator over the first conductor; a step of forming a fourth insulator over the second insulator; a step of forming the third insulator over the fourth insulator; a step of forming the third opening in the fourth insulator; a step of forming the second opening in the second insulator; a step of forming the first opening in the first conductor; a step of forming the metal oxide by an ALD method in the first opening to the third opening; a step of performing microwave treatment; a step of removing the fourth insulator; and a step of forming the second conductor between the second insulator and the third insulator. The microwave treatment is performed using an oxygen gas and an argon gas, the metal oxide includes a crystal region, and a c-axis of the crystal region is parallel to a normal vector of a surface where the metal oxide is formed or a normal vector of a surface of the metal oxide.

In the above method for manufacturing a memory device, it is preferable that a diameter of the first opening be larger than a diameter of the second opening and the diameter of the first opening be larger than a diameter of the third opening.

### Effect of the Invention

In manufacture of a three-dimensional memory cell array in which a plurality of memory elements are stacked and connected in series, the total number of steps can be smaller than the product of the number of stacked memory elements and the number of steps for manufacturing one memory element, which is preferable. This means that, the number of manufacturing steps of the memory cell array is not proportional to the number of stacked memory elements. For example, when the number of manufacturing steps of a memory cell array B including 32 layers of memory elements is compared with the number of manufacturing steps of a memory cell array A including 4 layers of memory elements, the number of manufacturing steps of the memory cell array B can be significantly smaller than eight times the number of manufacturing steps of the memory cell array A in spite of the number of stacked layers including memory elements eight times larger.

One embodiment of the present invention can provide a novel metal oxide and a deposition method thereof. One embodiment of the present invention can provide a deposition apparatus for a novel metal oxide. One embodiment of the present invention can provide a highly reliable memory device and a manufacturing method thereof. One embodiment of the present invention can provide a memory device with a large storage capacity and a manufacturing method thereof. One embodiment of the present invention can provide a memory device that occupies a small area and a manufacturing method thereof. One embodiment of the present invention can provide a memory device with low manufacturing cost and a manufacturing method thereof. One embodiment of the present invention can provide a highly reliable semiconductor device and a manufacturing method thereof. One embodiment of the present invention can provide a semiconductor device with low manufacturing cost and a manufacturing method thereof. One embodiment of the present invention can provide a novel semiconductor device and a manufacturing method thereof.

Note that the description of these effects does not preclude the existence of other effects. One embodiment of the present invention does not have to have all these effects. Other effects will be apparent from and can be derived from the description of the specification, the drawings, the claims, and the like.

### Brief Description of the Drawings

FIG. 1A to FIG. 1D are cross-sectional views of a metal oxide of one embodiment of the present invention.
FIG. 2A is a top view illustrating a deposition apparatus of one embodiment of the present invention. FIG. 2B is a cross-sectional view illustrating a deposition apparatus of one embodiment of the present invention.
FIG. 3A to FIG. 3C are cross-sectional views illustrating deposition apparatuses of one embodiment of the present invention.
FIG. 4 is a top view illustrating a microwave treatment apparatus of one embodiment of the present invention.
FIG. 5 is a cross-sectional view illustrating a microwave treatment apparatus of one embodiment of the present invention.
FIG. 6 is a cross-sectional view illustrating a microwave treatment apparatus of one embodiment of the present invention.
FIG. 7 is a cross-sectional view illustrating a microwave treatment apparatus of one embodiment of the present invention.
FIG. 8A and FIG. 8B are diagrams showing deposition methods of a metal oxide of one embodiment of the present invention.
FIG. 9A is a diagram showing a classification of crystal structures of IGZO. FIG. 9B is a graph showing an XRD spectrum of a CAAC-IGZO film. FIG. 9C is an image showing a nanobeam electron diffraction pattern of a CAAC-IGZO film.
FIG. 10 is a perspective view of a memory device of one embodiment of the present invention.
FIG. 11 is a cross-sectional view of a memory device of one embodiment of the present invention.
FIG. 12 is a cross-sectional view of a memory string of one embodiment of the present invention.
FIG. 13A and FIG. 13B are cross-sectional views of a memory string of one embodiment of the present invention.
FIG. 14 is a cross-sectional view of a memory element of one embodiment of the present invention.
FIG. 15 is a cross-sectional view illustrating a manufacturing process of a semiconductor device of one embodiment of the present invention.
FIG. 16 is a cross-sectional view illustrating a manufacturing process of a semiconductor device of one embodiment of the present invention.
FIG. 17 is a cross-sectional view illustrating a manufacturing process of a semiconductor device of one embodiment of the present invention.
FIG. 18 is a cross-sectional view illustrating a manufacturing process of a semiconductor device of one embodiment of the present invention.
FIG. 19A and FIG. 19B are cross-sectional views illustrating manufacturing processes of a semiconductor device of one embodiment of the present invention.
FIG. 20 is a cross-sectional view illustrating a manufacturing process of a semiconductor device of one embodiment of the present invention.
FIG. 21 is a cross-sectional view illustrating a manufacturing process of a semiconductor device of one embodiment of the present invention.
FIG. 22 is a cross-sectional view illustrating a manufacturing process of a semiconductor device of one embodiment of the present invention.
FIG. 23 is a cross-sectional view illustrating a manufacturing process of a semiconductor device of one embodiment of the present invention.
FIG. 24 is a cross-sectional view illustrating a manufacturing process of a semiconductor device of one embodiment of the present invention.
FIG. 25 is a cross-sectional view illustrating a manufacturing process of a semiconductor device of one embodiment of the present invention.
FIG. 26 is a cross-sectional view illustrating a manufacturing process of a semiconductor device of one embodiment of the present invention.
FIG. 27 is a diagram illustrating a circuit configuration example of a memory string.
FIG. 28 is a diagram illustrating a circuit configuration example of a memory string.
FIG. 29 is a timing chart showing a writing operation example of a memory string.
FIG. 30A and FIG. 30B are circuit diagrams illustrating writing operation example of a memory string.
FIG. 31A and FIG. 31B are circuit diagrams illustrating writing operation example of a memory string.
FIG. 32A and FIG. 32B are circuit diagrams illustrating writing operation example of a memory string.
FIG. 33A and FIG. 33B are circuit diagrams illustrating writing operation example of a memory string.
FIG. 34A and FIG. 34B are circuit diagrams illustrating writing operation example of a memory string.
FIG. 35A and FIG. 35B are timing charts showing reading operation examples of a memory string.
FIG. 36A and FIG. 36B are circuit diagrams illustrating reading operation example of a memory string.
FIG. 37A and FIG. 37B are circuit diagrams illustrating reading operation example of a memory string.
FIG. 38A and FIG. 38B are diagrams showing Id-Vg characteristics of transistors.
FIG. 39 is a diagram illustrating a circuit configuration example of a memory string.
FIG. 40 is a diagram illustrating a circuit configuration example of a memory string.
FIG. 41 is a diagram illustrating a circuit configuration example of a memory string.
FIG. 42 is a block diagram illustrating a structure example of a semiconductor device.
FIG. 43A to FIG. 43C are perspective views illustrating structure examples of a semiconductor device.
FIG. 44 is a cross-sectional view illustrating a semiconductor device of one embodiment of the present invention.
FIG. 45A is a perspective view illustrating a structure example of a computer and FIG. 45B is a perspective view illustrating a monolithic IC.
FIG. 46A and FIG. 46B are diagrams illustrating memory hierarchies of a computer and a monolithic IC, respectively.
FIG. 47A is a schematic diagram of a semiconductor device. FIG. 47B is a perspective view of a semiconductor device.
FIG. 48A to FIG. 48E are diagrams each illustrating an example of a memory device.
FIG. 49A to FIG. 49G are diagrams each illustrating an example of an electronic device.

### Mode for Carrying Out the Invention

Embodiments are described in detail with reference to the drawings. However, the present invention is not limited to the following description, and it is readily appreciated by those skilled in the art that modes and details can be modified in various ways without departing from the spirit and the scope of the present invention. Thus, the present invention should not be construed as being limited to the description in the following embodiments. Note that in the structures of the invention described below, the same portions or portions having similar functions are denoted by the same reference numerals in different drawings, and description thereof is not repeated.

In addition, the position, size, range, and the like of each component illustrated in the drawings and the like do not represent the actual position, size, range, and the like in some cases for easy understanding of the invention. Therefore, the disclosed invention is not necessarily limited to the position, size, range, or the like disclosed in drawings and the like. For example, in an actual manufacturing process, a resist mask or the like might be unintentionally reduced in size by treatment such as etching, which might not be reflected in the drawings for easy understanding.

In drawings and the like, some components are omitted for easy understanding of the explanation, in some cases.

In addition, in this specification and the like, the term "electrode" or "wiring" does not functionally limit these components. For example, an "electrode" is used as part of a "wiring" in some cases, and vice versa. Furthermore, the term "electrode" or "wiring" also includes the case where a plurality of "electrodes" or "wirings" are formed in an integrated manner, for example.

In this specification and the like, a "terminal" in an electric circuit refers to a portion that inputs or outputs a current, inputs or outputs a voltage, or receives or transmits a signal. Accordingly, part of a wiring or an electrode functions as a terminal in some cases.

Note that the term "over" or "under" in this specification and the like does not necessarily mean that a component is placed directly over and in contact with or directly under and in contact with another component. For example, the expression "electrode B over insulating layer A" does not necessarily mean that the electrode B is formed on and in direct contact with the insulating layer A, and does not exclude the case where another component is provided between the insulating layer A and the electrode B.

In addition, functions of a source and a drain are interchanged with each other depending on operation conditions and the like, for example, when a transistor of different polarity is employed or when the current direction is changed in a circuit operation; therefore, it is difficult to define which is the source or the drain. Thus, the terms "source" and "drain" can be interchangeably used in this specification.

In this specification and the like, the expression "electrically connected" includes the case where components are directly connected to each other and the case where components are connected through an "object having any electric function". Here, there is no particular limitation on the "object having any electric function" as long as electric signals can be transmitted and received between components that are connected through the object. Thus, even when the expression "electrically connected" is used, there is a case where no physical connection portion is made and a wiring is just extended in an actual circuit.

Furthermore, in this specification and the like, "parallel" indicates a state where two straight lines are placed at an angle of greater than or equal to -10° and less than or equal to 10°, for example. Accordingly, the case where the angle is greater than or equal to -5° and less than or equal to 5° is also included. In addition, "substantially parallel" indicates a state where two straight lines are placed at an angle greater than or equal to -30° and less than or equal to 30°. Moreover, "perpendicular" and "orthogonal" indicate a state where two straight lines are placed at an angle of greater than or equal to 80° and less than or equal to 100°, for example. Accordingly, the case where the angle is greater than or equal to 85° and less than or equal to 95° is also included. Furthermore, "substantially perpendicular" and "substantially orthogonal" indicate a state where two straight lines are placed at an angle greater than or equal to 60° and less than or equal to 120°.

In this specification and the like, the terms "identical", "same", "equal", "uniform", and the like used in describing calculation values and measurement values or in describing objects, methods, events, and the like that can be converted into calculation values or measurement values allow for a margin of error of ±20 % unless otherwise specified.

In addition, a voltage refers to a potential difference between a certain potential and a reference potential (e.g., a ground potential or a source potential) in many cases. Therefore, the terms "voltage" and "potential" can be replaced with each other in many cases. In this specification and the like, the terms "voltage" and "potential" can be replaced with each other unless otherwise specified.

Note that a "semiconductor" has characteristics of an "insulator" when conductivity is sufficiently low, for example. Thus, a "semiconductor" can be replaced with an "insulator". In that case, a "semiconductor" and an "insulator" cannot be strictly distinguished from each other because a border therebetween is not clear. Accordingly, a "semiconductor" and an "insulator" described in this specification can be replaced with each other in some cases.

Furthermore, a "semiconductor" has characteristics of a "conductor" when conductivity is sufficiently high, for example. Thus, a "semiconductor" can be replaced with a "conductor". In that case, a "semiconductor" and a "conductor" cannot be strictly distinguished from each other because a border therebetween is not clear. Accordingly, a "semiconductor" and a "conductor" described in this specification can be replaced with each other in some cases.

Note that ordinal numbers such as "first" and "second" in this specification and the like are used in order to avoid confusion among components and do not denote the priority or the order such as the order of steps or the stacking order. A term without an ordinal number in this specification and the like might be provided with an ordinal number in the scope of claims in order to avoid confusion among components. Furthermore, a term with an ordinal number in this specification and the like might be provided with a different ordinal number in the scope of claims. Furthermore, even when a term is provided with an ordinal number in this specification and the like, the ordinal number might be omitted in the scope of claims and the like.

Note that in this specification and the like, an "on state" of a transistor refers to a state in which a source and a drain of the transistor are electrically short-circuited (also referred to as a "conduction state"). Furthermore, an "off state" of a transistor refers to a state in which a source and a drain of the transistor are electrically disconnected (also referred to as a "non-conduction state").

In addition, in this specification and the like, an "on-state current" sometimes refers to a current that flows between a source and a drain when a transistor is in an on state. Furthermore, an "off-state current" sometimes refers to a current that flows between a source and a drain when a transistor is in an off state.

In this specification and the like, a high power supply potential VDD (hereinafter, also simply referred to as "VDD", "H potential", or "H") is a power supply potential higher than a low power supply potential VSS (hereinafter, also simply referred to as "VSS", "L potential", or "L"). VSS refers to a power supply potential at a potential lower than VDD. A ground potential (hereinafter, also simply referred to as "GND" or "GND potential") can be used as VDD or VSS. For example, in the case where VDD is a ground potential, VSS is a potential lower than the ground potential, and in the case where VSS is a ground potential, VDD is a potential higher than the ground potential.

Unless otherwise specified, transistors described in this specification and the like are enhancement (normally off) n-channel field-effect transistors. Thus, the threshold voltage (also referred to as "Vth") is higher than 0 V. Furthermore, unless otherwise specified, "an H potential is supplied to a gate of a transistor" means that "the transistor is brought into an on state" in some cases. Also, unless otherwise specified, "an L potential is supplied to a gate of a transistor" means that "the transistor is brought into an off state" in some cases.

In addition, in this specification and the like, a gate refers to part or the whole of a gate electrode and a gate wiring. A gate wiring refers to a wiring for electrically connecting at least one gate electrode of a transistor to another electrode or another wiring.

Furthermore, in this specification and the like, a source refers to part or the whole of a source region, a source electrode, and a source wiring. A source region refers to a region in a semiconductor layer, where the resistivity is lower than or equal to a given value. A source electrode refers to part of a conductive layer that is connected to a source region. A source wiring refers to a wiring for electrically connecting at least one source electrode of a transistor to another electrode or another wiring.

Moreover, in this specification and the like, a drain refers to part or the whole of a drain region, a drain electrode, and a drain wiring. A drain region refers to a region in a semiconductor layer, where the resistivity is lower than or equal to a given value. A drain electrode refers to part of a conductive layer that is connected to a drain region. A drain wiring refers to a wiring for electrically connecting at least one drain electrode of a transistor to another electrode or another wiring.

In the drawings and the like, for easy understanding of the potentials of a wiring, an electrode, a conductor, and the like, "H" representing an H potential or "L" representing an L potential is sometimes written near the wiring, the electrode, the conductor, and the like. In addition, enclosed "H" or "L" is sometimes written near a wiring, an electrode, a conductor, and the like whose potential has changed. Moreover, in the case where a transistor is in an off state, a symbol "×" is sometimes written on the transistor.

In general, a "capacitor" has a structure in which two electrodes face each other with an insulator (dielectric) therebetween. This specification and the like include a case where a "capacitor element" is the above-described "capacitor". That is, this specification and the like include cases where a "capacitor element" is one having a structure in which two electrodes face each other with an insulator therebetween, one having a structure in which two wirings face each other with an insulator therebetween, or one in which two wirings are positioned with an insulator therebetween.

In this specification and the like, when a plurality of components are denoted by the same reference numeral and, in particular, need to be distinguished from each other, an identification sign such as "_1", "_2", "[*n*]", or "[*m*,*n*]" is sometimes added to the reference numeral. For example, the second conductor WWL may be expressed as a conductor WWL[2].

In this specification, in the case where the maximum value and the minimum value are specified, a structure in which the maximum value and the minimum value are freely combined is disclosed.

### (Embodiment 1)

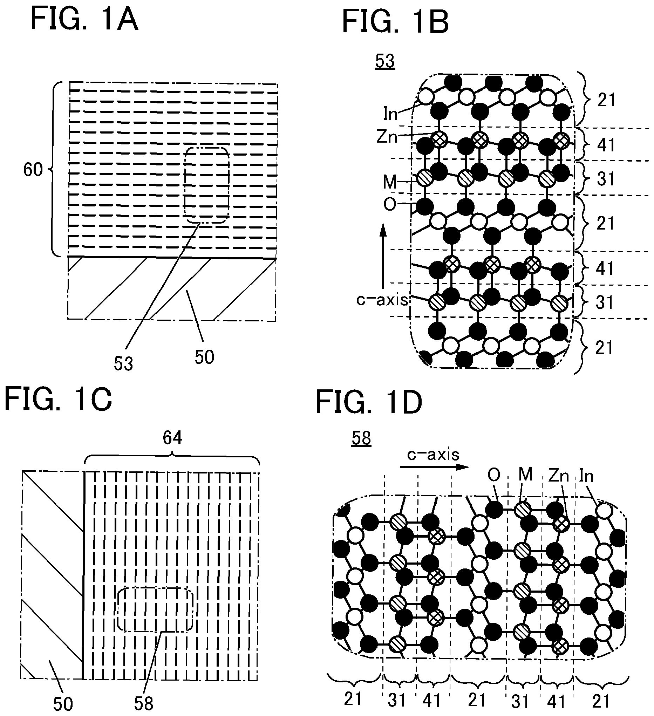

In this embodiment, a metal oxide (hereinafter, also referred to as an oxide semiconductor or an oxide in some cases) that can be used for a semiconductor layer of a transistor and a deposition method thereof are described with reference to FIG. 1 to FIG. 9. Note that a metal oxide of one embodiment of the present invention is used for not only a semiconductor layer of a transistor but also an insulating material or a conductive material depending on the kind, combination, composition, or the like of constituent elements of the metal oxide.

A metal oxide has a lattice defect in some cases. Examples of the lattice defect include point defects such as an atomic vacancy and an exotic atom, linear defects such as transition, plane defects such as a grain boundary, and volume defects such as a cavity. Examples of a factor in generating a lattice defect include the deviation of the proportion of the number of atoms in constituent elements (excess or deficiency of constituent atoms) and an impurity.

When a metal oxide is used for a semiconductor layer of a transistor, a lattice defect in the metal oxide might cause generation, capture, or the like of a carrier. Thus, when a metal oxide with a large number of lattice defects is used for a semiconductor layer of a transistor, the electrical characteristics of the transistor might be unstable. Therefore, a metal oxide used for a semiconductor layer of a transistor preferably has a small number of lattice defects.

A transistor using a metal oxide is likely to change its electrical characteristics especially in the case where oxygen vacancies (V_{O}) and impurities exist in a region of the metal oxide where a channel is formed, which might degrade the reliability. In some cases, hydrogen in the vicinity of an oxygen vacancy forms a defect that is an oxygen vacancy into which hydrogen enters (hereinafter, sometimes referred to as a V_{O}H defect), which generates an electron serving as a carrier. Therefore, when the channel formation region in the metal oxide includes oxygen vacancies, the transistor is likely to have normally-on characteristics (characteristics with which, even when no voltage is applied to the gate electrode, the channel exists and current flows through the transistor). Therefore, oxygen vacancies and impurities are preferably reduced as much as possible in the channel formation region in the metal oxide. In other words, it is preferable that the region of the metal oxide where a channel is formed have a reduced carrier concentration and be of an i-type (intrinsic) or substantially i-type.

The kind of a lattice defect that is likely to exist in a metal oxide and the number of lattice defects that exist vary depending on the structure of the metal oxide, a method for depositing the metal oxide, or the like.

Structures of metal oxides are classified into a single crystal structure and other structures (non-single-crystal structures). Examples of non-single-crystal structures include a CAAC (c-axis aligned crystalline) structure, a polycrystalline structure, an nc (nanocrystalline) structure, an amorphous-like (a-like) structure, and an amorphous structure. An a-like structure has a structure between an nc structure and an amorphous structure. Note that the classification of crystal structures will be described later.

A metal oxide having an a-like structure and a metal oxide having an amorphous structure each include a void or a low-density region. That is, a metal oxide having an a-like structure and a metal oxide having an amorphous structure each have low crystallinity compared with a metal oxide having an nc structure and a metal oxide having a CAAC structure. Moreover, a metal oxide having an a-like structure has higher hydrogen concentration in the metal oxide than a metal oxide having an nc structure and a metal oxide having a CAAC structure. Thus, a lattice defect is likely to be generated in a metal oxide having an a-like structure and a metal oxide having an amorphous structure.

Therefore, a metal oxide with high crystallinity is preferably used for a semiconductor layer of a transistor. For example, a metal oxide having a CAAC structure or a metal oxide having a single crystal structure is preferably used. The use of the metal oxide for a transistor enables a transistor having favorable electrical characteristics. In addition, a transistor having high reliability can be achieved.

Note that the metal oxide with high crystallinity does not include a metal oxide having a polycrystalline structure. A polycrystalline structure is a crystal structure in which a clear grain boundary is observed. In the case where a metal oxide having a polycrystalline structure is used for a semiconductor layer of a transistor, it is highly probable that the grain boundary becomes a recombination center and captures carriers and thus decreases the on-state current and field-effect mobility of a transistor, for example.

For the channel formation region of a transistor, a metal oxide that increases the on-state current of the transistor is preferably used. To increase the on-state current of the transistor, the mobility of the metal oxide used for the transistor is increased. To increase the mobility of the metal oxide, the transfer of carriers (electrons in the case of an n-channel transistor) needs to be facilitated or scattering factors that adversely affect the carrier transfer need to be reduced. Note that the carriers flow from the source to the drain through the channel formation region. Hence, the on-state current of the transistor can be increased by providing a channel formation region through which carriers can easily flow in the channel length direction.

Here, it is preferable to use a metal oxide with high crystallinity for a metal oxide including a channel formation region. The crystal region included in the metal oxide preferably has a crystal structure in which a plurality of layers (for example, a first layer, a second layer, and a third layer) are stacked. That is, the crystal region has a layered crystal structure (also referred to as a layered crystal or a layered structure). At this time, the direction of the c-axis of the crystal region is the direction in which the plurality of layers are stacked. Examples of a metal oxide including the crystal region include a single crystal oxide semiconductor, a CAAC-OS which is described later, and the like.

The c-axis of the above crystal region is preferably aligned in the normal direction with respect to the formation surface or film surface of the metal oxide. This enables the plurality of layers to be placed substantially parallel to the formation surface or film surface of the metal oxide. In other words, each of the plurality of layers extends in the channel length direction.

The above layered crystal structure including three layers is as follows, for example. The first layer has a coordination geometry of atoms that has an octahedral structure of oxygen in which a metal included in the first layer is positioned at the center. The second layer has a coordination geometry of atoms that has a trigonal bipyramidal or tetrahedral structure of oxygen in which a metal included in the second layer is positioned at the center. The third layer has a coordination geometry of atoms that has a trigonal bipyramidal or tetrahedral structure of oxygen in which a metal included in the third layer is positioned at the center.

Examples of the crystal structure of the above crystal region are a YbFe₂O₄ type structure, a Yb₂Fe₃O₇ type structure, their deformed structures, and the like.

The above structure can increase the crystallinity of the metal oxide, which leads to an increase in the mobility of the metal oxide. Thus, the use of the metal oxide for the channel formation region of the transistor increases the on-state current of the transistor, leading to an improvement in the electrical characteristics of the transistor.

The metal oxide preferably contains at least indium or zinc. It is particularly preferable that indium and zinc be contained. In addition to them, a metal element with the same valence as that of indium or zinc is preferably contained. Examples of the metal element are aluminum, gallium, yttrium, and the like. One or more kinds selected from iron, cobalt, nickel, lanthanum, cerium, neodymium, magnesium, calcium, and the like may be contained.

Here, the case where the metal oxide is an In-*M*-Zn oxide that contains indium (In), an element *M,* and zinc (Zn) is considered. The element *M* is aluminum, gallium, yttrium, or the like. Examples of other elements that can be used as the element M include iron, cobalt, nickel, lanthanum, cerium, neodymium, magnesium, and calcium. Note that two or more of the above-described elements may be used in combination as the element *M*.

In order to achieve a miniaturized or highly integrated transistor, a semiconductor layer of the transistor is formed over a structure body having a projection, a structure body having a depression, or a structure body having an uneven portion, inside a groove portion or an opening portion, or the like in some cases. As a method for forming a semiconductor layer for them with favorable coverage, an atomic layer deposition (ALD) method and a chemical vapor deposition (CVD) method can be given.

In an ALD method, one atomic layer can be deposited at a time using self-regulating characteristics of precursor molecules or atoms contained in the precursor. Hence, an ALD method has effects such as deposition of an extremely thin film, deposition of a film on a component with a high aspect ratio, deposition of a film with a small number of defects such as pinholes, deposition of a film with excellent coverage, and deposition of a film at a low temperature. An ALD method includes a plasma ALD (PEALD: Plasma Enhanced ALD) method, which is a deposition method using plasma. The use of plasma is sometimes preferable because deposition at a lower temperature is possible. Note that a precursor used in an ALD method sometimes contains an element such as carbon or chlorine. Thus, in some cases, a film provided by an ALD method contains a larger amount of an element such as carbon or chlorine than a film provided by another deposition method. Note that these elements can be quantified by X-ray photoelectron spectroscopy (XPS).

An ALD method is a deposition method which enables less plasma damage to an object to be processed. An ALD method also cause less plasma damage or does not cause plasma damage during deposition, so that a film with few defects can be obtained.

The CVD method can be classified into a plasma CVD (PECVD: plasma enhanced CVD) method using plasma, a thermal CVD (TCVD) method using heat, a photo CVD method using light, and the like. Moreover, the CVD method can be classified into a metal CVD (MCVD) method and a metal organic CVD (MOCVD) method depending on a source gas to be used.

A high-quality film can be obtained at a relatively low temperature by a plasma CVD method. Furthermore, a thermal CVD method is a deposition method that does not use plasma and thus enables less plasma damage to an object to be processed. For example, a wiring, an electrode, an element (a transistor, a capacitor, or the like), or the like included in a semiconductor device might be charged up by receiving charge from plasma. In that case, accumulated charge might break the wiring, the electrode, the element, or the like included in the semiconductor device. In contrast, such plasma damage does not occur in the case of a thermal CVD method, which does not use plasma, and thus the yield of the semiconductor device can be increased. In addition, a thermal CVD method does not cause plasma damage during deposition, so that a film with few defects can be obtained.

Unlike a deposition method in which particles ejected from a target or the like are deposited, an ALD method and a CVD method are deposition methods in which a film is formed by reaction at a surface of an object to be processed. Thus, an ALD method and a CVD method are deposition methods that enable favorable step coverage almost regardless of the shape of an object to be processed. In particular, an ALD method has excellent step coverage and excellent thickness uniformity and thus is suitable for covering a surface of an opening portion with a high aspect ratio, for example. On the other hand, an ALD method has a relatively low deposition rate, and thus is preferably used in combination with another deposition method with a high deposition rate, such as a CVD method, in some cases.

An ALD method and a CVD method enable control of the composition of a film to be obtained with the flow rate ratio of the source gases. For example, by an ALD method and a CVD method, a film with a certain composition can be deposited depending on the flow rate ratio of the source gases. Moreover, for example, by an ALD method and a CVD method, a film whose composition is continuously changed can be deposited by changing the flow rate ratio of the source gases during the deposition. In the case where the film is deposited while the flow rate ratio of the source gases is changed, as compared to the case where the film is deposited using a plurality of deposition chambers, the time taken for the deposition can be shortened because the time taken for transfer and pressure adjustment is omitted. Thus, the productivity of the semiconductor device can be increased in some cases.

An element contained in the source gas used for deposition may enter a metal oxide deposited by an ALD method or a CVD method. As the element contained in the source gas, hydrogen, carbon, nitrogen, chlorine, or the like can be given. Note that hydrogen, carbon, nitrogen, chlorine, or the like can serve as an impurity for a metal oxide. As described above, the crystallinity of the metal oxide tends to decrease as the impurity concentration is higher.

Therefore, microwave treatment is preferably performed after depositing a metal oxide by an ALD method or a CVD method. Note that the microwave treatment is preferably performed in an oxygen-containing atmosphere.

The microwave treatment in an oxygen-containing atmosphere converts an oxygen gas into plasma using a high-frequency wave such as a microwave, RF, or the like, so that the oxygen plasma can be applied to the metal oxide. At this time, the metal oxide can be irradiated with the high-frequency wave such as a microwave or RF. In other words, the high-frequency wave such as a microwave or RF, the oxygen plasma, or the like can be applied to the metal oxide.

The effect of the high-frequency wave, the oxygen plasma, and the like can reduce the impurity concentration of the metal oxide. For example, hydrogen in the metal oxide can be released as a water molecule. Alternatively, carbon in the metal oxide can be released as a carbon oxide (CO and/or CO₂), for example. In addition, by supplying oxygen radicals generated by the oxygen plasma to the metal oxide, oxygen vacancies, VoH, or the like in the metal oxide can be reduced.

The effect of the high-frequency wave, the oxygen plasma, and the like can apply energy which is higher than or equal to the treatment temperature of the microwave treatment to the atom in the metal oxide. Thus, rearrangement of metal atoms and oxygen atoms in the metal oxide is promoted, so that the crystallinity of the metal oxide can be improved. Note that as the impurity concentration and the amount of defects (such as oxygen vacancies or VoH) in the metal oxide are reduced, the crystallinity of the metal oxide tends to be improved. That is, the microwave treatment in an oxygen-containing atmosphere reduces the impurity concentration and the amount of the defects in the metal oxide and improves the crystallinity of the metal oxide.

As described above, the impurity concentration and the amount of defects in the above-described metal oxide can be reduced by performing the microwave treatment in an oxygen-containing atmosphere. Furthermore, the rearrangement of metal atoms and oxygen atoms in the metal oxide can be promoted. Thus, the crystallinity of the metal oxide is improved, so that a metal oxide having a CAAC structure can be formed. In other words, the metal oxide includes a crystal region where the c-axis is substantially parallel to the normal vector of a surface where the metal oxide is formed or the normal vector of a surface of the metal oxide.

As described above, an ALD method is a deposition method which enables less plasma damage to an object to be processed. Thus, the metal oxide which has been subjected to the microwave treatment may have a crystal region where the c-axis is substantially parallel to the normal vector of a surface where the metal oxide is formed or the normal vector of a surface of the metal oxide in the vicinity of the interface between the object to be processed and the metal oxide. Note that the vicinity of the interface between the object to be processed and the metal oxide indicates a region in the metal oxide that is positioned in the range of greater than 0 nm and less than or equal to 3 nm from the object to be processed, for example.

Note that the above-described microwave treatment is not necessarily performed after depositing a metal oxide by an ALD method or a CVD method. The microwave treatment may be performed during the deposition of the metal oxide by an ALD method or a CVD method, for example.

Here, a deposition method of a metal oxide of one embodiment of the present invention, a deposition apparatus employing an ALD method (hereinafter, also referred to as an ALD apparatus), and a microwave treatment apparatus are described.

In an ALD apparatus, deposition is performed by introducing a first source gas (also referred to as a precursor or a metal precursor) and a second source gas (also referred to as a reactant, an oxidizer, or a nonmetallic precursor) for reaction alternately into a chamber, and repeating the introduction of these source gases. Note that the source gases to be introduced can be switched by switching the respective switching valves (also referred to as high-speed valves), for example. When the source gases are introduced, an inert gas such as nitrogen (N₂), argon (Ar), or helium (He) may be introduced as a carrier gas with the source gases into the chamber. With the use of a carrier gas, the source gases can be inhibited from being adsorbed onto an inner side of a pipe and an inner side of a valve and can be introduced into the chamber, even in the case where the volatility of the source gases is low or the vapor pressure is low. Moreover, uniformity of the formed film is improved, which is preferable.

### <Deposition method of metal oxide>

An example of a method for depositing a metal oxide with high crystallinity using an ALD method and microwave treatment is described.

First of all, a metal oxide is deposited by an ALD method. First, a first precursor is introduced into a chamber and the first precursor is adsorbed onto a surface of a substrate (hereinafter, the step is referred to as a first step in some cases). Here, the first precursor is adsorbed onto the substrate surface, whereby a self-limiting mechanism of surface chemical reaction works and no more first precursor is adsorbed onto a layer of the first precursor over the substrate.

Next, an inert gas (such as argon, helium, or nitrogen) or the like is introduced into the chamber, so that an excess first precursor, a reaction product, and the like are released from the chamber (hereinafter, the step is referred to as a second step in some cases). Instead of introduction of an inert gas into the chamber, vacuum evacuation may be performed to release excess precursors, a reaction product, and the like from the chamber. The second step is also called purge.

Next, a first reactant (e.g., an oxidizer (ozone (O₃), oxygen (O₂), water (H₂O), and plasma, a radical, and an ion thereof)) is introduced into the chamber to react with the first precursor adsorbed onto the surface of the substrate, whereby part of components contained in the first precursor is released while the component molecules of the first precursor are kept adsorbed onto the substrate (hereinafter, the step is referred to as a third step in some cases). Thus, a first oxide layer, which is formed by oxidation of part of the first precursor, is formed on the surface of the substrate.

In the case where a plasma ALD method is used, oxygen may be constantly supplied as an oxidizer and plasma may be generated in the third step. Accordingly, in the third step, oxygen plasma is formed and serves as the first reactant. In this case, the first precursor that does not react with oxygen that has been heated may be used in a step other than the third step. Note that a high-frequency wave with a frequency of 13.56 MHz or 60 MHz or a microwave with a frequency of 2.45 GHz may be used for plasma generation.

Next, introduction of an inert gas or vacuum evacuation is performed, whereby an excess first reactant, a reaction product, and the like are released from the chamber (hereinafter, the step is referred to as a fourth step in some cases).

Then, a second precursor containing a metal element different from that in the first precursor is introduced and a step similar to the first step is performed, so that the second precursor is adsorbed onto a surface of the first oxide layer. Here, the second precursor is adsorbed onto the first oxide layer, whereby a self-limiting mechanism of surface chemical reaction works and no more second precursor is adsorbed onto a layer of the second precursor over the substrate.

Next, as in the second step, introduction of an inert gas or vacuum evacuation is performed, whereby an excess second precursor, a reaction product, and the like are released from the chamber.

Next, as in the third step, a second reactant is introduced into the chamber. Here, the second reactant that is the same as or different from the first reactant may be used. Thus, a second oxide layer, which is formed by oxidation of part of the second precursor, is formed over the first oxide layer.

Then, as in the fourth step, introduction of an inert gas or vacuum evacuation is performed, whereby an excess second reactant, a reaction product, and the like are released from the chamber.

Furthermore, the first to fourth steps are performed in a similar manner, whereby a third oxide layer can be formed over the second oxide layer using a third precursor and a third reactant. In this manner, by repeating the steps of forming the first oxide layer to the third oxide layer, a metal oxide consisting of a metal element contained in the first precursor, a metal element contained in the second precursor, and a metal element contained in the third precursor can be formed. That is, an oxide layer can be formed through the first step to the fourth step, which are regarded as one set, and by repeating the set, a metal oxide can be formed.

Elements contained in the precursors and the reactants, elements other than elements constituting the metal oxide, can serve as impurities of the metal oxide. As elements other than elements constituting the metal oxide, hydrogen, carbon, nitrogen, chlorine, and the like can be given. In the case where the release of an excess precursor, an excess reactant, a reaction product, and the like from a chamber by the second step (purge) and the fourth step is not sufficient, the concentration of an impurity such as hydrogen, carbon, nitrogen, chlorine, or the like in the metal oxide is higher in some cases. As described above, the crystallinity of the metal oxide tends to decrease as the impurity concentration is higher.

Therefore, microwave treatment is preferably performed after depositing a metal oxide by an ALD method. In addition, it is further preferable that microwave treatment be performed successively without exposure to the air after depositing a metal oxide using an ALD method. As described above, the impurity concentration in the metal oxide is reduced and the crystallinity of the metal oxide is improved by performing microwave treatment. Thus, a metal oxide having a layered crystal structure, specifically, a metal oxide having a CAAC structure can be formed.

The above-described microwave treatment is further preferably performed in an oxygen-containing atmosphere. As an oxygen-containing atmosphere, for example, an oxygen gas and a noble gas (such as argon, helium, or krypton) are used for performing the microwave treatment. In the case where an oxygen gas and an argon gas are used for an oxygen-containing atmosphere, the proportion of the flow rate of the oxygen gas to the sum of the flow rate of the oxygen gas and the flow rate of the argon gas is referred to as an oxygen flow rate ratio (O₂/(O₂ + Ar)). The oxygen flow rate ratio (O₂/(O₂ + Ar)) is greater than 0 % and less than or equal to 100 %, preferably greater than 0 % and less than or equal to 50 %, further preferably greater than or equal to 10 % and less than or equal to 40 %, still further preferably greater than or equal to 10 % and less than or equal to 30 %. Note that also in the case where an oxygen gas, and a helium gas or a krypton gas are used for an oxygen-containing atmosphere, the oxygen flow rate ratio (O₂/(O₂ + He) or O₂/(O₂ + Kr)) is greater than 0 % and less than or equal to 100 %, preferably greater than 0 % and less than or equal to 50 %, further preferably greater than or equal to 10% and less than or equal to 40 %, still further preferably greater than or equal to 10 % and less than or equal to 30 %.

The above-described microwave treatment is preferably performed under a reduced pressure. For example, the pressure inside the chamber is set to higher than or equal to 10 Pa and lower than or equal to 1000 Pa, preferably higher than or equal to 300 Pa and lower than or equal to 700 Pa.

Note that the microwave treatment is not necessarily performed after depositing a metal oxide using an ALD method. The microwave treatment may be performed, for example, during the deposition of the metal oxide using an ALD method. In other words, the microwave treatment is performed after repeating the above-described set once or a plurality of times, and then repeating the set once or a plurality of times. Note that microwave treatment may be performed once or a plurality of times during the deposition of the metal oxide using an ALD method.

In some cases, the microwave treatment can be performed in a chamber where deposition of the metal oxide using an ALD method is performed. In other words, the deposition of the metal oxide by an ALD method and the microwave treatment can be performed in the same chamber in some cases. The ALD apparatus may have a function of performing microwave treatment. For example, in the case where the plasma ALD method is used, plasma may be generated using a microwave in the state where an inert gas such as argon and oxygen are introduced in a chamber during the deposition of the metal oxide or after depositing the metal oxide. At this time, oxygen plasma is formed. By setting the condition of a plasma generation apparatus described later as appropriate, a metal oxide may be irradiated with a microwave. In other words, a microwave, an oxygen plasma, or the like can be applied to the metal oxide. This corresponds to the microwave treatment. Note that a microwave may be applied to the precursor (at least one of the first precursor to the third precursor) or a reactant (at least one of the first reactant to the third reactant).

The first step to the fourth step may be performed while the substrate is being heated. For example, the substrate temperature may be set to higher than or equal to 200 °C and lower than or equal to 600 °C, preferably higher than or equal to 300 °C and lower than or equal to the precursor decomposition temperature. In the case where deposition is performed by an ALD method with use of different kinds of precursors, the substrate temperature is preferably lower than or equal to the lowest precursor decomposition temperature among the precursors. Accordingly, during deposition by an ALD method, the precursors that are used can be adsorbed onto an object (e.g., a substrate) without being decomposed. By performing the deposition while the substrate is being heated in such a temperature range, an impurity such as hydrogen or carbon contained in the precursor, the reactant, or the like can be removed from the metal oxide in each of the first step to the fourth step.

Note that an example of a structure in which the first precursor is formed over the substrate is shown in the above; however, the present invention is not limited thereto. For example, an insulating film (an insulating film containing oxygen, nitrogen, silicon, aluminum, hafnium, or the like) or a conductive film (a conductive film containing tungsten, tantalum, molybdenum, zirconium, aluminum, titanium, or the like) may be provided over the substrate and the first precursor may be formed thereover. Alternatively, the first precursor may be formed over a component formed using an insulating film, a conductive film, and the like over the substrate.

Heat treatment may be performed after the metal oxide is deposited and/or the microwave treatment is performed. The heat treatment is preferably performed without exposure to the air successively after the deposition by an ALD method. The heat treatment is performed at a temperature higher than or equal to 100 °C and lower than or equal to 1200 °C, preferably higher than or equal to 200 °C and lower than or equal to 1000 °C, further preferably higher than or equal to 250 °C and lower than or equal to 650 °C, still further preferably higher than or equal to 300 °C and lower than or equal to 600 °C, still further preferably higher than or equal to 400 °C and lower than or equal to 550 °C, still further preferably higher than or equal to 420 °C and lower than or equal to 480 °C. Note that the heat treatment is performed in a nitrogen gas or inert gas atmosphere, or an atmosphere containing an oxidizing gas at 10 ppm or more, 1 % or more, or 10 % or more. The heat treatment may be performed under reduced pressure. Alternatively, the heat treatment may be performed in an atmosphere containing an oxidizing gas at 10 ppm or more, 1 % or more, or 10 % or more in order to compensate for released oxygen, after heat treatment is performed in a nitrogen gas or inert gas atmosphere. In the case where the temperature of the heat treatment is high, the metal oxide may have a polycrystalline structure; thus, the temperature of the heat treatment is set as appropriate within a range where the metal oxide does not have a polycrystalline structure. By performing the heat treatment in such a manner, an impurity such as hydrogen or carbon contained in the metal oxide can be removed.

In the above, the metal oxide in which the first oxide layer, the second oxide layer, and the third oxide layer are repeatedly formed is described; however, the present invention is not limited thereto. For example, a single layer, two layers, or four or more layers of an oxide may be repeatedly formed in a metal oxide. In the above, a first oxide, a second oxide, and a third oxide are repeatedly formed without changing the order; however, the present invention is not limited thereto. For example, the order of the first oxide, the second oxide, and the third oxide may be changed. Alternatively, the compositions of the first oxide, the second oxide, and the third oxide may be changed in the film. In the above, different oxide layers are provided to be adj acent to each other in the order of the first oxide, the second oxide, and the third oxide; however, the present invention is not limited thereto. For example, a structure may be employed in which the same oxide layers are successively provided in the order of, for example, the first oxide, the first oxide, the second oxide, the second oxide, the third oxide, and the third oxide.

In the following description of this specification, in the case of using ozone, oxygen, and/or water as a reactant or an oxidizer, they include not only those in gas and molecular states but also those in a plasma state, a radical state, and an ion state, unless otherwise specified. In the case where a film is deposited using an oxidizer in a plasma state, a radical state, or an ion state, a radical ALD apparatus or a plasma ALD apparatus, which will be described later, is used.

In order to remove an impurity such as carbon or hydrogen contained in a precursor, the precursor is preferably made to react with an oxidizer sufficiently. For example, pulse time for introducing an oxidizer is made longer. Alternatively, an oxidizer is introduced a plurality of times. In the case where an oxidizer is introduced a plurality of times, the same kind of oxidizer may be introduced or different kinds of oxidizers may be introduced. For example, after water is introduced as a first oxidizer to the chamber, vacuum evacuation may be performed, ozone or oxygen which does not contain hydrogen may be introduced as a second oxidizer to the chamber, and vacuum evacuation may be performed.

Note that in the above description, an example in which the second source gas is introduced into the chamber after the first source gas is introduced into the chamber is shown; however, the present invention is not limited thereto. The first source gas may be introduced into the chamber after the second source gas is introduced into the chamber. In other words, deposition may be performed in the following manner: the third step and the fourth step are performed first, the first step, the second step, the third step, and the fourth step are performed, and then the first step to the fourth step are repeated. Alternatively, deposition may be performed by repeating the third step and the fourth step a plurality of times, and repeating the first step to the fourth step.

In this manner, the third step and the fourth step are preferably performed once or a plurality of times before the first step because the deposition atmosphere in the chamber can be controlled. For example, ozone and oxygen are introduced as oxidizers in the third step, so that the chamber can have an oxygen atmosphere. Deposition performed in the chamber having an oxygen atmosphere is preferable because the formed film can have a high concentration of oxygen. Furthermore, oxygen can also be supplied to the insulator or the oxide that is to be bases of the film. A semiconductor device formed by such a method can have favorable characteristics and obtain high reliability. Moreover, for example, introduction of water as an oxidizer in the third step can form a hydrophilic group on the formation surface. Accordingly, the precursor can have a much improved adsorption property.

After the first step and the second step, introduction of the second source gas in the third step and vacuum evacuation or introduction of an inert gas in the fourth step may be repeated a plurality of times. That is, after the first step, the second step, the third step, the fourth step, the third step, and the fourth step are performed, that is, after the third step and the fourth step are repeated, the first step and the second step may be performed.

For example, ozone and oxygen are introduced as oxidizers in the third step, introduction of an inert gas is performed in the fourth step, and then these steps may be repeated a plurality of times. In the case where the third step and the fourth step are repeated, it is not necessary to repeat the introduction of the same kind of source gas. For example, water may be used as an oxidizer in the third step in the first cycle, and ozone may be used as an oxidizer in the third steps in and after the second cycle.

In this manner, the introduction of an oxidizer and the introduction of an inert gas (or vacuum evacuation) in the chamber are repeated a plurality of times in a short time, whereby excess hydrogen atoms, carbon atoms, chlorine atoms, and the like can be more certainly removed from the precursor adsorbed onto the substrate surface, and can be released to the outside of the chamber. When the number of the kinds of the oxidizer is increased to two, more excess hydrogen atoms and the like can be removed from the precursor adsorbed onto the substrate surface. In this manner, hydrogen atoms are prevented from being taken into the film during the film formation, so that water, hydrogen, and the like contained in the formed film can be reduced.

With the use of such a method, it is possible to form a film of which the released amount of water molecules is greater than or equal to 1.0 × 10¹³ molecules/cm² and less than or equal to 1.0 × 10¹⁶ molecules/cm², preferably greater than or equal to 1.0 × 10¹³ molecules/cm² and less than or equal to 3.0 × 10¹⁵ molecules/cm² in TDS analysis in a film-surface temperature range from 100 °C to 700 °C or from 100 °C to 500 °C.

An ALD method is a method in which deposition is performed through reaction of a precursor and a reactant using thermal energy. A temperature required for the reaction between the precursor and the reactant is determined by the temperature characteristics, vapor pressure, decomposition temperature, and the like thereof and is set to higher than or equal to 100 °C and lower than or equal to 600 °C, preferably higher than or equal to 200 °C and lower than or equal to 600 °C, further preferably higher than or equal to 300 °C and lower than or equal to 600 °C.

Moreover, an ALD method in which treatment is performed by introducing a plasma-excited reactant into the chamber as a third source gas in addition to the precursor and the reactant which react with each other is referred to as a plasma ALD method in some cases. In this case, a plasma generation apparatus is provided in the introduction portion of the third source gas. For generating plasma, an inductively coupled plasma (ICP), an electron cyclotron resonance plasma (ECRP), or the like can be used. On the other hand, an ALD method in which reaction between the precursor and the reactant is performed using thermal energy is sometimes referred to as a thermal ALD method.

In a plasma ALD method, deposition is performed by introducing a plasma-excited reactant in the third step. Alternatively, deposition is performed by introducing a plasma-excited reactant (referred to as a fifth reactant) while repeating the first step to the fourth step. In this case, the reactant introduced in the third step is referred to as a fourth reactant. In the plasma ALD method, the same material as the above-described oxidizer can be used for the fifth reactant used as the third source gas. In other words, plasma-excited ozone, oxygen, and water can be used as the fifth reactant. Other than oxidizer, a nitriding agent may be used as the fifth reactant. As the nitriding agent, nitrogen (N₂) or ammonia (NH₃) can be used. A mixed gas of nitrogen (N₂) and hydrogen (H₂) can also be used as the nitriding agent. For example, a mixed gas of nitrogen (N₂) of 5 % and hydrogen (H₂) of 95 % can be used as the nitriding agent. Deposition is performed while plasma-excited nitrogen and/or ammonia are/is introduced, whereby a nitride film such as a metal nitride film can be formed.

Argon (Ar), helium (He), or nitrogen (N₂) may be used as a carrier gas for the fifth reactant. The use of a carrier gas such as argon, helium, or nitrogen is preferable because plasma is easily discharged and the plasma-excited fifth reactant is easily generated. Note that in the case where an oxide film such as a metal oxide film is formed by a plasma ALD method and nitrogen is used as a carrier gas, nitrogen enters the film and a desired film quality cannot be obtained in some cases. In this case, argon or helium is preferably used as the carrier gas.

By an ALD method, an extremely thin film can be deposited to have a uniform thickness. In addition, the coverage of a surface having projections and depressions with the film is high.

When deposition is performed by a plasma ALD method, deposition can be performed at a lower temperature than that by a thermal ALD method. By a plasma ALD method, for example, deposition can be performed without decreasing the deposition rate even at 100 °C or lower in some cases. Furthermore, in a plasma ALD method, not only an oxidizer but also any of a variety of reactants such as a nitriding agent can be used; therefore, it is possible to form various kinds of films of a nitride, a fluoride, a metal, and the like as well as an oxide.

In the case where a plasma ALD method is employed, by generating plasma while a plasma source for ICP, ECRP, or the like is apart from a substrate, plasma damage can be reduced.

Here, atomic arrangement in the crystal when the metal oxide having a layered crystal structure is an In-*M*-Zn oxide is described with reference to FIG. 1A to FIG. 1D. In FIG. 1B and FIG. 1D, an atom is represented by a sphere (a circle) and a bond between a metal atom and an oxygen atom is represented by a line. In FIG. 1B and FIG. 1D, the c-axis direction in the crystal structure of the In-*M*-Zn oxide is indicated by the arrows in the diagrams. The a-b plane direction in the crystal structure of the In-*M*-Zn oxide is the direction perpendicular to the c-axis direction indicated by the arrows in FIG. 1B and FIG. 1D.

FIG. 1A is a diagram illustrating an oxide 60 including an In-*M*-Zn oxide formed on a structure body 50. Here, the structure body refers to a component included in a semiconductor device such as a transistor. The structure body 50 includes a substrate, conductors such as a gate electrode, a source electrode, and a drain electrode, insulators such as a gate insulating film, an interlayer insulating film, and a base insulating film, a semiconductor such as a metal oxide and silicon, and the like. In FIG. 1A, a deposition surface of the structure body 50 is positioned parallel to a substrate (or a base, not illustrated).

FIG. 1B is an enlarged view illustrating the atomic arrangement in the crystal in a region 53, which is part of the oxide 60 in FIG. 1A. Here, the composition of the oxide 60 illustrated in FIG. 1A and FIG. 1B is In: *M*: Zn = 1:1:1 [atomic ratio], and the crystal structure is a YbFe₂O₄ type structure. The element *M* is a metal element having a valence of +3.

As illustrated in FIG. 1B, the crystal included in the oxide 60 has repetitive stacking of a layer 21 containing indium (In) and oxygen (O), a layer 31 containing the element *M* and oxygen, and a layer 41 containing zinc (Zn) and oxygen in this order. Each of the layer 21, the layer 31, and the layer 41 is placed substantially parallel to the deposition surface of the structure body 50. That is, the a-b plane of the oxide 60 is substantially parallel to the deposition surface of the structure body 50, and the c-axis of the oxide 60 is substantially parallel to the normal direction of the deposition surface of the structure body 50.

When the layer 21, the layer 31, and the layer 41 included in the above-described crystal are each composed of one kind of metal element and oxygen as illustrated in FIG. 1B, favorable crystallinity can be obtained and the mobility of the metal oxide can be increased.

Note that the In-*M*-Zn oxide with In: *M:* Zn = 1:1:1 [atomic ratio] is not limited to the structure illustrated in FIG. 1B. The stacking order of the layer 21, the layer 31, and the layer 41 may be changed. For example, the layer 21, the layer 41, and the layer 31 may be stacked repeatedly in this order. Alternatively, the layer 21, the layer 31, the layer 41, the layer 21, the layer 41, and the layer 31 may be stacked repeatedly in this order. Part of the element *M* in the layer 31 may be substituted by zinc and part of zinc in the layer 41 may be substituted by the element *M*.

Although an example of forming the In-*M*-Zn oxide whose composition is In: *M*: Zn = 1:1:1 [atomic ratio] is described above, a crystalline In-*M*-Zn oxide whose composition formula is represented by In_{(1+α)}*M*_{(1-α)}O₃(ZnO)*ₘ* (α is a real number greater than 0 and less than 1 and *m* is a positive number) can have a layered crystal structure in a similar manner.

The oxide 60 may have a stacked-layer structure of a plurality of oxide layers with different chemical compositions.

As described above, an ALD method enables deposition of a film on a component with a high aspect ratio and also enables deposition of a film with excellent coverage on a side surface of a structure body. By employing an ALD method, a metal oxide having crystallinity such as a CAAC structure can be easily formed regardless of the orientation of the deposition surface. For example, a metal oxide with favorable coverage can be formed on a top surface, a bottom surface, a side surface, and a surface with a slope of a structure body even when the structure body has a projected shape or a recessed shape. In other words, a metal oxide that has a substantially uniform thickness in the normal direction can be formed on each deposition surface. As for the metal oxide that is formed on each of the top surface, the bottom surface, the side surface, and the surface with the slope of the structure body, the ratio of the minimum thickness to the maximum thickness can be greater than or equal to 0.5 and less than or equal to 1, preferably greater than or equal to 0.7 and less than or equal to 1, further preferably greater than or equal to 0.9 and less than or equal to 1. At this time, in the case where the metal oxide has a crystal structure, the c-axis of the crystal structure is aligned in a direction substantially parallel to the normal direction of each of the deposition surfaces. In other words, the c-axis is aligned perpendicular to each of the deposition surfaces.

Here, FIG. 1C illustrates a case where a deposition surface of the structure body 50 is placed perpendicular to a substrate (or a base, not illustrated) and an oxide 64 is formed on the surface of the structure body 50. FIG. 1D is an enlarged view of a region 58, which is part of the oxide 64 in FIG. 1C. FIG. 1D illustrates a state where, on the side surface of the structure body 50, the layer 21 containing indium (In), the layer 31 containing the element *M*, and the layer 41 containing zinc (Zn) are stacked in the perpendicular direction repeatedly with respect to the deposition surface. The layer 21 containing indium is placed parallel to the deposition surface of the structure body 50, the layer 31 containing the element *M* is placed thereover to be parallel to the deposition surface of the structure body 50, and further the layer 41 containing zinc is placed thereover to be parallel to the deposition surface of the structure body 50. That is, the a-b plane of the oxide 60 is substantially parallel to the deposition surface of the structure body 50, and the c-axis of the oxide 60 is substantially parallel to the normal direction of the deposition surface of the structure body 50. Note that FIG. 1C and FIG. 1D show the example of the In-*M*-Zn oxide with In: *M*: Zn = 1:1:1 [atomic ratio], but an oxide with a different atomic ratio can also be formed on the surface of the structure body 50 whose deposition surface is placed perpendicular to the substrate.

Note that the electrical conductivity of the metal oxide largely varies depending on the atomic ratio. By depositing a metal oxide by an ALD method as described above, a metal oxide having a layered crystal structure corresponding to the atomic ratio can be deposited. Thus, by employing an ALD method, a metal oxide corresponding to required characteristics can be deposited.

### <Structure example of deposition apparatus>

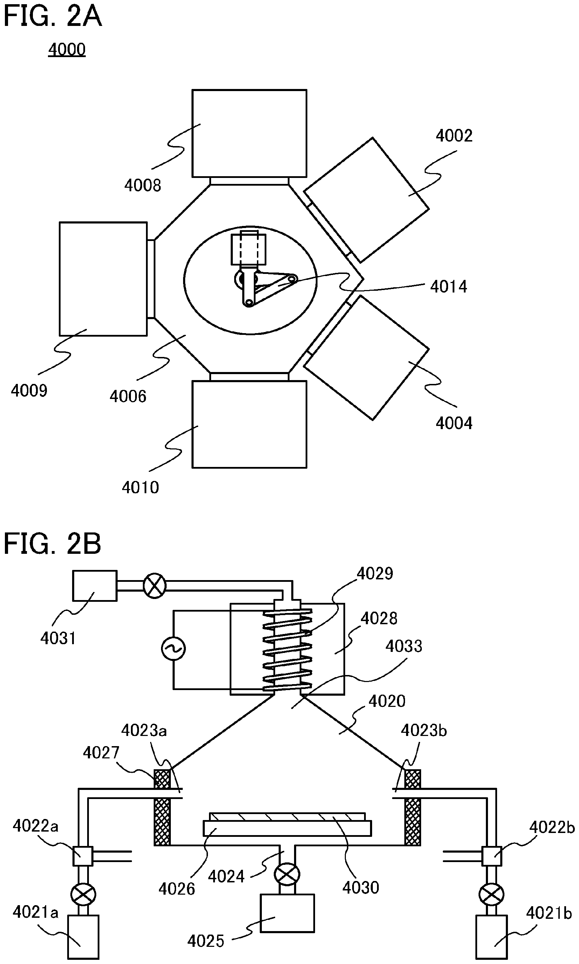

A structure of a deposition apparatus 4000, which is an example of an apparatus capable of deposition by an ALD method, is described with reference to FIG. 2A and FIG. 2B. FIG. 2A is a schematic view of the multi-chamber type deposition apparatus 4000, and FIG. 2B is a cross-sectional view of an ALD apparatus that can be used for the deposition apparatus 4000.

The deposition apparatus 4000 includes a carrying-in/out chamber 4002, a carrying-in/out chamber 4004, a transfer chamber 4006, a deposition chamber 4008, a deposition chamber 4009, a deposition chamber 4010, and a transfer arm 4014. Here, the carrying-in/out chamber 4002, the carrying-in/out chamber 4004, and the deposition chamber 4008 to the deposition chamber 4010 are each independently connected to the transfer chamber 4006. This enables successive deposition in the deposition chamber 4008 to the deposition chamber 4010 without exposure to the air, preventing the entry of impurities into a film. Moreover, contamination of an interface between a substrate and a film and interfaces between films can be reduced, so that clean interfaces can be obtained.

Note that in order to prevent attachment of moisture and the like, the carrying-in/out chamber 4002, the carrying-in/out chamber 4004, the transfer chamber 4006, and the deposition chamber 4008 to the deposition chamber 4010 are preferably filled with an inert gas (such as a nitrogen gas) whose dew point is controlled, and reduced pressure is desirably maintained.

An ALD apparatus can be used in the deposition chamber 4008 to the deposition chamber 4010. Alternatively, a structure may be employed in which a deposition apparatus other than an ALD apparatus is used in any of the deposition chamber 4008 to the deposition chamber 4010. Examples of the deposition apparatus that can be used in the deposition chamber 4008 to the deposition chamber 4010 include a sputtering apparatus, a plasma CVD apparatus, a thermal CVD apparatus, a photo CVD apparatus, a metal CVD apparatus, and a metal organic CVD apparatus. An apparatus having a function other than a deposition apparatus may be provided in one or more of the deposition chamber 4008 to the deposition chamber 4010. Examples of the apparatus include a heating apparatus (typically, a vacuum heating apparatus) and a plasma generation apparatus (typically, a microwave plasma generation apparatus).

For example, in the case where an ALD apparatus is used in the deposition chamber 4008, a PECVD apparatus is used in the deposition chamber 4009, and a metal CVD apparatus is used in the deposition chamber 4010, a metal oxide can be formed in the deposition chamber 4008, an insulating film functioning as a gate insulating film can be formed in the deposition chamber 4009, and a conductive film functioning as a gate electrode can be formed in the deposition chamber 4010. At this time, the metal oxide, the insulating film thereover, and the conductive film thereover can be formed successively without exposure to the air.

Although the deposition apparatus 4000 includes the carrying-in/out chamber 4002, the carrying-in/out chamber 4004, and the deposition chamber 4008 to the deposition chamber 4010, the present invention is not limited thereto. The number of the deposition chambers in the deposition apparatus 4000 may be four or more. The deposition apparatus 4000 may be of a single-wafer type or may be of a batch type, in which case deposition is performed on a plurality of substrates at a time.

### <ALD apparatus>

Next, a structure of an ALD apparatus that can be used as the deposition apparatus 4000 is described with reference to FIG. 2B. The ALD apparatus includes a deposition chamber (a chamber 4020), a source material supply portion 4021 (a source material supply portion 4021a and a source material supply portion 4021b), a source material supply portion 4031, a high-speed valve 4022a and a high-speed valve 4022b that are introduction amount controllers, a source material introduction port 4023 (a source material introduction port 4023a and a source material introduction port 4023b), a source material introduction port 4033, a source material exhaust port 4024, and an evacuation unit 4025. The source material introduction port 4023a, the source material introduction port 4023b, and the source material introduction port 4033 provided in the chamber 4020 are connected to the source material supply portion 4021a, the source material supply portion 4021b, and the source material supply portion 4031, respectively, through supply tubes and valves, and the source material exhaust port 4024 is connected to the evacuation unit 4025 through an exhaust tube, a valve, and a pressure controller.

A plasma generation apparatus 4028 is connected to the chamber 4020 as illustrated in FIG. 2B, whereby deposition can be performed by a plasma ALD method as well as a thermal ALD method. It is preferable that the plasma generation apparatus 4028 be an ICP-type plasma generation apparatus using a coil 4029 connected to a high frequency power source. The high frequency power source is capable of outputting power with a frequency higher than or equal to 10 kHz and lower than or equal to 100 MHz, preferably higher than or equal to 1 MHz and lower than or equal to 60 MHz, further preferably higher than or equal to 10 MHz and lower than or equal to 60 MHz. For example, power with a frequency of 13.56 MHz or 60 MHz can be output. A plasma ALD method enables deposition without decreasing the deposition rate even at low temperatures, and thus is preferably used for a single-wafer type deposition apparatus with low deposition efficiency.

A substrate holder 4026 is positioned in the chamber, and a substrate 4030 is placed on the substrate holder 4026. The substrate holder 4026 may be provided with a mechanism to which a constant potential or a high-frequency wave is applied. Alternatively, the substrate holder 4026 may be floating or grounded. A heater 4027, which is provided on an outside wall of the chamber, can control the temperature inside the chamber 4020 and the temperatures of the substrate holder 4026, the surface of the substrate 4030, and the like. The heater 4027 is preferably capable of controlling the temperature of the surface of the substrate 4030 to higher than or equal to 100 °C and lower than or equal to 500 °C, preferably higher than or equal to 200 °C and lower than or equal to 400 °C, and is preferably capable of setting the temperature of the heater 4027 itself to higher than or equal to 100 °C and lower than or equal to 500 °C.

In the source material supply portion 4021a, the source material supply portion 4021b, and the source material supply portion 4031, a source gas is formed from a solid source material or a liquid source material using a vaporizer, a heating unit, or the like. Alternatively, the source material supply portion 4021a, the source material supply portion 4021b, and the source material supply portion 4031 may supply a source gas.

Although FIG. 2B illustrates the example in which two source material supply portions 4021 and one source material supply portion 4031 are provided, this embodiment is not limited thereto. One or three or more source material supply portions 4021 may be provided. In addition, two or more source material supply portions 4031 may be provided. The high-speed valve 4022a and the high-speed valve 4022b can be precisely controlled by time and are configured to control supply of a source gas from the source material supply portion 4021a and supply of a source gas from the source material supply portion 4021b.

In the deposition apparatus illustrated in FIG. 2B, a thin film is formed over a substrate surface in the following manner: the substrate 4030 is transferred onto the substrate holder 4026, the chamber 4020 is sealed, the substrate 4030 is set to a desired temperature (e.g., higher than or equal to 100 °C and lower than or equal to 500 °C, preferably higher than or equal to 200 °C and lower than or equal to 400 °C) by the heater 4027; and supply of a source gas from the source material supply portion 4021a, evacuation with the evacuation unit 4025, supply of a source gas from the source material supply portion 4031, and evacuation with the evacuation unit 4025 are repeated. In the formation of the thin film, supply of a source gas from the source material supply portion 4021b and evacuation with the evacuation unit 4025 may further be performed. The temperature of the heater 4027 is determined as appropriate depending on the type of film to be formed, the source gas, the desired film quality, the heat resistance of a substrate and a film and an element that are provided over the substrate, or the like. For example, the deposition may be performed by setting the temperature of the heater 4027 to higher than or equal to 200 °C and lower than or equal to 300 °C or higher than or equal to 300 °C and lower than or equal to 500 °C.

By performing deposition while the substrate 4030 is heated by the heater 4027, heat treatment for the substrate 4030 that is necessary in a later step can be omitted. In other words, with the use of the deposition apparatus 4000 or the chamber 4020 provided with the heater 4027, formation of a film over the substrate 4030 can also serve as heat treatment for the substrate 4030.

In the deposition apparatus illustrated in FIG. 2B, a metal oxide can be formed by appropriate selection of source materials (a volatile organometallic compound and the like) used in the source material supply portion 4021 and the source material supply portion 4031. In the case where an In-Ga-Zn oxide, which contains indium, gallium, and zinc, is formed as the metal oxide, it is preferable to use a deposition apparatus provided with at least three source material supply portions 4021 besides the source material supply portion 4031. Specifically, it is preferable that a precursor containing indium be supplied from the first source material supply portion 4021, a precursor containing gallium be supplied from the second source material supply portion 4021, and a precursor containing zinc be supplied from the third source material supply portion 4021. In the case where the metal oxide is formed using precursors containing gallium and zinc, at least two source material supply portions 4021 are provided.

As the precursor containing indium, triethylindium, tris(2,2,6,6-tetramethyl-3,5-heptanedione acid)indium, cyclopentadienylindium, indium(III) chloride, or the like can be used. As the precursor containing gallium, trimethylgallium, triethylgallium, gallium trichloride, tris(dimethylamide)gallium, gallium(III) acetylacetonate, tris(2,2,6,6-tetramethyl-3,5-heptanedione acid)gallium, dimethylchlorogallium, diethylchlorogallium, gallium(III) chloride, or the like can be used. As the precursor containing zinc, dimethylzinc, diethylzinc, bis(2,2,6,6-tetramethyl-3,5-heptanedione acid)zinc, zinc chloride, or the like can be used.

A reactant is supplied from the source material supply portion 4031. An oxidizer containing at least one of ozone, oxygen, and water can be used as the reactant.

By appropriate selection of source materials (a volatile organometallic compound and the like) used in the source material supply portion 4021a, the source material supply portion 4021b, and the source material supply portion 4031, an insulating layer formed using an oxide (including a composite oxide) containing one or more kinds of elements selected from hafnium, aluminum, tantalum, zirconium, and the like can be deposited. Specifically, an insulating layer formed using hafnium oxide, an insulating layer formed using aluminum oxide, an insulating layer formed using hafnium silicate, an insulating layer formed using aluminum silicate, or the like can be deposited. Alternatively, a thin film, e.g., a metal layer such as a tungsten layer or a titanium layer, or a nitride layer such as a titanium nitride layer can be deposited by appropriate selection of source materials (a volatile organometallic compound and the like) used in the source material supply portion 4021a, the source material supply portion 4021b, and the source material supply portion 4031.

For example, in the case where a hafnium oxide layer is formed by an ALD apparatus, the first source gas which is obtained by vaporizing a liquid containing a solvent and a hafnium precursor compound (hafnium alkoxide or hafnium amide such as tetrakis(dimethylamide)hafnium (TDMAHf)), and the second source gas of ozone (O₃) and oxygen (O₂) as an oxidizer are used. In this case, the first source gas supplied from the source material supply portion 4021a is TDMAHf, and the second source gas supplied from the source material supply portion 4031 is ozone and oxygen. Note that the chemical formula of tetrakis(dimethylamide)hafnium is Hf[N(CH₃)₂]₄. Furthermore, examples of another material liquid include tetrakis(ethylmethylamide)hafnium. Alternatively, water can be used as the second source gas.

In the case where an aluminum oxide layer is formed by an ALD apparatus, the first source gas which is obtained by vaporizing a liquid containing a solvent and an aluminum precursor compound (e.g., TMA: trimethylaluminum) and the second source gas containing ozone (O₃) and oxygen (O₂) as an oxidizer are used. In this case, the first source gas supplied from the source material supply portion 4021a is TMA, and the second source gas supplied from the source material supply portion 4031 is ozone and oxygen. Note that the chemical formula of trimethylaluminum is Al(CH₃)₃. Examples of another material liquid include tris(dimethylamide)aluminum, triisobutylaluminum, and aluminum tris(2,2,6,6-tetramethyl-3,5-heptanedionate). Alternatively, water can be used as the second source gas.

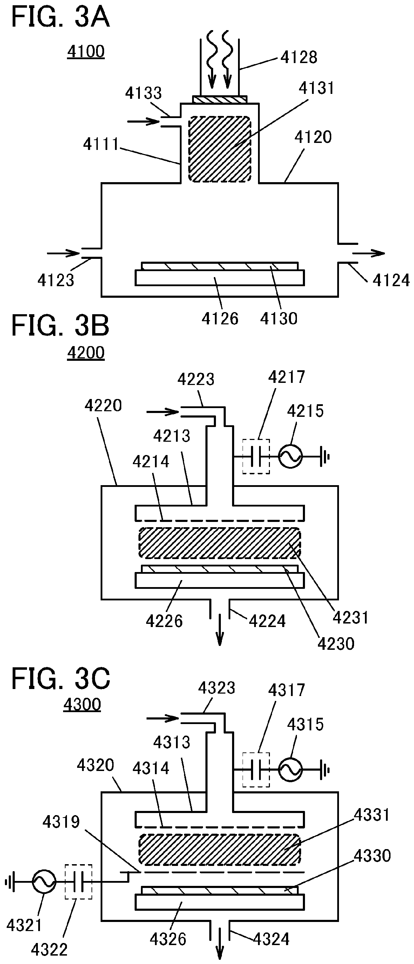

FIG. 3A to FIG. 3C illustrate ALD apparatuses with different structures that can be used as the deposition apparatus 4000. Note that detailed description of structures and functions similar to those of the ALD apparatus illustrated in FIG. 2B is omitted in some cases.

FIG. 3A is a schematic view illustrating one embodiment of a plasma ALD apparatus. A plasma ALD apparatus 4100 is provided with a reaction chamber 4120 and a plasma generation chamber 4111 above the reaction chamber 4120. The reaction chamber 4120 can be referred to as a chamber. Alternatively, the reaction chamber 4120 and the plasma generation chamber 4111 can be collectively referred to as a chamber. The reaction chamber 4120 includes a source material introduction port 4123 and a source material exhaust port 4124, and the plasma generation chamber 4111 includes a source material introduction port 4133. Furthermore, a plasma generation apparatus 4128 enables a high-frequency wave such as RF or a microwave to be applied to a gas introduced into the plasma generation chamber 4111, thereby generating plasma 4131 in the plasma generation chamber 4111. In the case where the plasma 4131 is generated using a microwave, a microwave with a frequency of 2.45 GHz is typically used. Plasma generated by such a microwave is referred to as ECRP in some cases. A substrate holder 4126 is provided in the reaction chamber 4120, and a substrate 4130 is positioned thereover. A source gas introduced from the source material introduction port 4123 is decomposed by heat from a heater provided in the reaction chamber 4120 and is deposited over the substrate 4130. A source gas introduced from the source material introduction port 4133 turns into a plasma state by the plasma generation apparatus 4128. The source gas in the plasma state is recombined with electrons or other molecules to be in a radical state before it reaches the surface of the substrate 4130, and reaches the substrate 4130. An ALD apparatus that performs deposition using a radical in such a manner may also be referred to as a radical ALD (Radical-Enhanced ALD) apparatus. The structure of the plasma ALD apparatus 4100, in which the plasma generation chamber 4111 is provided above the reaction chamber 4120, is illustrated; however, this embodiment is not limited to this structure. The plasma generation chamber 4111 may be provided adjacent to a side surface of the reaction chamber 4120.

FIG. 3B is a schematic view illustrating one embodiment of a plasma ALD apparatus. A plasma ALD apparatus 4200 includes a chamber 4220. The chamber 4220 includes an electrode 4213, a source material exhaust port 4224, and a substrate holder 4226, and a substrate 4230 is positioned thereover. The electrode 4213 includes a source material introduction port 4223 and a shower head 4214 that supplies the introduced source gas into the chamber 4220. A power source 4215 capable of applying a high-frequency wave through a capacitor 4217 is connected to the electrode 4213. The substrate holder 4226 may be provided with a mechanism to which a constant potential or a high-frequency wave is applied. Alternatively, the substrate holder 4226 may be floating or grounded. The electrode 4213 and the substrate holder 4226 function as an upper electrode and a lower electrode, respectively, for generating plasma 4231. A source gas introduced from the source material introduction port 4223 is decomposed by heat from a heater provided in the chamber 4220 and is deposited over the substrate 4230. Alternatively, the source gas introduced from the source material introduction port 4223 turns into a plasma state between the electrode 4213 and the substrate holder 4226. The source gas in the plasma state enters the substrate 4230 owing to a potential difference (also referred to as an ion sheath) generated between the plasma 4231 and the substrate 4230.

FIG. 3C is a schematic view illustrating one embodiment of a plasma ALD apparatus different form that in FIG. 3B. A plasma ALD apparatus 4300 includes a chamber 4320. The chamber 4320 includes an electrode 4313, a source material exhaust port 4324, and a substrate holder 4326, and a substrate 4330 is positioned thereover. The electrode 4313 includes a source material introduction port 4323 and a shower head 4314 that supplies the introduced source gas into the chamber 4320. A power source 4315 capable of applying a high-frequency wave through a capacitor 4317 is connected to the electrode 4313. The substrate holder 4326 may be provided with a mechanism to which a constant potential or a high-frequency wave is applied. Alternatively, the substrate holder 4326 may be floating or grounded. The electrode 4313 and the substrate holder 4326 function as an upper electrode and a lower electrode, respectively, for generating plasma 4331. The plasma ALD apparatus 4300 is different from the plasma ALD apparatus 4200 in that a mesh 4319 to which a power source 4321 capable of applying a high-frequency wave through a capacitor 4322 is connected is provided between the electrode 4313 and the substrate holder 4326. With the mesh 4319, the plasma 4231 can be away from the substrate 4130. A source gas introduced from the source material introduction port 4323 is decomposed by heat from a heater provided in the chamber 4320 and is deposited over the substrate 4330. Alternatively, the source gas introduced from the source material introduction port 4323 turns into a plasma state between the electrode 4313 and the substrate holder 4326. Charge of the source gas in the plasma state is removed by the mesh 4319 and the source gas reaches the substrate 4130 while being in an electrically neutral state such as a radical. Therefore, it is possible to perform deposition with suppressed damage due to plasma and the entry of ions.

### <Microwave treatment apparatus>

A microwave treatment apparatus that can be used for a method for improving the quality of the above-described insulating film and a method for manufacturing a semiconductor device that will be described later are described below.

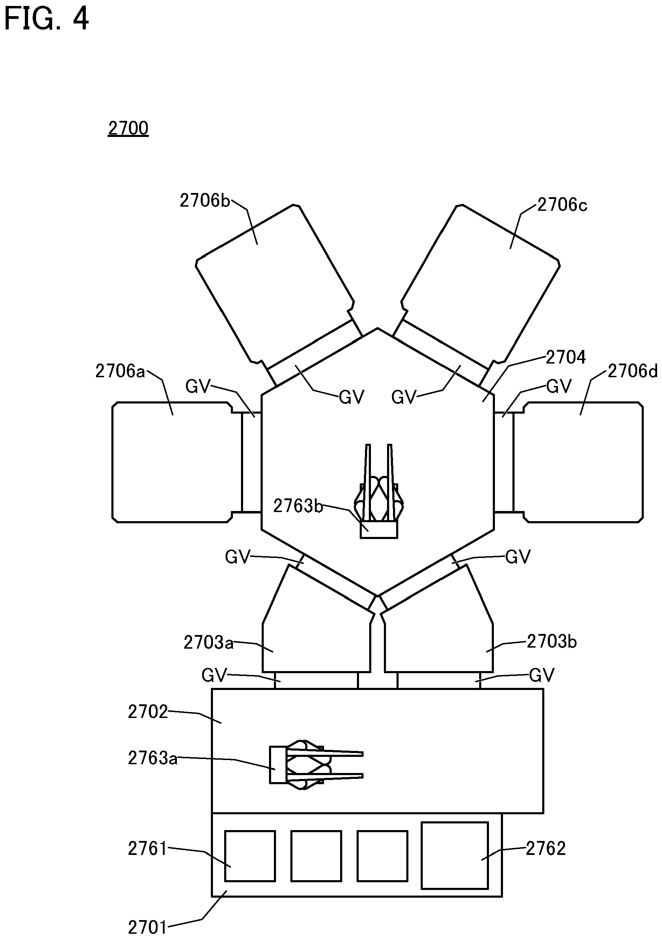

First, the structure of a manufacturing apparatus that hardly allows entry of impurities in manufacturing a semiconductor device or the like is described with reference to FIG. 4 to FIG. 7.

FIG. 4 schematically illustrates a top view of a single wafer multi-chamber manufacturing apparatus 2700. The manufacturing apparatus 2700 includes an atmosphere-side substrate supply chamber 2701 including a cassette port 2761 for storing substrates and an alignment port 2762 for performing alignment of substrates; an atmosphere-side substrate transfer chamber 2702 through which a substrate is transferred from the atmosphere-side substrate supply chamber 2701; a load lock chamber 2703a where a substrate is carried in and the pressure inside the chamber is switched from atmospheric pressure to reduced pressure or from reduced pressure to atmospheric pressure; an unload lock chamber 2703b where a substrate is carried out and the pressure inside the chamber is switched from reduced pressure to atmospheric pressure or from atmospheric pressure to reduced pressure; a transfer chamber 2704 through which a substrate is transferred in a vacuum; a chamber 2706a; a chamber 2706b; a chamber 2706c; and a chamber 2706d.

Furthermore, the atmosphere-side substrate transfer chamber 2702 is connected to the load lock chamber 2703a and the unload lock chamber 2703b, the load lock chamber 2703a and the unload lock chamber 2703b are connected to the transfer chamber 2704, and the transfer chamber 2704 is connected to the chamber 2706a, the chamber 2706b, the chamber 2706c, and the chamber 2706d.

Note that gate valves GV are provided in connecting portions between the chambers so that each chamber excluding the atmosphere-side substrate supply chamber 2701 and the atmosphere-side substrate transfer chamber 2702 can be independently kept in a vacuum state. Furthermore, the atmosphere-side substrate transfer chamber 2702 is provided with a transfer robot 2763a, and the transfer chamber 2704 is provided with a transfer robot 2763b. With the transfer robot 2763a and the transfer robot 2763b, a substrate can be transferred inside the manufacturing apparatus 2700.

The back pressure (total pressure) in the transfer chamber 2704 and each of the chambers is, for example, lower than or equal to 1 × 10⁻⁴ Pa, preferably lower than or equal to 3 × 10⁻⁵ Pa, further preferably lower than or equal to 1 × 10⁻⁵ Pa. Furthermore, the partial pressure of a gas molecule (atom) having a mass-to-charge ratio (m/z) of 18 in the transfer chamber 2704 and each of the chambers is, for example, lower than or equal to 3 × 10⁻⁵ Pa, preferably lower than or equal to 1 × 10⁻⁵ Pa, further preferably lower than or equal to 3 × 10⁻⁶ Pa. Furthermore, the partial pressure of a gas molecule (atom) having m/z of 28 in the transfer chamber 2704 and each of the chambers is, for example, lower than or equal to 3 × 10⁻⁵ Pa, preferably lower than or equal to 1 × 10⁻⁵ Pa, further preferably lower than or equal to 3 × 10⁻⁶ Pa. Furthermore, the partial pressure of a gas molecule (atom) having m/z of 44 in the transfer chamber 2704 and each of the chambers is, for example, lower than or equal to 3 × 10⁻⁵ Pa, preferably lower than or equal to 1 × 10⁻⁵ Pa, further preferably lower than or equal to 3 × 10⁻⁶ Pa.

Note that the total pressure and the partial pressure in the transfer chamber 2704 and each of the chambers can be measured using an ionization vacuum gauge, a mass analyzer, or the like.

Furthermore, the transfer chamber 2704 and the chambers each desirably have a structure in which the amount of external leakage or internal leakage is small. For example, the leakage rate in the transfer chamber 2704 is less than or equal to 1 × 10⁰ Pa/min, preferably less than or equal to 5 × 10⁻¹ Pa/min. Furthermore, the leakage rate in each chamber is less than or equal to 1 × 10⁻¹ Pa/min, preferably less than or equal to 5 × 10⁻² Pa/min.

Note that a leakage rate can be derived from the total pressure and partial pressure measured using the ionization vacuum gauge, the mass analyzer, or the like. For example, the leakage rate is preferably derived from the total pressure at the time when 10 minutes have passed from the start of evacuation to a vacuum using a vacuum pump such as a turbo molecular pump and the total pressure at the time when 10 minutes have passed from the operation of closing the valve. Note that the total pressure at the time when 10 minutes have passed from the start of evacuation to a vacuum is preferably an average value of the total pressures measured a plurality of times.

The leakage rate depends on external leakage and internal leakage. The external leakage refers to inflow of gas from the outside of a vacuum system through a minute hole, a sealing defect, or the like. The internal leakage is due to leakage through a partition, such as a valve, in a vacuum system or released gas from an internal member. Measures need to be taken from both aspects of external leakage and internal leakage in order that the leakage rate can be less than or equal to the above-described value.

For example, open/close portions of the transfer chamber 2704 and each of the chambers are preferably sealed with a metal gasket. For the metal gasket, metal covered with iron fluoride, aluminum oxide, or chromium oxide is preferably used. The metal gasket achieves higher adhesion than an O-ring and can reduce the external leakage. Furthermore, with the use of the metal covered with iron fluoride, aluminum oxide, chromium oxide, or the like, which is in the passive state, the release of gas containing impurities released from the metal gasket is inhibited, so that the internal leakage can be reduced.

Furthermore, for a member of the manufacturing apparatus 2700, aluminum, chromium, titanium, zirconium, nickel, or vanadium, which releases a small amount of gas containing impurities, is used. Furthermore, an alloy containing iron, chromium, nickel, and the like covered with the above-described metal, which releases a small amount of gas containing impurities, may be used. The alloy containing iron, chromium, nickel, and the like is rigid, resistant to heat, and suitable for processing. Here, when surface unevenness of the member is reduced by polishing or the like to reduce the surface area, the release of gas can be reduced.

Alternatively, the above-described member of the manufacturing apparatus 2700 may be covered with iron fluoride, aluminum oxide, chromium oxide, or the like.

The member of the manufacturing apparatus 2700 is preferably formed using only metal when possible, and in the case where a viewing window formed of quartz or the like is provided, for example, the surface is preferably thinly covered with iron fluoride, aluminum oxide, chromium oxide, or the like to inhibit release of gas.

An adsorbed substance present in the transfer chamber 2704 and each of the chambers does not affect the pressure in the transfer chamber 2704 and each of the chambers because it is adsorbed onto an inner wall or the like; however, it causes release of gas when the transfer chamber 2704 and each of the chambers are evacuated. Thus, although there is no correlation between the leakage rate and the exhaust rate, it is important that the adsorbed substance present in the transfer chamber 2704 and each of the chambers be desorbed as much as possible and evacuation be performed in advance with the use of a pump with high exhaust capability. Note that the transfer chamber 2704 and each of the chambers may be subjected to baking to promote desorption of the adsorbed substance. By the baking, the desorption rate of the adsorbed substance can be increased about tenfold. The baking is performed at higher than or equal to 100 °C and lower than or equal to 450 °C. At this time, when the adsorbed substance is removed while an inert gas is introduced into the transfer chamber 2704 and each of the chambers, the desorption rate of water or the like, which is difficult to desorb simply by evacuation, can be further increased. Note that when the inert gas to be introduced is heated to substantially the same temperature as the baking temperature, the desorption rate of the adsorbed substance can be further increased. Here, a noble gas is preferably used as the inert gas.

Alternatively, treatment for evacuating the transfer chamber 2704 and each of the chambers is preferably performed a certain period of time after a heated inert gas such as a noble gas, heated oxygen, or the like is introduced to increase the pressure in the transfer chamber 2704 and each of the chambers. The introduction of the heated gas can desorb the adsorbed substance in the transfer chamber 2704 and each of the chambers, and impurities present in the transfer chamber 2704 and each of the chambers can be reduced. Note that this treatment is effective when repeated more than or equal to 2 times and less than or equal to 30 times, preferably more than or equal to 5 times and less than or equal to 15 times. Specifically, an inert gas, oxygen, or the like at a temperature higher than or equal to 40 °C and lower than or equal to 400 °C, preferably higher than or equal to 50 °C and lower than or equal to 200 °C is introduced, so that the pressure in the transfer chamber 2704 and each of the chambers can be kept at higher than or equal to 0.1 Pa and lower than or equal to 10 kPa, preferably higher than or equal to 1 Pa and lower than or equal to 1 kPa, further preferably higher than or equal to 5 Pa and lower than or equal to 100 Pa in the time range of 1 minute to 300 minutes, preferably 5 minutes to 120 minutes. After that, the transfer chamber 2704 and each of the chambers are evacuated in the time range of 5 minutes to 300 minutes, preferably 10 minutes to 120 minutes.

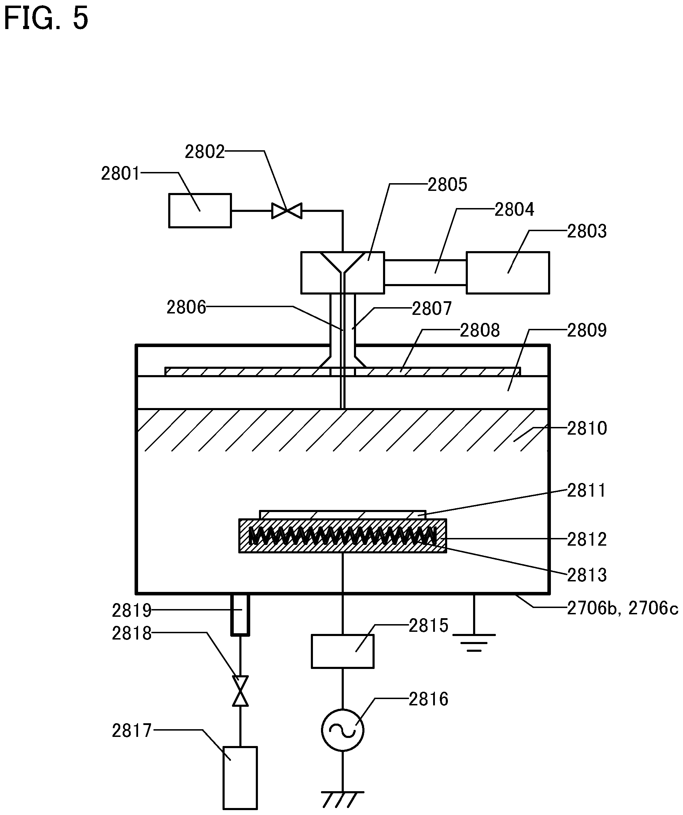

Next, the chamber 2706b and the chamber 2706c are described with reference to a schematic cross-sectional view illustrated in FIG. 5.

The chamber 2706b and the chamber 2706c are chambers in which microwave treatment can be performed on an object to be processed, for example. Note that the chamber 2706b is different from the chamber 2706c only in the atmosphere in performing the microwave treatment. The other structures are common and thus collectively described below.

The chamber 2706b and the chamber 2706c each include a slot antenna plate 2808, a dielectric plate 2809, a substrate holder 2812, and an exhaust port 2819. Furthermore, a gas supply source 2801, a valve 2802, a high-frequency generator 2803, a waveguide 2804, a mode converter 2805, a gas pipe 2806, a waveguide 2807, a matching box 2815, a high-frequency power source 2816, a vacuum pump 2817, and a valve 2818 are provided outside the chamber 2706b and the chamber 2706c, for example.

The high-frequency generator 2803 is connected to the mode converter 2805 through the waveguide 2804. The mode converter 2805 is connected to the slot antenna plate 2808 through the waveguide 2807. The slot antenna plate 2808 is placed in contact with the dielectric plate 2809. Furthermore, the gas supply source 2801 is connected to the mode converter 2805 through the valve 2802. Then, gas is transferred to the chamber 2706b and the chamber 2706c through the gas pipe 2806 that runs through the mode converter 2805, the waveguide 2807, and the dielectric plate 2809. Furthermore, the vacuum pump 2817 has a function of exhausting gas or the like from the chamber 2706b and the chamber 2706c through the valve 2818 and the exhaust port 2819. Furthermore, the high-frequency power source 2816 is connected to the substrate holder 2812 through the matching box 2815.

The substrate holder 2812 has a function of holding a substrate 2811. For example, the substrate holder 2812 has a function of an electrostatic chuck or a mechanical chuck for holding the substrate 2811. Furthermore, the substrate holder 2812 has a function of an electrode to which power is supplied from the high-frequency power source 2816. Furthermore, the substrate holder 2812 includes a heating mechanism 2813 therein and has a function of heating the substrate 2811.

As the vacuum pump 2817, a dry pump, a mechanical booster pump, an ion pump, a titanium sublimation pump, a cryopump, or a turbomolecular pump can be used, for example. Furthermore, in addition to the vacuum pump 2817, a cryotrap may be used. The use of the cryopump and the cryotrap is particularly preferable because water can be efficiently exhausted.

Furthermore, for example, the heating mechanism 2813 is a heating mechanism that uses a resistance heater or the like for heating. Alternatively, a heating mechanism that uses heat conduction or heat radiation from a medium such as a heated gas for heating may be used. For example, RTA (Rapid Thermal Annealing) such as GRTA (Gas Rapid Thermal Annealing) or LRTA (Lamp Rapid Thermal Annealing) can be used. In GRTA, heat treatment is performed using a high-temperature gas. An inert gas is used as the gas.

Furthermore, the gas supply source 2801 may be connected to a purifier through a mass flow controller. As the gas, a gas whose dew point is -80 °C or lower, preferably -100 °C or lower is preferably used. For example, an oxygen gas, a nitrogen gas, or a noble gas (an argon gas or the like) is used.

As the dielectric plate 2809, silicon oxide (quartz), aluminum oxide (alumina), yttrium oxide (yttria), or the like is used, for example. Furthermore, another protective layer may be further formed on a surface of the dielectric plate 2809. For the protective layer, magnesium oxide, titanium oxide, chromium oxide, zirconium oxide, hafnium oxide, tantalum oxide, silicon oxide, aluminum oxide, yttrium oxide, or the like is used. The dielectric plate 2809 is exposed to an especially high-density region of high-density plasma 2810 described later; thus, providing the protective layer can reduce the damage. Consequently, an increase in the number of particles or the like during the treatment can be inhibited.

The high-frequency generator 2803 has a function of generating a microwave at, for example, higher than or equal to 0.3 GHz and lower than or equal to 3.0 GHz, higher than or equal to 0.7 GHz and lower than or equal to 1.1 GHz, or higher than or equal to 2.2 GHz and lower than or equal to 2.8 GHz. The microwave generated by the high-frequency generator 2803 is propagated to the mode converter 2805 through the waveguide 2804. The mode converter 2805 converts the microwave propagated in the TE (Transverse Electric) mode into the microwave in the TEM (Transverse Electomagnetic) mode. Then, the microwave propagates to the slot antenna plate 2808 through the waveguide 2807. The slot antenna plate 2808 is provided with a plurality of slot holes, and the microwave passes through the slot holes and the dielectric plate 2809. Then, an electric field is generated below the dielectric plate 2809, and the high-density plasma 2810 can be generated. In the high-density plasma 2810, ions and radicals based on the gas species supplied from the gas supply source 2801 are present. For example, oxygen radicals are present.

At this time, the quality of a film or the like over the substrate 2811 can be modified by the ions and radicals generated in the high-density plasma 2810. Note that it is preferable in some cases to apply a bias to the substrate 2811 side using the high-frequency power source 2816. As the high-frequency power source 2816, an RF (Radio Frequency) power source with a frequency of 13.56 MHz, 27.12 MHz, or the like is used, for example. The application of a bias to the substrate side allows ions in the high-density plasma 2810 to efficiently reach a deep portion of an opening of the film or the like over the substrate 2811.

For example, in the chamber 2706b or the chamber 2706c, oxygen radical treatment using the high-density plasma 2810 can be performed by introducing oxygen from the gas supply source 2801.

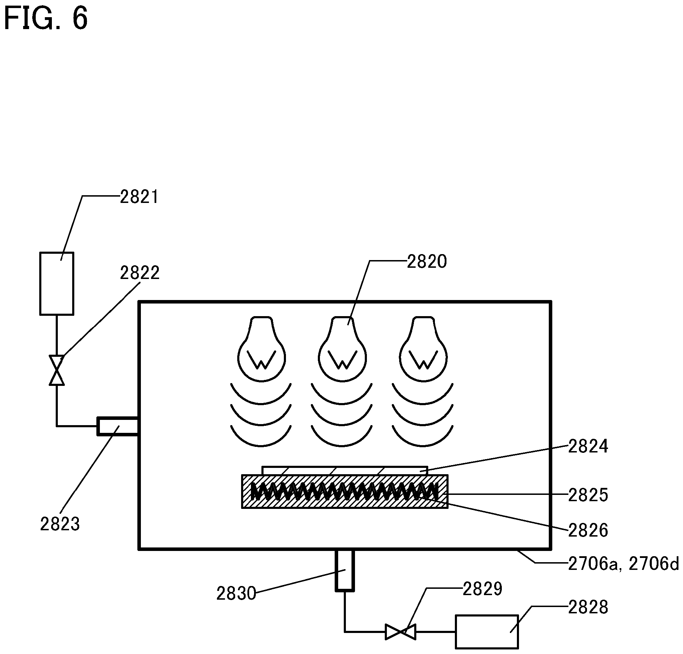

Next, the chamber 2706a and the chamber 2706d are described with reference to a schematic cross-sectional view illustrated in FIG. 6.

The chamber 2706a and the chamber 2706d are chambers in which an object to be processed can be irradiated with electromagnetic waves, for example. Note that the chamber 2706a is different from the chamber 2706d only in the kind of the electromagnetic waves. The other structures have many common portions and thus are collectively described below.

The chamber 2706a and the chamber 2706d each include one or a plurality of lamps 2820, a substrate holder 2825, a gas inlet 2823, and an exhaust port 2830. Furthermore, a gas supply source 2821, a valve 2822, a vacuum pump 2828, and a valve 2829 are provided outside the chamber 2706a and the chamber 2706d, for example.

The gas supply source 2821 is connected to the gas inlet 2823 through the valve 2822. The vacuum pump 2828 is connected to the exhaust port 2830 through the valve 2829. The lamp 2820 is provided to face the substrate holder 2825. The substrate holder 2825 has a function of holding a substrate 2824. Furthermore, the substrate holder 2825 includes a heating mechanism 2826 therein and has a function of heating the substrate 2824.

As the lamp 2820, a light source having a function of emitting electromagnetic waves such as visible light and ultraviolet light is used, for example. For example, a light source having a function of emitting electromagnetic waves which have a peak at a wavelength longer than or equal to 10 nm and shorter than or equal to 2500 nm, longer than or equal to 500 nm and shorter than or equal to 2000 nm, or longer than or equal to 40 nm and shorter than or equal to 340 nm is used.

As the lamp 2820, a light source such as a halogen lamp, a metal halide lamp, a xenon arc lamp, a carbon arc lamp, a high-pressure sodium lamp, or a high-pressure mercury lamp is used, for example.

For example, part or the whole of electromagnetic waves emitted from the lamp 2820 is absorbed by the substrate 2824, so that the quality of a film or the like over the substrate 2824 can be modified. For example, generation or reduction of defects or removal of impurities can be performed. Note that generation or reduction of defects, removal of impurities, or the like can be efficiently performed while the substrate 2824 is heated.

Alternatively, for example, the electromagnetic waves emitted from the lamp 2820 may generate heat in the substrate holder 2825 to heat the substrate 2824. In that case, the substrate holder 2825 does not need to include the heating mechanism 2826 therein.

For the vacuum pump 2828, refer to the description of the vacuum pump 2817. Furthermore, for the heating mechanism 2826, refer to the description of the heating mechanism 2813. Furthermore, for the gas supply source 2821, refer to the description of the gas supply source 2801.

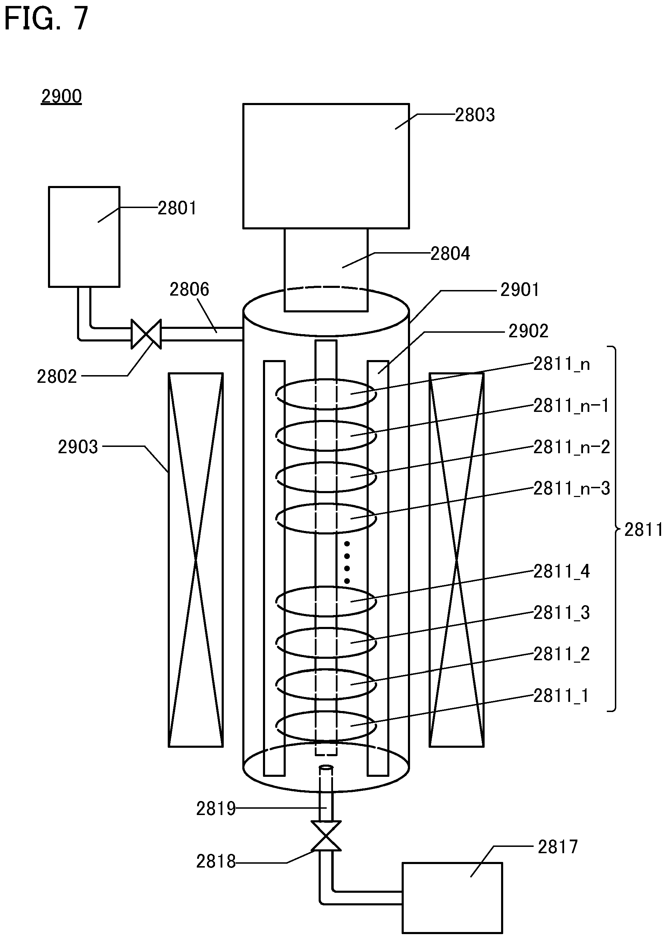

A microwave treatment apparatus that can be used in this embodiment is not limited to the above. It is possible to use a microwave treatment apparatus 2900 illustrated in FIG. 7. The microwave treatment apparatus 2900 includes a quartz tube 2901, the exhaust port 2819, the gas supply source 2801, the valve 2802, the high-frequency generator 2803, the waveguide 2804, the gas pipe 2806, the vacuum pump 2817, and the valve 2818. Furthermore, the microwave treatment apparatus 2900 includes a substrate holder 2902 that holds a plurality of substrates 2811 (2811_1 to 2811_*n*, where *n* is an integer greater than or equal to 2) in the quartz tube 2901. The microwave treatment apparatus 2900 may further include a heating means 2903 outside the quartz tube 2901.

The substrate placed in the quartz tube 2901 is irradiated with the microwave generated by the high-frequency generator 2803 through the waveguide 2804. The vacuum pump 2817 is connected to the exhaust port 2819 through the valve 2818 and can adjust the pressure inside the quartz tube 2901. The gas supply source 2801 is connected to the gas pipe 2806 through the valve 2802 and can introduce a desired gas into the quartz tube 2901. The heating means 2903 can heat the substrate 2811 in the quartz tube 2901 to a desired temperature. Alternatively, the heating means 2903 may heat the gas which is supplied from the gas supply source 2801. With the use of the microwave treatment apparatus 2900, the substrate 2811 can be subjected to heat treatment and microwave treatment at the same time. Alternatively, the substrate 2811 can be heated and then subjected to microwave treatment. Alternatively, the substrate 2811 can be subjected to microwave treatment and then heat treatment.

All of the substrate 2811_1 to the substrate 2811_*n* may be substrates to be treated where a semiconductor device or a memory device is to be formed, or some of the substrates may be dummy substrates. For example, the substrate 2811_1 and the substrate 2811_*n* may be dummy substrates and the substrate 2811_2 to the substrate 2811_*n*-1 may be substrates to be treated. Alternatively, the substrate 2811_1, the substrate 2811_2, the substrate 2811_*n*-1, and the substrate 2811_*n* may be dummy substrates and the substrate 2811_3 to the substrate 2811_*n*-2 may be substrates to be treated. A dummy substrate is preferably used, in which case a plurality of substrates to be treated can be uniformly treated at the time of microwave treatment or heat treatment and a variation between the substrates to be treated can be reduced. For example, a dummy substrate is preferably placed over the substrate to be treated which is the closest to the high-frequency generator 2803 and the waveguide 2804, in which case the substrate to be treated can be inhibited from being directly exposed to a microwave.

With the use of the above-described manufacturing apparatus, the quality of a film or the like can be modified while the entry of impurities into an object to be processed is inhibited.

Note that the apparatus having a function of performing microwave treatment on an object to be processed or the apparatus having a function of performing electron irradiation on an object to be processed, which is described above, may be provided in any one of the deposition chamber 4008 to the deposition chamber 4010 illustrated in FIG. 2A. At this time, by using the deposition apparatus 4000 illustrated in FIG. 2A, microwave treatment can be successively performed without exposure to the air after deposition of the metal oxide by an ALD method. With such treatment, impurities or moisture from the atmospheric environment can be prevented from being attached onto the metal oxide.

### <Deposition sequence>

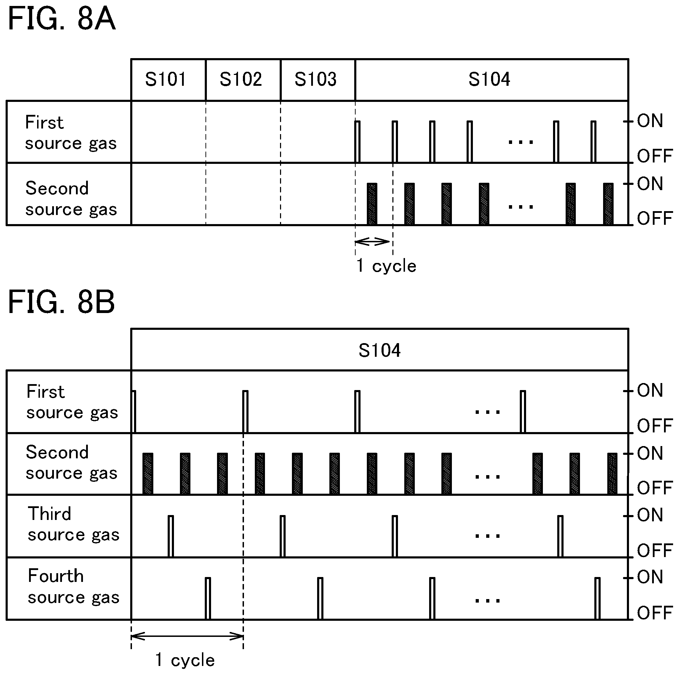

Next, a deposition sequence of a metal oxide using the ALD apparatus illustrated in FIG. 2B is described with reference to FIG. 8A and FIG. 8B. In FIG. 8A and FIG. 8B, introductions of the first source gas to a fourth source gas are each indicated by ON, and periods during which the source gases are not introduced are each indicated by OFF.

FIG. 8A shows a deposition sequence using the ALD apparatus illustrated in FIG. 2B. First, the substrate 4030 is set on the substrate holder 4026 in the chamber 4020 (Step S101). Next, the temperature of the heater 4027 is adjusted (Step S102). Then, the substrate 4030 is held on the substrate holder 4026 so that the temperature of the substrate 4030 becomes uniform in the substrate surface (Step S103). Next, a metal oxide is deposited in accordance with the above first step to fourth step (Step S104). Note that after setting the substrate 4030 (Step S101), Step S102 may be omitted if the temperature of the heater 4027 does not need to be adjusted.

In Step S 104, the first source gas (a source gas containing a precursor) and the second source gas (a source gas containing a reactant) are alternately introduced into the chamber 4020 to perform deposition over the substrate 4030. The first source gas and the second source gas are introduced in a pulsed form. In periods during which neither the first source gas nor the second source gas is introduced, the chamber 4020 is purged. In the deposition by an ALD method, introduction of the first source gas (the first step), purge of the first source gas (the second step), introduction of the second source gas (the third step), and purge of the second source gas (the fourth step) are regarded as one cycle, and a film having a desired thickness is formed by repetition of this cycle.

Furthermore, the second source gas containing a reactant may be introduced into the chamber 4020 between Step S103 and Step S104. It is preferable that one or more selected from ozone (O₃), oxygen (O₂), and water (H₂O), which function as oxidizers, be introduced as the second source gas. Introduction of water as the second source gas can form a hydrophilic group on the substrate 4030, so that the precursor can have a much improved adsorption property. Introduction of ozone and oxygen as the second source gas can set the inside of the chamber in an oxygen atmosphere and supply oxygen to the base insulating film or the like formed on the substrate 4030. Accordingly, oxygen can be supplied to the metal oxide film formed over the base insulating film, so that the oxygen concentration in the film can be increased. In that case, the second source gas is preferably introduced in a pulsed form in a manner similar to that in Step S104; however, the present invention is not limited thereto. The second source gas may be successively introduced. In the period during which the second source gas is not introduced, the chamber 4020 is evacuated.

A first oxide layer is formed in one cycle using the above first source gas, a second oxide layer is formed in one cycle using the third source gas different from the first source gas, and a third oxide layer is formed in one cycle using the fourth source gas different from the first source gas, whereby a layered crystalline oxide including different oxide layers can be deposited. Hereinafter, a deposition sequence corresponding to a deposition process of an In-*M*-Zn oxide is described as an example with reference to FIG. 8B.

FIG. 8B shows Step S 104 of the deposition sequence in an example in which deposition is performed using the first source gas to the fourth source gas containing precursors. Note that Step S 101 to Step S 103 are performed in a manner similar to the above. Here, the first source gas contains a precursor containing indium, the third source gas contains a precursor containing the element *M* (*M* is any one or more of gallium, aluminum, and yttrium), and the fourth source gas contains a precursor containing zinc. The second source gas contains one or more selected from ozone, oxygen, and water. Note that examples of other elements that can be used as the element *M* include iron, cobalt, nickel, lanthanum, cerium, neodymium, magnesium, and calcium. Note that a plurality of the above elements may be used in combination as the element *M*.

As shown in FIG. 8B, first, the first source gas is introduced, whereby the precursor containing indium is adsorbed onto the substrate 4030. Then, introduction of the first source gas is stopped and an excess first source gas in the chamber is purged.

Next, the second source gas is introduced, whereby the adsorbed precursor containing indium reacts with an oxidizer and a layer of indium oxide is formed. Then, introduction of the second source gas is stopped and an excess second source gas in the chamber is purged.

Next, the third source gas is introduced, whereby the precursor containing the element *M* is adsorbed onto the layer of indium oxide. Then, introduction of the third source gas is stopped and an excess third source gas in the chamber is purged.

Next, the second source gas is introduced, whereby the adsorbed precursor containing the element *M* reacts with an oxidizer and an oxide layer of the element *M* is formed. Then, introduction of the second source gas is stopped and an excess second source gas in the chamber is purged.

Next, the fourth source gas is introduced, whereby the precursor containing zinc is adsorbed onto the oxide layer of the element *M*. Then, introduction of the fourth source gas is stopped and an excess fourth source gas in the chamber is purged.

Next, the second source gas is introduced, whereby the adsorbed precursor containing zinc reacts with an oxidizer and a layer of zinc oxide is formed. Then, introduction of the second source gas is stopped and an excess second source gas in the chamber is purged. Furthermore, the precursor containing indium is adsorbed onto the zinc oxide by the above method.

The above steps of forming the indium oxide, the oxide of the element *M*, and the zinc oxide are regarded as one cycle and the cycle is repeated, whereby an In-*M*-Zn oxide with In: *M:* Zn = 1:1:1 [atomic ratio] having a desired thickness can be formed.

Note that the first source gas to the fourth source gas are introduced in a pulsed form. The pulse time of introducing the first source gas, the third source gas, and the fourth source gas into the chamber 4020 is longer than or equal to 0.05 seconds and shorter than or equal to 1 second, preferably longer than or equal to 0.1 seconds and shorter than or equal to 0.5 seconds. The time for exhausting the first source gas, the third source gas, and the fourth source gas from the chamber 4020 is longer than or equal to 0.1 seconds and shorter than or equal to 15 seconds, preferably longer than or equal to 0.5 seconds and shorter than or equal to 10 seconds. The pulse time of introducing the second source gas into the chamber 4020 is longer than or equal to 0.05 seconds and shorter than or equal to 30 seconds, preferably longer than or equal to 0.1 seconds and shorter than or equal to 15 seconds. The time for exhausting the second source gas from the chamber 4020 is longer than or equal to 0.1 seconds and shorter than or equal to 15 seconds, preferably longer than or equal to 0.1 seconds and shorter than or equal to 5 seconds.

Note that in the sequence shown in FIG. 8B, the order of introduction of the first source gas, the third source gas, and the fourth source gas is not limited thereto. For example, the fourth gas containing the precursor containing zinc may be introduced first. Since zinc oxide is more likely to form a crystal structure than indium oxide and the oxide of the element *M*, a stable crystal of zinc oxide can be formed in a bottom layer. Accordingly, the layers of the indium oxide and the oxide of the element M can be comparatively easily formed over the zinc oxide.

The deposition of the In-*M*-Zn oxide with In: *M:* Zn = 1:1:1 [atomic ratio] is described above; however, the present invention is not limited thereto. An In-*M*-Zn oxide with a different atomic ratio can be formed by a similar method. The number of pulses or the pulse time of a source gas containing a precursor in one cycle is preferably set in accordance with the atomic ratio of a desired In-*M*-Zn oxide.

For example, in the sequence shown in FIG. 8B, in order to deposit an In-*M*-Zn oxide with In: *M*: Zn = 1:1:1 [atomic ratio], the numbers of pulses of the first source gas containing indium, the third source gas containing the element *M*, and the fourth source gas containing zinc are each one in one cycle. Here, the pulse times of the precursors are the same.

Note that in the above, introductions of different kinds of precursors are performed with the source gas containing a reactant introduced therebetween; however, the present invention is not limited thereto. For example, introductions of source gases containing the same kind of precursor may be successively performed with the source gas containing a reactant introduced therebetween. At this time, the numbers of pulses of the source gases containing the precursors in one cycle are preferably the same as the atomic ratio of a desired In-*M*-Zn oxide.

Moreover, in the above, the structure in which only the source gas containing one kind of precursor is introduced in the interval between the oxidations using the second source gas is shown; however, the present invention is not limited thereto. Two or more kinds of source gases containing precursors may be introduced in the interval between the oxidations using the second source gas. At this time, two or more kinds of source gases containing precursors may be introduced at the same time. Alternatively, the same kind of precursor may be introduced twice successively in the interval between the oxidations using the second source gas.

The deposition of the oxide with a constant atomic ratio is described above; however, the present invention is not limited thereto. Two or more kinds of oxides with different atomic ratios can be successively deposited by a similar method. In this case, for stacked oxides with different atomic ratios, the number of pulses or the pulse time of a source gas containing a precursor in one cycle is preferably set in accordance with the atomic ratios of the oxides. When deposition is performed in such a manner, the stacked oxides with different atomic ratios can be deposited in one chamber. Thus, entry of an impurity such as hydrogen or carbon in the interval between the depositions of the oxides can be prevented.

In the above, the deposition method is described using the In-*M*-Zn oxide as an example; however, the present invention is not limited thereto. A precursor is set as appropriate in accordance with a metal element contained in a desired metal oxide. In the above, one or three kinds of precursors are used; however, without limitation to this, two kinds or four or more kinds may be used.

In the above, the example in which deposition is performed using a precursor containing one kind of metal element is described; however, the present invention is not limited thereto. A precursor containing two or more kinds of metal elements may be used. For example, a precursor containing indium and the element *M*, a precursor containing the element *M* and zinc, or the like may be used. In such a case, the number of source material supply portions 4021 illustrated in FIG. 2B or the like can be reduced.

### <Classification of crystal structure>

Hereinafter, the classification of the crystal structures of the above metal oxide (oxide semiconductor) is explained.

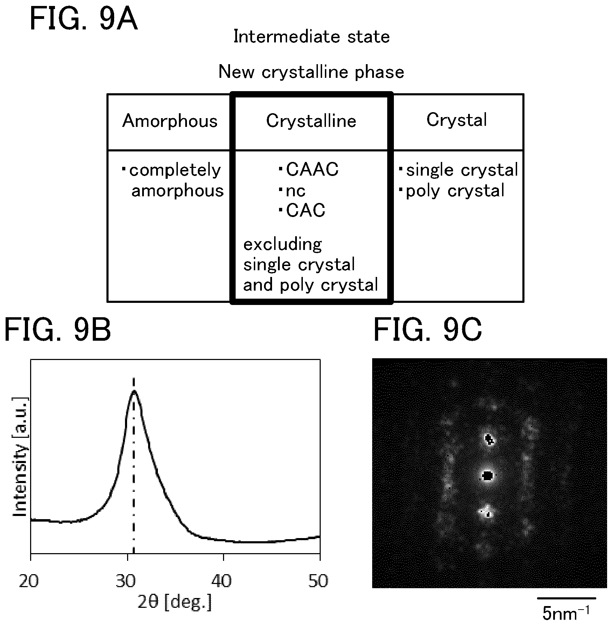

First, the classification of crystal structures of an oxide semiconductor is described with reference to FIG. 9A. FIG. 9A is a diagram showing the classification of crystal structures of an oxide semiconductor, typically IGZO (a metal oxide containing In, Ga, and Zn).

As shown in FIG. 9A, an oxide semiconductor is roughly classified into "Amorphous", "Crystalline", and "Crystal". "Amorphous" includes completely amorphous. "Crystalline" includes CAAC, nc, and CAC (cloud-aligned composite) (excluding single crystal and poly crystal). Note that in the classification of "Crystalline", single crystal, poly crystal, and completely amorphous are excluded. "Crystal" includes single crystal and poly crystal.

Note that the structures in the thick frame shown in FIG. 9A are in an intermediate state between "Amorphous" and "Crystal", and belong to a new boundary region (New crystalline phase). That is, these structures are completely different from "Amorphous", which is energetically unstable, and "Crystal".

A crystal structure of a film or a substrate can be evaluated with an X-ray diffraction (XRD) spectrum. Here, FIG. 9B shows an XRD spectrum, which is obtained by GIXD (Grazing-Incidence XRD) measurement, of a CAAC-IGZO film classified into "Crystalline". Note that a GIXD method is also referred to as a thin film method or a Seemann-Bohlin method. The XRD spectrum that is shown in FIG. 9B and obtained by GIXD measurement is hereinafter simply referred to as an XRD spectrum. The CAAC-IGZO film shown in FIG. 9B has a composition in the neighborhood of In: Ga: Zn = 4:2:3 [atomic ratio]. The CAAC-IGZO film shown in FIG. 9B has a thickness of 500 nm.

In FIG. 9B, the horizontal axis represents 2*θ* [deg.], and the vertical axis represents intensity [a.u.]. As shown in FIG. 9B, a clear peak indicating crystallinity is detected in the XRD spectrum of the CAAC-IGZO film. Specifically, a peak indicating c-axis alignment is detected at 2*θ* of around 31° in the XRD spectrum of the CAAC-IGZO film. As shown in FIG. 9B, the peak at 2*θ* of around 31° is asymmetric with respect to the axis of the angle at which the peak intensity is detected.

A crystal structure of a film or a substrate can also be evaluated with a diffraction pattern observed by a nanobeam electron diffraction (NBED) method (such a pattern is also referred to as a nanobeam electron diffraction pattern). FIG. 9C shows a diffraction pattern of the CAAC-IGZO film. FIG. 9C shows a diffraction pattern observed with NBED in which an electron beam is incident in the direction parallel to the substrate. The CAAC-IGZO film shown in FIG. 9C has a composition in the neighborhood of In: Ga: Zn = 4:2:3 [atomic ratio]. In the nanobeam electron diffraction method, electron diffraction is performed with a probe diameter of 1 nm.

As shown in FIG. 9C, a plurality of spots indicating c-axis alignment are observed in the diffraction pattern of the CAAC-IGZO film.

### [Structure of oxide semiconductor]

Oxide semiconductors might be classified in a manner different from that in FIG. 9A when classified in terms of the crystal structure. Oxide semiconductors are classified into a single crystal oxide semiconductor and a non-single-crystal oxide semiconductor, for example. Examples of the non-single-crystal oxide semiconductor include the above-described CAAC-OS and nc-OS. Other examples of the non-single-crystal oxide semiconductor include a polycrystalline oxide semiconductor, an amorphous-like oxide semiconductor (a-like OS), and an amorphous oxide semiconductor.

Next, the above-described CAAC-OS, nc-OS, and a-like OS will be described in detail.

### [CAAC-OS]

The CAAC-OS is an oxide semiconductor that has a plurality of crystal regions each of which has c-axis alignment in a particular direction. Note that the particular direction refers to the film thickness direction of a CAAC-OS film, the normal direction of the surface where the CAAC-OS film is formed, or the normal direction of the surface of the CAAC-OS film. The crystal region refers to a region having a periodic atomic arrangement. When an atomic arrangement is regarded as a lattice arrangement, the crystal region also refers to a region with a uniform lattice arrangement. The CAAC-OS has a region where a plurality of crystal regions are connected in the a-b plane direction, and the region has distortion in some cases. Note that the distortion refers to a portion where the direction of a lattice arrangement changes between a region with a uniform lattice arrangement and another region with a uniform lattice arrangement in a region where a plurality of crystal regions are connected. That is, the CAAC-OS is an oxide semiconductor having c-axis alignment and having no clear alignment in the a-b plane direction.

Note that each of the plurality of crystal regions is formed of one or more fine crystals (crystals each of which has a maximum diameter of less than 10 nm). In the case where the crystal region is formed of one fine crystal, the maximum diameter of the crystal region is less than 10 nm. In the case where the crystal region is formed of a large number of fine crystals, the size of the crystal region may be approximately several tens of nanometers.

In the case of an In-*M*-Zn oxide, the CAAC-OS tends to have a layered crystal structure (also referred to as a layered structure) in which a layer containing indium (In) and oxygen (hereinafter, an In layer) and a layer containing the element *M*, zinc (Zn), and oxygen (hereinafter, an (*M*,Zn) layer) are stacked. Indium and the element *M* can be replaced with each other. Therefore, indium may be contained in the (*M*,Zn) layer. In addition, the element *M* may be contained in the In layer. Note that Zn may be contained in the In layer. Such a layered structure is observed as a lattice image in a high-resolution TEM image, for example.

When the CAAC-OS film is subjected to structural analysis by Out-of-plane XRD measurement with an XRD apparatus using *θ*/2*θ* scanning, for example, a peak indicating c-axis alignment is detected at 2*θ* of 31° or around 31°. Note that the position of the peak indicating c-axis alignment (the value of 2*θ*) may change depending on the kind, composition, or the like of the metal element contained in the CAAC-OS.

For example, a plurality of bright spots are observed in the electron diffraction pattern of the CAAC-OS film. Note that one spot and another spot are observed point-symmetrically with a spot of the incident electron beam passing through a sample (also referred to as a direct spot) as the symmetric center.

When the crystal region is observed from the particular direction, a lattice arrangement in the crystal region is basically a hexagonal lattice arrangement; however, a unit lattice is not always a regular hexagon and is a non-regular hexagon in some cases. A pentagonal lattice arrangement, a heptagonal lattice arrangement, and the like are included in the distortion in some cases. Note that a clear grain boundary cannot be observed even in the vicinity of the distortion in the CAAC-OS. That is, formation of a grain boundary is inhibited by the distortion of a lattice arrangement. This is probably because the CAAC-OS can tolerate distortion owing to a low density of arrangement of oxygen atoms in the a-b plane direction, an interatomic bond distance changed by substitution of a metal atom, and the like.

A crystal structure in which a clear grain boundary is observed is what is called polycrystal. It is highly probable that the grain boundary becomes a recombination center and captures carriers and thus decreases the on-state current and field-effect mobility of a transistor, for example. Thus, the CAAC-OS in which no clear grain boundary is observed is one of crystalline oxides having a crystal structure suitable for a semiconductor layer of a transistor. Note that Zn is preferably contained to form the CAAC-OS. For example, an In-Zn oxide and an In-Ga-Zn oxide are suitable because they can inhibit generation of a grain boundary as compared with an In oxide.

The CAAC-OS is an oxide semiconductor with high crystallinity in which no clear grain boundary is observed. Thus, in the CAAC-OS, a reduction in electron mobility due to the grain boundary is unlikely to occur. Moreover, since the crystallinity of an oxide semiconductor might be decreased by entry of impurities, formation of defects, or the like, the CAAC-OS can be regarded as an oxide semiconductor that has small amounts of impurities and defects (oxygen vacancies or the like). Thus, an oxide semiconductor including the CAAC-OS is physically stable. Therefore, the oxide semiconductor including the CAAC-OS is resistant to heat and has high reliability. In addition, the CAAC-OS is stable with respect to high temperature in the manufacturing process (what is called thermal budget). Accordingly, the use of the CAAC-OS for the OS transistor can extend the degree of freedom of the manufacturing process.

### [nc-OS]

In the nc-OS, a microscopic region (e.g., a region with a size greater than or equal to 1 nm and less than or equal to 10 nm, in particular, a region with a size greater than or equal to 1 nm and less than or equal to 3 nm) has a periodic atomic arrangement. In other words, the nc-OS includes a fine crystal. Note that the size of the fine crystal is, for example, greater than or equal to 1 nm and less than or equal to 10 nm, particularly greater than or equal to 1 nm and less than or equal to 3 nm; thus, the fine crystal is also referred to as a nanocrystal. Furthermore, there is no regularity of crystal orientation between different nanocrystals in the nc-OS. Thus, the orientation in the whole film is not observed. Accordingly, the nc-OS cannot be distinguished from an a-like OS and an amorphous oxide semiconductor with some analysis methods. For example, when an nc-OS film is subjected to structural analysis using Out-of-plane XRD measurement with an XRD apparatus using *θ*/2*θ* scanning, a peak indicating crystallinity is not detected. Furthermore, a diffraction pattern like a halo pattern is observed when the nc-OS film is subjected to electron diffraction (also referred to as selected-area electron diffraction) using an electron beam with a probe diameter larger than the diameter of a nanocrystal (e.g., larger than or equal to 50 nm). Meanwhile, in some cases, a plurality of spots in a ring-like region with a direct spot as the center are observed in the obtained electron diffraction pattern when the nc-OS film is subjected to electron diffraction (also referred to as nanobeam electron diffraction) using an electron beam with a probe diameter nearly equal to or smaller than the diameter of a nanocrystal (e.g., larger than or equal to 1 nm and smaller than or equal to 30 nm).

### [a-like OS]

The a-like OS is an oxide semiconductor having a structure between those of the nc-OS and the amorphous oxide semiconductor. The a-like OS includes a void or a low-density region. That is, the a-like OS has low crystallinity as compared with the nc-OS and the CAAC-OS. Moreover, the a-like OS has a higher hydrogen concentration in the film than the nc-OS and the CAAC-OS.

### [Structure of oxide semiconductor]

Next, the above-described CAC-OS will be described in detail. Note that the CAC-OS relates to the material composition.

### [CAC-OS]

The CAC-OS refers to one composition of a material in which elements constituting a metal oxide are unevenly distributed with a size greater than or equal to 0.5 nm and less than or equal to 10 nm, preferably greater than or equal to 1 nm and less than or equal to 3 nm, or a similar size, for example. Note that a state in which one or more metal elements are unevenly distributed and regions including the metal element(s) are mixed with a size greater than or equal to 0.5 nm and less than or equal to 10 nm, preferably greater than or equal to 1 nm and less than or equal to 3 nm, or a similar size in a metal oxide is hereinafter referred to as a mosaic pattern or a patch-like pattern.

In addition, the CAC-OS has a composition in which materials are separated into a first region and a second region to form a mosaic pattern, and the first regions are distributed in the film (this composition is hereinafter also referred to as a cloud-like composition). That is, the CAC-OS is a composite metal oxide having a composition in which the first regions and the second regions are mixed.

Note that the atomic ratios of In, Ga, and Zn to the metal elements contained in the CAC-OS in an In-Ga-Zn oxide are denoted with [In], [Ga], and [Zn], respectively. For example, the first region in the CAC-OS in the In-Ga-Zn oxide has [In] higher than that in the composition of the CAC-OS film. Moreover, the second region has [Ga] higher than that in the composition of the CAC-OS film. For example, the first region has higher [In] and lower [Ga] than the second region. Moreover, the second region has higher [Ga] and lower [In] than the first region.

Specifically, the first region includes indium oxide, indium zinc oxide, or the like as its main component. The second region includes gallium oxide, gallium zinc oxide, or the like as its main component. That is, the first region can be referred to as a region containing In as its main component. The second region can be referred to as a region containing Ga as its main component.

Note that a clear boundary between the first region and the second region cannot be observed in some cases.

For example, energy dispersive X-ray spectroscopy (EDX) is used to obtain EDX mapping, and according to the EDX mapping, the CAC-OS in the In-Ga-Zn oxide has a structure in which the region containing In as its main component (the first region) and the region containing Ga as its main component (the second region) are unevenly distributed and mixed.

In the case where the CAC-OS is used for a transistor, a switching function (on/off switching function) can be given to the CAC-OS owing to the complementary action of the conductivity derived from the first region and the insulating property derived from the second region. That is, the CAC-OS has a conducting function in part of the material and has an insulating function in another part of the material; as a whole, the CAC-OS has a function of a semiconductor. Separation of the conducting function and the insulating function can maximize each function. Accordingly, when the CAC-OS is used for a transistor, high on-state current (*I*ₒₙ), high field-effect mobility (µ), and excellent switching operation can be achieved.

An oxide semiconductor has various structures with different properties. Two or more kinds among the amorphous oxide semiconductor, the polycrystalline oxide semiconductor, the a-like OS, the CAC-OS, the nc-OS, and the CAAC-OS may be included in an oxide semiconductor of one embodiment of the present invention.

### <Transistor including oxide semiconductor>

Next, the case where the above oxide semiconductor is used for a transistor will be described.

When the above oxide semiconductor is used for a transistor, a transistor with high field-effect mobility can be achieved. In addition, a transistor having high reliability can be achieved.

An oxide semiconductor with a low carrier concentration is preferably used for a channel formation region of the transistor. For example, the carrier concentration of the channel formation region of the oxide semiconductor is preferably lower than or equal to 1 × 10¹⁸ cm⁻³, further preferably lower than 1 × 10¹⁷ cm⁻³, still further preferably lower than 1 × 10¹⁶ cm⁻³, yet further preferably lower than 1 × 10¹³ cm⁻³, yet still further preferably lower than 1 × 10¹² cm⁻³. In order to reduce the carrier concentration of an oxide semiconductor film, the impurity concentration in the oxide semiconductor film is reduced so that the density of defect states can be reduced. In this specification and the like, a state with a low impurity concentration and a low density of defect states is referred to as a highly purified intrinsic or substantially highly purified intrinsic state. Note that an oxide semiconductor having a low carrier concentration may be referred to as a highly purified intrinsic or substantially highly purified intrinsic oxide semiconductor. A highly purified intrinsic or substantially highly purified intrinsic state may be referred to as an i-type or a substantially i-type.

A highly purified intrinsic or substantially highly purified intrinsic oxide semiconductor film has a low density of defect states and thus has a low density of trap states in some cases.

Charge trapped by the trap states in the oxide semiconductor takes a long time to disappear and might behave like fixed charge. Thus, a transistor whose channel formation region is formed in an oxide semiconductor with a high density of trap states has unstable electrical characteristics in some cases.

Accordingly, in order to obtain stable electrical characteristics of a transistor, reducing the impurity concentration in an oxide semiconductor is effective. In order to reduce the impurity concentration in the oxide semiconductor, it is preferable that the impurity concentration in an adjacent film be also reduced. Examples of impurities include hydrogen, nitrogen, an alkali metal, an alkaline earth metal, iron, nickel, and silicon.

### <Impurity>

Here, the influence of each impurity in the oxide semiconductor will be described.

When silicon or carbon, which is one of Group 14 elements, is contained in the oxide semiconductor, defect states are formed in the oxide semiconductor. Thus, the concentration of silicon or carbon in the channel formation region of the oxide semiconductor and the concentration of silicon or carbon in the vicinity of the interface with the channel formation region of the oxide semiconductor (the concentration obtained by secondary ion mass spectrometry (SIMS)) are each set lower than or equal to 2 × 10¹⁸ atoms/cm³, preferably lower than or equal to 2 × 10¹⁷ atoms/cm³.

When the oxide semiconductor contains an alkali metal or an alkaline earth metal, defect states are formed and carriers are generated in some cases. Thus, a transistor using an oxide semiconductor that contains an alkali metal or an alkaline earth metal is likely to have normally-on characteristics. Thus, the concentration of an alkali metal or an alkaline earth metal in the channel formation region of the oxide semiconductor, which is obtained using SIMS, is lower than or equal to 1 × 10¹⁸ atoms/cm³, preferably lower than or equal to 2 × 10¹⁶ atoms/cm³.

Furthermore, when the oxide semiconductor contains nitrogen, the oxide semiconductor easily becomes n-type because of generation of electrons serving as carriers and an increase in carrier concentration. As a result, a transistor using an oxide semiconductor containing nitrogen as a semiconductor is likely to have normally-on characteristics. When nitrogen is contained in the oxide semiconductor, a trap state is sometimes formed. This might make the electrical characteristics of the transistor unstable. Therefore, the concentration of nitrogen in the channel formation region of the oxide semiconductor, which is obtained using SIMS, is set lower than 5 × 10¹⁹ atoms/cm³, preferably lower than or equal to 5 × 10¹⁸ atoms/cm³, further preferably lower than or equal to 1 × 10¹⁸ atoms/cm³, still further preferably lower than or equal to 5 × 10¹⁷ atoms/cm³.

Hydrogen contained in the oxide semiconductor reacts with oxygen bonded to a metal atom to be water, and thus forms an oxygen vacancy in some cases. Entry of hydrogen into the oxygen vacancy generates an electron serving as a carrier in some cases. Furthermore, bonding of part of hydrogen to oxygen bonded to a metal atom causes generation of an electron serving as a carrier in some cases. Thus, a transistor using an oxide semiconductor containing hydrogen is likely to have normally-on characteristics. Accordingly, hydrogen in the channel formation region of the oxide semiconductor is preferably reduced as much as possible. Specifically, the hydrogen concentration in the channel formation region of the oxide semiconductor, which is obtained using SIMS, is set lower than 1 × 10²⁰ atoms/cm³, preferably lower than 5 × 10¹⁹ atoms/cm³, further preferably lower than 1 × 10¹⁹ atoms/cm³, still further preferably lower than 5 × 10¹⁸ atoms/cm³, yet still further preferably lower than 1 × 10¹⁸ atoms/cm³.

When an oxide semiconductor with sufficiently reduced impurities is used for the channel formation region of the transistor, stable electrical characteristics can be given.

### <Other semiconductor materials>

A semiconductor material that can be used for a semiconductor 125 and a semiconductor 127 described in Embodiment 2 is not limited to the above oxide semiconductors. A semiconductor material that has a band gap (a semiconductor material that is not a zero-gap semiconductor) may be used for the semiconductor 125 and the semiconductor 127. For example, a single element semiconductor such as silicon, a compound semiconductor such as gallium arsenide, or a layered material functioning as a semiconductor (also referred to as an atomic layer material, a two-dimensional material, or the like) may be used as a semiconductor material. In particular, a layered material functioning as a semiconductor is preferably used as a semiconductor material.

In this specification and the like, the layered material generally refers to a group of materials having a layered crystal structure. In the layered crystal structure, layers formed by covalent bonding or ionic bonding are stacked with bonding such as the Van der Waals force, which is weaker than covalent bonding or ionic bonding. The layered material has high electrical conductivity in a monolayer, that is, high two-dimensional electrical conductivity. When a material that functions as a semiconductor and has high two-dimensional electrical conductivity is used for a channel formation region, a transistor having a high on-state current can be provided.

Examples of the layered material include graphene, silicene, and chalcogenide. Chalcogenide is a compound containing chalcogen. Chalcogen is a general term of elements belonging to Group 16, which includes oxygen, sulfur, selenium, tellurium, polonium, and livermorium. Examples of chalcogenide include transition metal chalcogenide and chalcogenide of Group 13 elements.

For the semiconductor 125 and the semiconductor 127, a transition metal chalcogenide functioning as a semiconductor is preferably used, for example. Specific examples of the transition metal chalcogenide which can be used for the semiconductor 125 and the semiconductor 127 include molybdenum sulfide (typically MoS₂), molybdenum selenide (typically MoSe₂), molybdenum telluride (typically MoTe₂), tungsten sulfide (typically WS₂), tungsten selenide (typically WSe₂), tungsten telluride (typically WTe₂), hafnium sulfide (typically HfS₂), hafnium selenide (typically HfSe₂), zirconium sulfide (typically ZrS₂), and zirconium selenide (typically ZrSe₂).

This embodiment can be implemented in an appropriate combination with the structures described in the other embodiments and the like.

### (Embodiment 2)

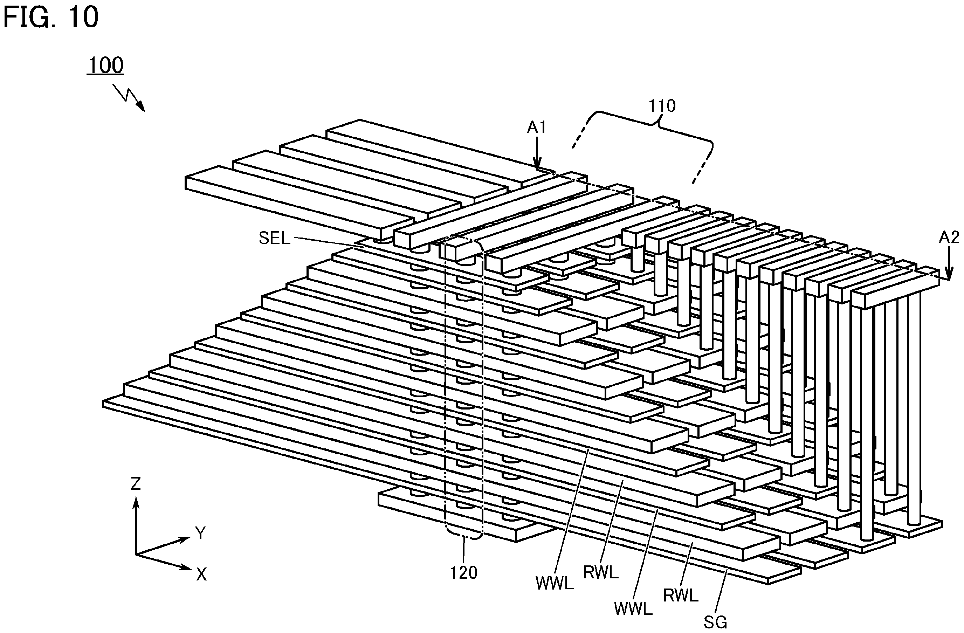

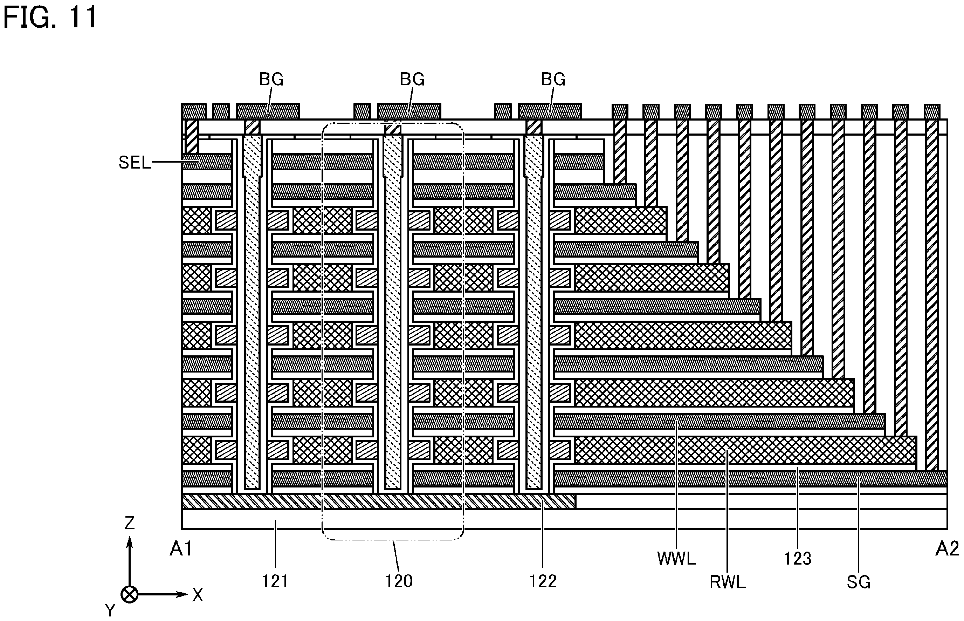

FIG. 10 illustrates a perspective view of a memory device 100 of one embodiment of the present invention. The memory device 100 is a memory device having a three-dimensional stacked-layer structure. FIG. 11 is a cross-sectional view of a portion A1-A2 indicated by a dashed-dotted line in FIG. 10 and a connection portion between a conductor SEL and a wiring. Note that arrows indicating the X direction, the Y direction, and the Z direction are illustrated in FIG. 10 and the like. The X direction, the Y direction, and the Z direction are directions orthogonal to each other. In this specification and the like, one of the X direction, the Y direction, and the Z direction is referred to as "first direction" in some cases. Another one of the directions is referred to as "second direction" in some cases. Furthermore, the remaining one of the directions is referred to as "third direction" in some cases. Note that in this embodiment and the like, the direction in which a conductor 130 described later extends is defined as the Z direction.

FIG. 11 illustrates a cross section along the X-Z plane. As described above, some components may be omitted in FIG. 10, FIG. 11, and the like for easy understanding of the explanation.

### <Structure example of memory device>

The memory device 100 of one embodiment of the present invention includes a memory cell array 110. The memory cell array 110 includes a plurality of memory strings 120. The memory strings 120 extend in the Z direction and are arranged in a matrix on the XY plane.

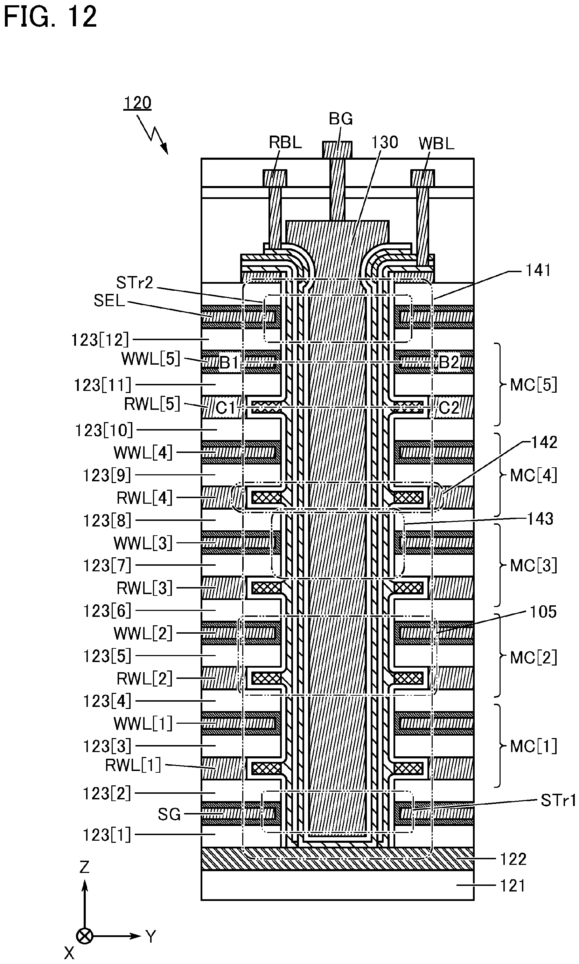

FIG. 12 illustrates a cross-sectional structure example of the memory string 120 of one embodiment of the present invention. The memory string 120 has a structure in which a plurality of memory elements MC (also referred to as "memory cells") are connected in series. Although the case where five memory elements MC are connected in series is described in this embodiment, the number of memory elements MC provided in the memory string 120 is not limited to five. Given that the number of memory elements MC provided in the memory string 120 is *n*, *n* is an integer of 2 or more.

Furthermore, the memory string 120 includes a plurality of conductors WWL, a plurality of conductors RWL, a conductor SG, and a conductor SEL. The plurality of conductors WWL and the plurality of conductors RWL are alternately stacked with insulators 123 therebetween. The conductor SG is provided in a layer below the plurality of conductors WWL and the plurality of conductors RWL. The conductor SEL is provided in a layer above the plurality of conductors WWL and the plurality of conductors RWL.

FIG. 12 illustrates the five memory elements MC as a memory element MC[1] to a memory element MC[5]. When explaining a matter common to the memory element MC[1] to the memory element MC[5], the memory elements are simply referred to as the "memory element(s) MC". The same applies to the other components such as the conductors WWL, the conductors RWL, and the insulators 123.

The memory string 120 includes a transistor STr1 connected to the memory element MC[1] and a transistor STr2 connected to the memory element MC[5].

The conductors WWL, the conductors RWL, the conductor SG, and the conductor SEL extend beyond the memory cell array 110. Furthermore, the conductors WWL, the conductors RWL, the conductor SG, and the conductor SEL are stacked stepwise outside the memory cell array 110 (see FIG. 10 and FIG. 11).

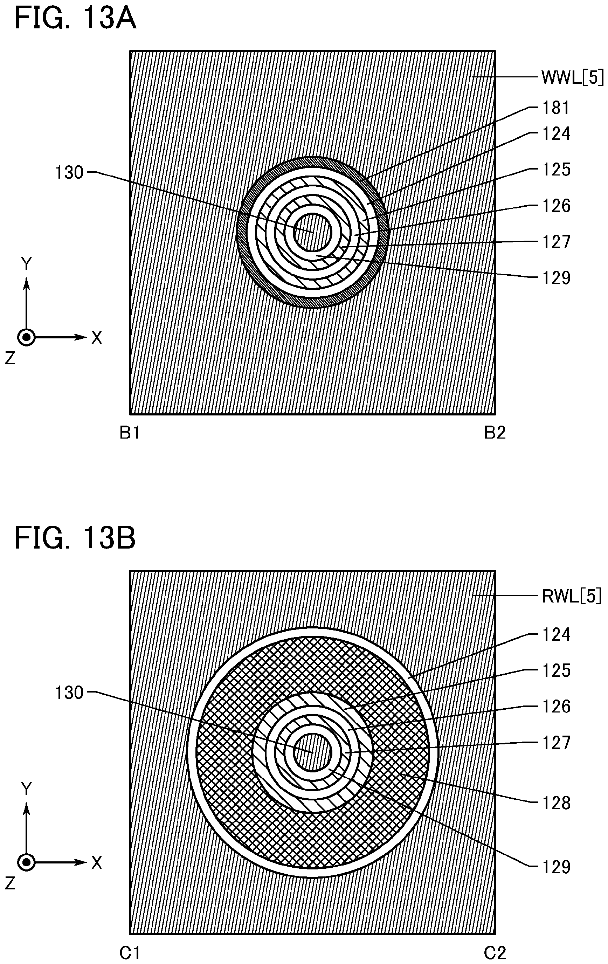

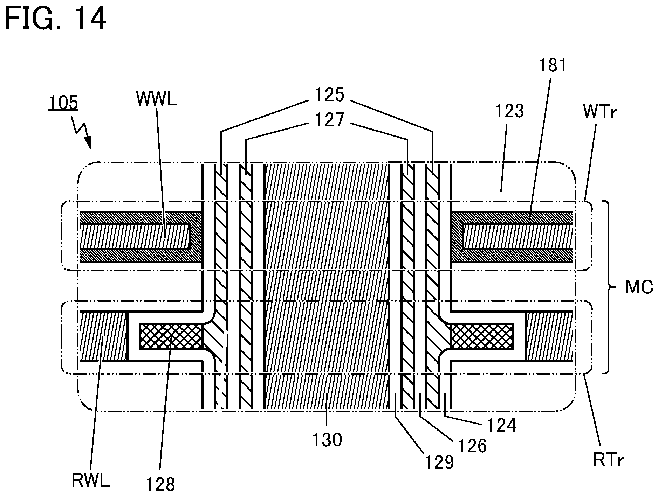

FIG. 13A illustrates a cross section of a portion B1-B2 indicated by a dashed-dotted line in FIG. 12 when seen from the Z direction. FIG. 13B illustrates a cross section of a portion C1-C2 indicated by a dashed-dotted line in FIG. 12 when seen from the Z direction. FIG. 14 illustrates an enlarged diagram of a region 105 indicated by a dashed double-dotted line in FIG. 12. FIG. 14 corresponds to a cross-sectional view of the memory element MC.

The memory string 120 includes a conductor 122 over a substrate 121. As the substrate 121, an insulator is used, for example. In addition, an insulator 123[1], the conductor SG, an insulator 123[2], a conductor RWL[1], an insulator 123[3], a conductor WWL[1], an insulator 123[4], a conductor RWL[2], an insulator 123[5], a conductor WWL[2], an insulator 123[6], a conductor RWL[3], an insulator 123[7], a conductor WWL[3], an insulator 123[8], a conductor RWL[4], an insulator 123[9], a conductor WWL[4], an insulator 123[10], a conductor RWL[5], an insulator 123[11], a conductor WWL[5], an insulator 123[12], and the conductor SEL are included over the conductor 122 (see FIG. 12).

Furthermore, the memory string 120 includes an opening 141 which is formed by removing part of each of the insulator 123[1], the conductor SG, the insulator 123[2], the conductor RWL[1], the insulator 123[3], the conductor WWL[1], the insulator 123[4], the conductor RWL[2], the insulator 123[5], the conductor WWL[2], the insulator 123[6], the conductor RWL[3], the insulator 123[7], the conductor WWL[3], the insulator 123[8], the conductor RWL[4], the insulator 123[9], the conductor WWL[4], the insulator 123[10], the conductor RWL[5], the insulator 123[11], the conductor WWL[5], the insulator 123[12], and the conductor SEL.

The opening 141 extends in the Z direction and reaches the conductor 122. In the opening 141, the diameter of a region 142 overlapping with the conductor RWL is larger than the diameter of a region 143 overlapping with the conductor WWL. Thus, a side surface of the opening 141 has projections and depressions.

An insulator 124 and the semiconductor 125 are provided along the side surface of the opening 141. Furthermore, in a region overlapping with the conductor RWL in the opening 141, a conductor 128 is provided between the insulator 124 and the semiconductor 125. The semiconductor 125 includes a region overlapping with the side surface of the opening 141 with the insulator 124 therebetween.

Furthermore, the memory string 120 includes the conductor 130 extending in the Z direction. The conductor 130 is provided in or in the vicinity of the center of the opening 141. A region of the conductor 130 overlapping with the side surface of the opening 141 is provided with an insulator 129, the semiconductor 127, and an insulator 126. The semiconductor 127 includes a region overlapping with a side surface of the conductor 130 with the insulator 129 therebetween. The insulator 126 includes a region overlapping with the side surface of the conductor 130 with the insulator 129 and the semiconductor 127 therebetween. In a bottom portion of the opening 141, the semiconductor 125 and the semiconductor 127 each include a region electrically connected to the conductor 122. In the bottom portion of the opening 141, the conductor 130 includes a region overlapping with the conductor 122 with the insulator 129 and the semiconductor 127 therebetween.

Between the conductor WWL and the conductor 130, an insulator 181, the insulator 124, the semiconductor 125, the insulator 126, the semiconductor 127, and the insulator 129 are provided in this order from the conductor WWL side (see FIG. 13A). Between the conductor RWL and the conductor 130, the insulator 124, the conductor 128, the semiconductor 125, the insulator 126, the semiconductor 127, and the insulator 129 are provided in this order from the conductor RWL side (see FIG. 13B).

The memory element MC includes a transistor WTr and a transistor RTr (see FIG. 14). A region where the conductor WWL and the conductor 130 overlap with each other functions as the transistor WTr. The conductor WWL functions as a gate electrode of the transistor WTr, and the conductor 130 functions as a back gate electrode of the transistor WTr. Part of the semiconductor 125 functions as a semiconductor layer where a channel of the transistor WTr is formed. The semiconductor layer where the channel of the transistor WTr is formed overlaps with the gate electrode (the conductor WWL) with part of the insulator 124 therebetween. Note that although part of the conductor WWL functions as the gate electrode in the example described in this embodiment and the like, the gate electrode and the conductor WWL may be provided independently and they may be electrically connected to each other.

A region where the conductor 128, the conductor RWL, and the conductor 130 overlap with one another functions as the transistor RTr. The conductor RWL functions as a gate electrode of the transistor RTr. The conductor 130 functions as a back gate electrode of the transistor RTr. Part of the semiconductor 127 functions as a semiconductor layer where a channel of the transistor RTr is formed. The semiconductor layer where the channel of the transistor RTr is formed overlaps with the gate electrode (the conductor RWL) with part of each of the insulator 126, the semiconductor 125, the conductor 128, and the insulator 124 therebetween. The semiconductor layer where the channel of the transistor RTr is formed overlaps with the back gate electrode (the conductor 130) with part of the insulator 129 therebetween.

The transistor STr1 includes the conductor SG, the semiconductor 125, and the semiconductor 127. The transistor STr2 includes the conductor SEL, the semiconductor 125, and the semiconductor 127.

Here, a back gate is described. A gate and a back gate are positioned so as to overlap with each other with a channel formation region of a semiconductor layer therebetween. The back gate can function like the gate. By changing the potential of the back gate, the threshold voltage of the transistor can be changed. One of the gate and the back gate is referred to as a "first gate" and the other is referred to as a "second gate", in some cases.

The gate and the back gate are formed using conductive layers, semiconductor layers with low resistivity, or the like and thus each have a function of preventing an electric field generated outside the transistor from influencing the semiconductor layer where a channel is formed (particularly, a function of blocking static electricity). Specifically, a variation in the electrical characteristics of the transistor due to the influence of an external electric field such as static electricity can be prevented.

Controlling the potential of the back gate can control the threshold voltage of the transistor. The potential of the back gate may be the same as the potential of the gate or may be a ground potential (GND potential) or a given potential.

For the semiconductor layers where the channels of the transistor WTr and the transistor RTr are formed, a single crystal semiconductor, a polycrystalline semiconductor, a microcrystalline semiconductor, an amorphous semiconductor, or the like can be used alone or in combination. As a semiconductor material, silicon, germanium, or the like can be used, for example. Alternatively, a compound semiconductor such as silicon germanium, silicon carbide, gallium arsenide, an oxide semiconductor, or a nitride semiconductor may be used. The same applies to the transistor STr1 and the transistor STr2.

Note that the semiconductor layers used for the transistor may be stacked. In the case of stacking semiconductor layers, semiconductors having different crystal states may be used, semiconductor materials having different compositions may be used, or different semiconductor materials may be used.

The semiconductor layers used for the transistor WTr, the transistor RTr, the transistor STr1, and the transistor STr2 are preferably oxide semiconductors including a metal oxide. A transistor that uses a metal oxide in its semiconductor layer achieves a higher field effect mobility than a transistor that uses amorphous silicon in its semiconductor layer. Furthermore, in a transistor that uses polycrystalline silicon in its semiconductor layer, a grain boundary might be generated in the semiconductor layer. It is highly probable that the grain boundary traps carriers and thus decreases the on-state current and field-effect mobility of the transistor, for example. By contrast, as described in detail later, an oxide semiconductor can have a crystal structure in which a clear grain boundary is not observed or a crystal structure in which the number of grain boundaries is extremely small. Using such an oxide semiconductor in a semiconductor layer is preferable to obtain a transistor with favorable electrical characteristics such as a high on-state current and a high field-effect mobility.

Moreover, an oxide semiconductor, particularly a CAAC-IGZO, which is a crystalline oxide semiconductor, has a characteristic structure where nanoclusters of several nanometers (e.g., greater than or equal to 1 nm and less than or equal to 3 nm) with a c-axis alignment in the direction vertical to a surface on which the oxide semiconductor is formed are connected to each other. Therefore, a crystal structure in which a clear grain boundary is not observed can be formed also in an opening extending in the Z direction.

In particular, the transistor WTr is preferably a transistor including an oxide semiconductor, which is a kind of metal oxide, in its semiconductor layer where a channel is formed (also referred to as an "OS transistor"). An oxide semiconductor has a band gap of 2 eV or more and thus has an extremely low off-state current. When an OS transistor is used as the transistor WTr, charge written to a node ND, which will be described later, can be retained for a long time. In the case where OS transistors are used as transistors included in the memory element MC, the memory element MC can be referred to as an "OS memory". In addition, the memory string 120 including the memory element MC can also be referred to as an "OS memory". Furthermore, the memory device 100 can also be referred to as an "OS memory".

The OS memory can retain written data for a year or more, or ten years or more even after power supply is stopped. Thus, the OS memory can be regarded as a nonvolatile memory.

In the OS memory, the amount of written charge is less likely to change over a long period of time; hence, the OS memory can retain multilevel (multibit) data as well as binary (1-bit) data.

Furthermore, an OS memory employs a method in which charge is written to a node through the OS transistor; hence, a high voltage, which is required for a conventional flash memory, is unnecessary and a high-speed writing operation is possible. The OS memory does not require an erasing operation before data rewriting, which is performed in a flash memory. Furthermore, the OS memory does not perform charge injection and extraction to and from a floating gate or a charge-trap layer, allowing a substantially unlimited number of times of data writing and reading. The OS memory is less likely to degrade than a conventional flash memory and can have high reliability.

Unlike a magnetoresistive memory (MRAM) and a resistance-change memory (ReRAM), the OS memory does not undergo a structure change at the atomic level. Hence, the OS memory has higher rewrite endurance than the magnetoresistive memory and the resistance-change memory.

The off-state current of the OS transistor hardly increases even in a high-temperature environment. Specifically, the off-state current hardly increases even at an environment temperature higher than or equal to room temperature and lower than or equal to 200 °C. In addition, the on-state current is unlikely to decrease even in a high-temperature environment. A memory device including the OS memory can operate stably and have high reliability even in a high-temperature environment. Furthermore, the OS transistor has high withstand voltage between its source and drain. With the use of the OS transistor as a transistor included in a semiconductor device, the semiconductor device can operate stably and have high reliability even in a high-temperature environment.

The semiconductor 127 is preferably an n-type semiconductor. A region of the semiconductor 125 that overlaps with the conductor WWL is preferably an i-type or substantially i-type semiconductor. In that case, the transistor WTr is an enhancement (normally-off) transistor, and the transistor RTr is a depletion (normally-on) transistor.

Note that the semiconductor 125 and the semiconductor 127 may include the same material or different materials. For example, the semiconductor 125 and the semiconductor 127 may each be an oxide semiconductor. The semiconductor 125 and the semiconductor 127 may each be a semiconductor including silicon. The semiconductor 125 may be an oxide semiconductor, and the semiconductor 127 may be a semiconductor including silicon. The semiconductor 125 may be a semiconductor including silicon, and the semiconductor 127 may be an oxide semiconductor.

Note that FIG. 13A corresponds to the X-Y plane of the center of the transistor WTr or the vicinity of the center, and FIG. 13B corresponds to the X-Y plane of the center of the transistor RTr or the vicinity of the center. In the case where the cross-sectional shape of the conductor 130 is a circular shape in FIG. 13A and FIG. 13B, the insulator 129 is concentrically provided outside the conductor 130, the semiconductor 127 is concentrically provided outside the insulator 129, the insulator 126 is concentrically provided outside the semiconductor 127, the semiconductor 125 is concentrically provided outside the insulator 126, and the insulator 124 is concentrically provided outside the semiconductor 125. Furthermore, the conductor 128 is concentrically provided between the semiconductor 125 and the insulator 124.

The cross-sectional shape of the conductor 130 is not limited to a circular shape. The cross-sectional shape of the conductor 130 may be a rectangular shape. Alternatively, the cross-sectional shape of the conductor 130 may be a triangular shape.

Note that the memory string 120 can also be referred to as a memory device, and the memory element MC can also be referred to as a memory device.

### [Constituent materials of memory device]

Next, constituent materials that can be used for the memory device 100 will be described.

### [Substrate]

The memory device 100 can be provided over a substrate. As the substrate, an insulator substrate, a semiconductor substrate, or a conductor substrate is used, for example. Examples of the insulator substrate include a glass substrate, a quartz substrate, a sapphire substrate, a stabilized zirconia substrate (an yttria-stabilized zirconia substrate or the like), and a resin substrate. Examples of the semiconductor substrate include a semiconductor substrate using silicon or germanium as a material and a compound semiconductor substrate containing silicon carbide, silicon germanium, gallium arsenide, indium phosphide, zinc oxide, or gallium oxide. Another example is the above-described semiconductor substrate in which an insulator region is included, e.g., an SOI (Silicon On Insulator) substrate or the like. Examples of the conductor substrate include a graphite substrate, a metal substrate, an alloy substrate, and a conductive resin substrate. Other examples include a substrate including a metal nitride and a substrate including a metal oxide. Other examples include an insulator substrate provided with a conductor or a semiconductor, a semiconductor substrate provided with a conductor or an insulator, and a conductor substrate provided with a semiconductor or an insulator. Alternatively, these substrates provided with elements may be used. Examples of the element provided for the substrate include a capacitor element, a resistor element, a switching element, a light-emitting element, and a memory element.

### [Insulator]

Examples of the insulator include an insulating oxide, an insulating nitride, an insulating oxynitride, an insulating nitride oxide, an insulating metal oxide, an insulating metal oxynitride, and an insulating metal nitride oxide.

Note that in this specification and the like, "oxynitride" refers to a material that contains more oxygen than nitrogen as its main component. For example, "silicon oxynitride" refers to a material that contains silicon, nitrogen, and oxygen and contains more oxygen than nitrogen. In this specification and the like, "nitride oxide" refers to a material that contains more nitrogen than oxygen as its main component. For example, "aluminum nitride oxide" refers to a material that contains aluminum, nitrogen, and oxygen and contains more nitrogen than oxygen.

As miniaturization and high integration of transistors progress, for example, a problem such as a leakage current arises because of a thinner gate insulator, in some cases. When a high-k material is used for the insulator functioning as a gate insulator, the voltage during operation of the transistor can be lowered while the physical thickness of the gate insulator is maintained. In contrast, when a material with a low relative permittivity is used for the insulator functioning as an interlayer film, parasitic capacitance generated between wirings can be reduced. Thus, a material is preferably selected depending on the function of an insulator.

Examples of the insulator with a high relative permittivity include gallium oxide, hafnium oxide, zirconium oxide, an oxide containing aluminum and hafnium, an oxynitride containing aluminum and hafnium, an oxide containing silicon and hafnium, an oxynitride containing silicon and hafnium, and a nitride containing silicon and hafnium.

Examples of the insulator with a low relative permittivity include silicon oxide, silicon oxynitride, silicon nitride oxide, silicon nitride, silicon oxide to which fluorine is added, silicon oxide to which carbon is added, silicon oxide to which carbon and nitrogen are added, porous silicon oxide, and a resin.

When an OS transistor is surrounded by an insulator having a function of inhibiting passage of oxygen and impurities such as hydrogen, the transistor can have stable electrical characteristics. As the insulator having a function of inhibiting passage of oxygen and impurities such as hydrogen, a single layer or stacked layers of an insulator containing, for example, boron, carbon, nitrogen, oxygen, fluorine, magnesium, aluminum, silicon, phosphorus, chlorine, argon, gallium, germanium, yttrium, zirconium, lanthanum, neodymium, hafnium, or tantalum are used. Specifically, as the insulator having a function of inhibiting passage of oxygen and impurities such as hydrogen, a metal oxide such as aluminum oxide, magnesium oxide, gallium oxide, germanium oxide, yttrium oxide, zirconium oxide, lanthanum oxide, neodymium oxide, hafnium oxide, or tantalum oxide; or a metal nitride such as aluminum nitride, silicon nitride oxide, or silicon nitride can be used.

In the case where an oxide semiconductor is used as the semiconductor 125 and/or the semiconductor 127, the insulator functioning as a gate insulator is preferably an insulator including a region containing oxygen that is released by heating. For example, when a structure is employed in which silicon oxide or silicon oxynitride including a region containing oxygen that is released by heating is in contact with the semiconductor 125 and/or the semiconductor 127, oxygen vacancies included in the semiconductor 125 and/or the semiconductor 127 can be compensated for.

The insulator 181 is preferably provided in order to inhibit oxidation of the conductor WWL (a conductor 182 described later) and the conductor SEL (a conductor 183 described later). The materials given above that have a barrier property against oxygen and/or hydrogen are preferably used for the insulator 181. The insulator 181 is preferably provided in contact with the bottom surfaces, the top surfaces, and side surfaces of the conductor WWL and the conductor SEL.

### [Conductor]

As a conductor, it is preferable to use a metal element selected from aluminum, chromium, copper, silver, gold, platinum, tantalum, nickel, titanium, molybdenum, tungsten, hafnium, vanadium, niobium, manganese, magnesium, zirconium, beryllium, indium, ruthenium, iridium, strontium, lanthanum, and the like; an alloy containing any of the above metal elements; an alloy containing a combination of the above metal elements; or the like. For example, it is preferable to use tantalum nitride, titanium nitride, tungsten, a nitride containing titanium and aluminum, a nitride containing tantalum and aluminum, ruthenium oxide, ruthenium nitride, an oxide containing strontium and ruthenium, an oxide containing lanthanum and nickel, or the like. In addition, tantalum nitride, titanium nitride, a nitride containing titanium and aluminum, a nitride containing tantalum and aluminum, ruthenium oxide, ruthenium nitride, an oxide containing strontium and ruthenium, and an oxide containing lanthanum and nickel are preferable because they are oxidation-resistant conductive materials or materials that retain their conductivity even after absorbing oxygen. Alternatively, a semiconductor having high electrical conductivity, typified by polycrystalline silicon containing an impurity element such as phosphorus, or silicide such as nickel silicide may be used.

A stack of a plurality of conductive layers formed of the above materials may be used. For example, a stacked-layer structure combining a material containing the above metal element and a conductive material containing oxygen may be employed. Alternatively, a stacked-layer structure combining a material containing the above metal element and a conductive material containing nitrogen may be employed. Alternatively, a stacked-layer structure combining a material containing the above metal element, a conductive material containing oxygen, and a conductive material containing nitrogen may be employed.

In the case where an oxide semiconductor, which is a type of metal oxide, is used for the channel formation region of the transistor, the conductor functioning as the gate electrode preferably employs a stacked-layer structure combining a material containing the above metal element and a conductive material containing oxygen. In this case, the conductive material containing oxygen is preferably provided on the channel formation region side. When the conductive material containing oxygen is provided on the channel formation region side, oxygen released from the conductive material is easily supplied to the channel formation region.

For the conductor functioning as the gate electrode, it is particularly preferable to use a conductive material containing oxygen and a metal element contained in the oxide semiconductor where the channel is formed. Alternatively, a conductive material containing the above metal element and nitrogen may be used. For example, a conductive material containing nitrogen, such as titanium nitride or tantalum nitride, may be used. Indium tin oxide, indium oxide containing tungsten oxide, indium zinc oxide containing tungsten oxide, indium oxide containing titanium oxide, indium tin oxide containing titanium oxide, indium zinc oxide, or indium tin oxide to which silicon is added may be used. Indium gallium zinc oxide containing nitrogen may be used. With the use of such a material, hydrogen contained in the oxide semiconductor where the channel is formed can be captured in some cases. Alternatively, hydrogen entering from an external insulator or the like can be captured in some cases.

### [Oxide semiconductor]

For the semiconductor 125 and the semiconductor 127, a metal oxide functioning as a semiconductor (an oxide semiconductor) is preferably used. An oxide semiconductor that can be used for the semiconductor 125 and the semiconductor 127 is described below.

The oxide semiconductor preferably contains at least indium or zinc. In particular, indium and zinc are preferably contained. Furthermore, aluminum, gallium, yttrium, tin, or the like is preferably contained in addition to them. Furthermore, one kind or a plurality of kinds selected from boron, titanium, iron, nickel, germanium, zirconium, molybdenum, lanthanum, cerium, neodymium, hafnium, tantalum, tungsten, magnesium, cobalt, and the like may be contained.

Here, the case where the oxide semiconductor is an In-*M*-Zn oxide containing indium, the element *M*, and zinc is considered. The element *M* is one or more selected from aluminum, gallium, yttrium, and tin. Examples of other elements that can be used as the element *M* include boron, titanium, iron, nickel, germanium, zirconium, molybdenum, lanthanum, cerium, neodymium, hafnium, tantalum, tungsten, magnesium, and cobalt. Note that two or more of the above-described elements may be used in combination as the element *M*.

Note that in this specification and the like, a metal oxide containing nitrogen is also referred to as a metal oxide in some cases. A metal oxide containing nitrogen may be referred to as a metal oxynitride.

### <Example of method for manufacturing memory device>

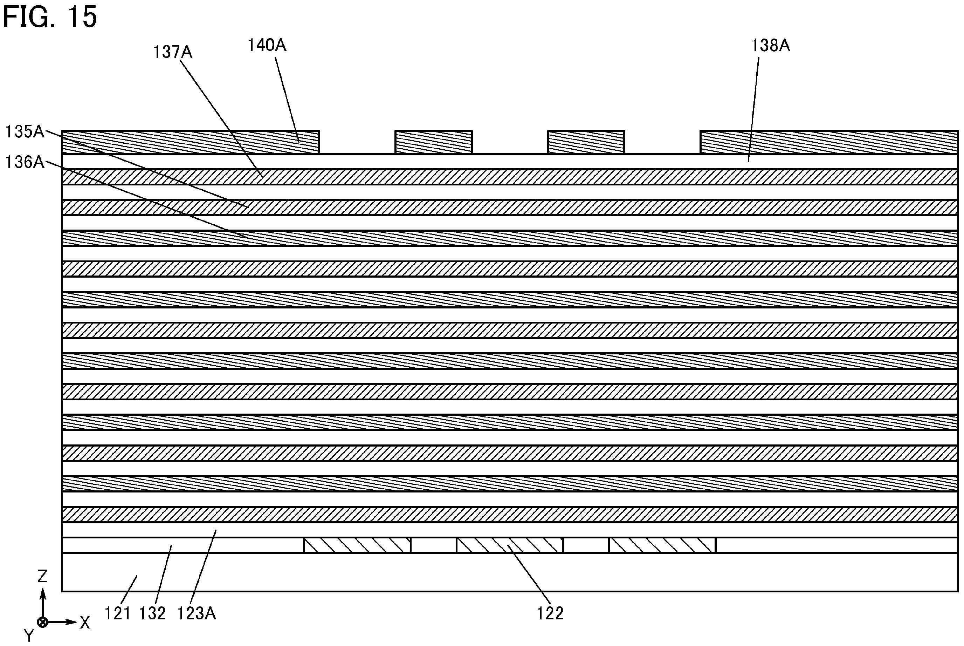

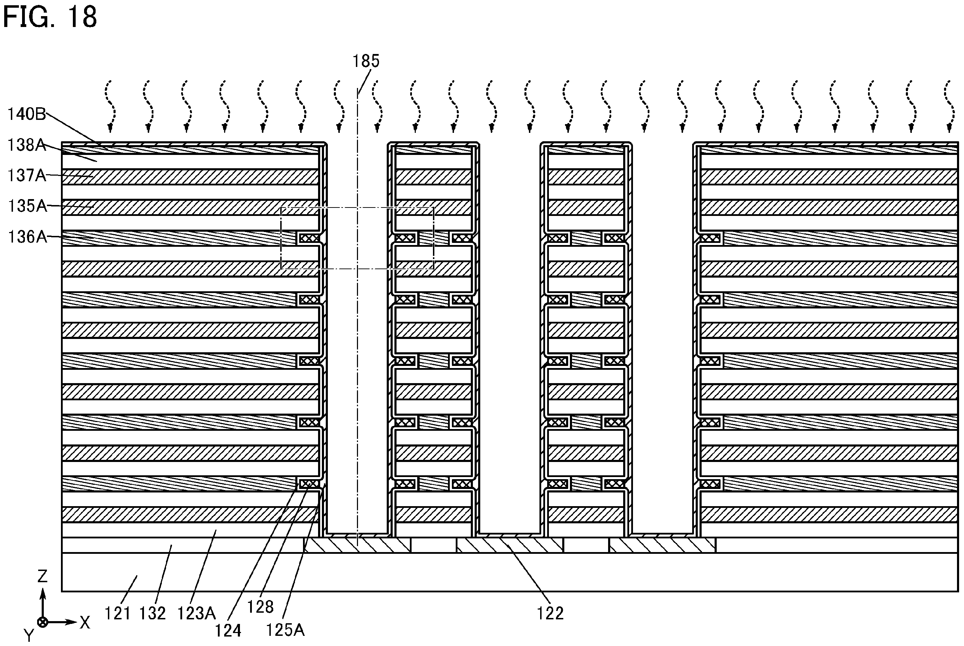

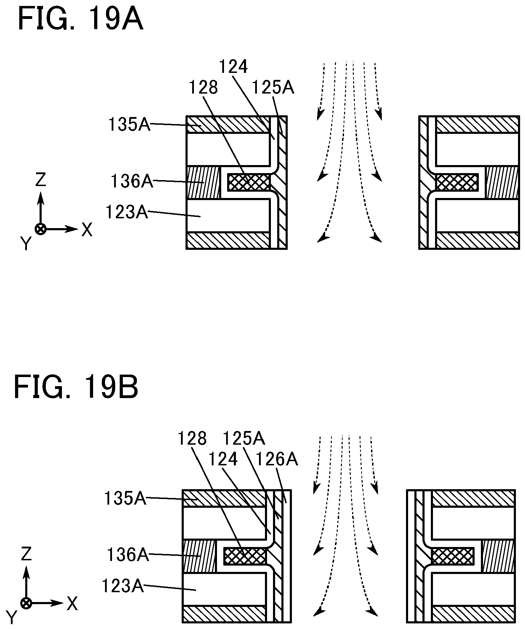

Next, an example of a method for manufacturing a memory device of the present invention will be described with reference to FIG. 15 to FIG. 26. Note that FIG. 15 to FIG. 26 each show a cross section along the X-Z plane and are cross-sectional views seen from the Y direction. FIG. 19A is an enlarged cross-sectional view of a portion surrounded by a dashed-dotted line in FIG. 18. Although three memory strings 120 including five (five stages of) memory elements MC are manufactured as an example in this manufacturing method, this embodiment is not limited to the example. The memory string 120 may include two or more stages of memory elements MC. For example, the memory string 120 may include four stages of memory elements MC. The memory string 120 may include 32 or more, preferably 64 or more, further preferably 128 or more, still further preferably 256 or more stages of memory elements MC. One embodiment of this embodiment enables two or more memory strings 120 to be manufactured at a time.

First, the conductor 122 is formed over the substrate 121 having an insulating surface, and an insulator 132 is formed around the conductor 122 (see FIG. 15).

Specifically, a conductive film is formed and processed by a lithography method, whereby the conductor 122 is formed. Then, an insulating film is formed over the substrate 121 so as to cover the conductor 122. Next, the insulating film is preferably subjected to planarization treatment. In the planarization treatment, the insulating film is preferably polished until a surface of the conductor 122 is exposed. By the above-described method, the insulator 132 can be formed. Note that the method for forming the conductor 122 and the insulator 132 is not limited to this method. The insulator 132 may be formed over the substrate 121 and an unnecessary portion of the insulator 132 may be removed to form a groove or an opening, and the conductor 122 may be embedded in the groove or the opening portion. Such a formation method of the conductor is referred to as a damascene method (a single damascene method or a dual damascene method) in some cases. By the above-described method, the structure illustrated in FIG. 15 can be obtained.

The conductor 122 and the insulator 132 can be formed by a sputtering method, a CVD method, a molecular beam epitaxy (MBE) method, a pulsed laser deposition (PLD) method, an ALD method, or the like.

Note that in a lithography method, first, a resist is exposed to light through a photomask. Next, a region exposed to light is removed or left using a developer, so that a resist mask is formed. Then, etching treatment through the resist mask is conducted, whereby a conductor, a semiconductor, an insulator, or the like can be processed into a desired shape. The resist mask is formed through, for example, exposure of the resist to KrF excimer laser light, ArF excimer laser light, extreme ultraviolet (EUV) light, or the like. Alternatively, a liquid immersion technique may be employed, in which a gap between a substrate and a projection lens is filled with liquid (e.g., water) in light exposure. An electron beam or an ion beam may be used instead of the above-described light. Note that a photomask is not necessary in the case of using an electron beam or an ion beam. Note that the resist mask can be removed by dry etching treatment such as ashing, wet etching treatment, wet etching treatment after dry etching treatment, or dry etching treatment after wet etching treatment.

In addition, a hard mask formed of an insulator or a conductor may be used instead of the resist mask. In the case where a hard mask is used, a hard mask with a desired shape can be formed by forming an insulating film or a conductive film to be the hard mask material over the conductive film, forming a resist mask thereover, and then etching the hard mask material.

A dry etching method or a wet etching method can be employed for the processing. Processing by a dry etching method is suitable for microfabrication.

As a dry etching apparatus, a capacitively coupled plasma (CCP) etching apparatus including parallel plate electrodes can be used. The capacitively coupled plasma etching apparatus including the parallel plate electrodes may have a structure in which a high-frequency power is applied to one of the parallel plate electrodes. Alternatively, a structure may be employed in which different high-frequency powers are applied to one of the parallel plate electrodes. Alternatively, a structure may be employed in which high-frequency powers with the same frequency are applied to the parallel plate electrodes. Alternatively, a structure may be employed in which high-frequency powers with different frequencies are applied to the parallel plate electrodes. Alternatively, a dry etching apparatus including a high-density plasma source can be used. As the dry etching apparatus including a high-density plasma source, ICP etching apparatus or the like can be used, for example.

In the case where a hard mask is used for etching of the conductive film, the etching treatment may be performed after the resist mask used for the formation of the hard mask is removed or with the resist mask left. In the latter case, the resist mask sometimes disappears during the etching. The hard mask may be removed by etching after the etching of the conductive film. Meanwhile, the hard mask is not necessarily removed when the hard mask material does not affect subsequent steps or can be utilized in subsequent steps.

As a conductive film to be the conductor 122, a conductive film containing a metal element is preferably formed by a sputtering method. The conductive film can also be formed by a CVD method.

A surface of the insulator 132 is preferably subjected to planarization treatment as needed. As the planarization treatment, a chemical mechanical polishing (CMP) method or a reflow method can be employed.

Insulating films 123A and insulating films 135A or conductive films 136A are alternately stacked over the conductor 122 and the insulator 132. In this embodiment, an example where the insulating films 123A are formed over the conductor 122 and the insulator 132, the insulating film 135A is formed over the insulating film 123A, the insulating film 123A is formed over the insulating film 135A, and the conductive film 136A is formed over the insulating film 123A is described (see FIG. 15). A CVD method can be employed to form the insulating films 135A, the conductive films 136A, and the insulating films 123A. Alternatively, a sputtering method may be employed.

For the conductor 122 and the conductive films 136A, a conductive material such as silicon to which an impurity is added or a metal can be used. A material that can be selectively etched against the conductor 122 and the insulating films 135A is preferably used for the conductive films 136A because the conductive films 136A need to be selectively etched against the conductor 122 and the conductive films 135A in a later step. In the case where silicon is used for the conductor 122 or the conductive films 136A, amorphous silicon or polysilicon can be used. A p-type impurity or an n-type impurity may be added to give a conducting property to silicon. Silicide containing titanium, cobalt, or nickel, which is a conductive material containing silicon, can be used for the conductor 122 or the conductive films 136A. In the case where a metal material is used for the conductor 122 or the conductive films 136A, a material containing one or more kinds of metal elements selected from aluminum, chromium, copper, silver, gold, platinum, tantalum, nickel, titanium, molybdenum, tungsten, hafnium, vanadium, niobium, manganese, magnesium, zirconium, beryllium, indium, ruthenium, and the like can be used.

An insulating oxide, an insulating nitride, an insulating oxynitride, an insulating nitride oxide, an insulating metal oxide, an insulating metal oxynitride, an insulating metal nitride oxide, or the like can be used for the insulator 132, the insulating films 135A, and the insulating films 123A. It is possible to use silicon oxide, silicon oxynitride, silicon nitride oxide, silicon nitride, silicon oxide to which fluorine is added, silicon oxide to which carbon is added, silicon oxide to which carbon and nitrogen are added, porous silicon oxide or resin, aluminum oxide, gallium oxide, hafnium oxide, zirconium oxide, an oxide containing aluminum and hafnium, an oxynitride containing aluminum and hafnium, an oxide containing silicon and hafnium, an oxynitride containing silicon and hafnium, a nitride containing silicon and hafnium, or the like.

A material that can be selectively etched against the insulator 132 and the insulating films 123A is preferably used for the insulating films 135A because the insulating films 135A need to be selectively etched against the insulator 132 and the insulating films 123A in a later step. For example, silicon oxide or silicon oxynitride is preferably used as the insulator 132 and the insulating films 123A, and silicon nitride or silicon nitride oxide is preferably used as the insulating films 135A.

Although an example where twelve insulating films 123A, six insulating films 135A, and five conductive films 136A are formed is described in this embodiment, the number of stacked layers is not limited thereto. Each of the films can be formed in accordance with the required performance of the semiconductor device. Assuming that the number of stacked insulating films 135A is *m* (*m* is an integer greater than or equal to 2), the number of stacked insulating films 123A is 2 × *m* and the number of stacked conductive films 136A is *m* - 1. For example, *m* can be greater than or equal to 33, preferably greater than or equal to 65, further preferably greater than or equal to 129, still further preferably greater than or equal to 257.

An insulating film 137A is formed over the uppermost insulating film 123A, and an insulating film 138A is formed over the insulating film 137A. The insulating film 137A can be formed using a method and a material similar to those of the insulating films 135A. Furthermore, the insulating film 138A can be formed using a method and a material similar to those of the insulating films 123A. A mask 140A is formed over the insulating film 138A.

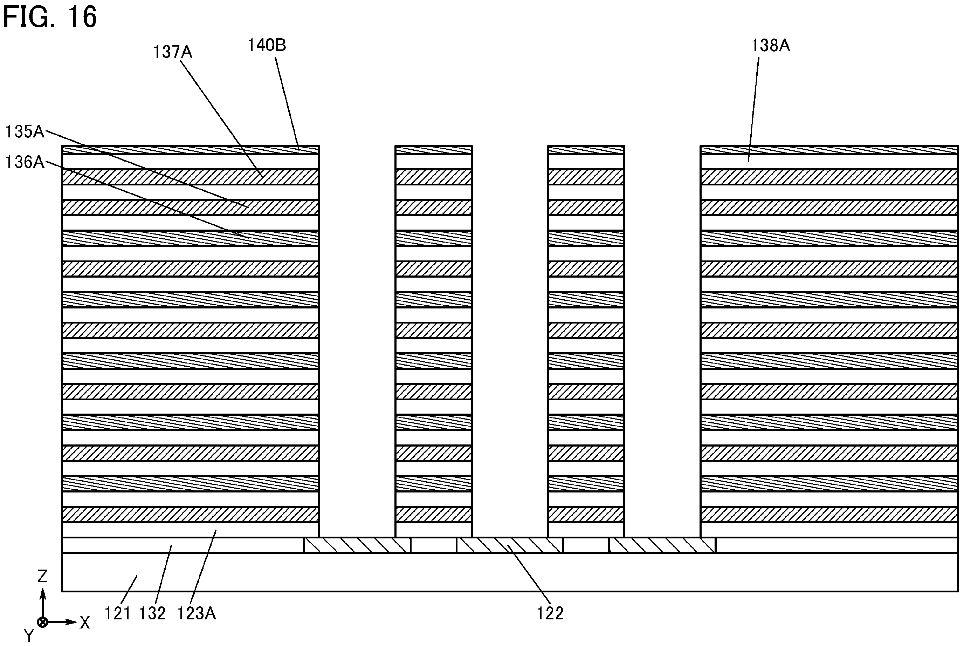

Next, the insulating film 138A, the insulating film 137A, the insulating films 123A, the insulating films 135A, and the conductive films 136A are processed using the mask 140A to form first openings exposing the conductor 122 (see FIG. 16). The mask 140A is etched by the processing to become a mask 140B in some cases.

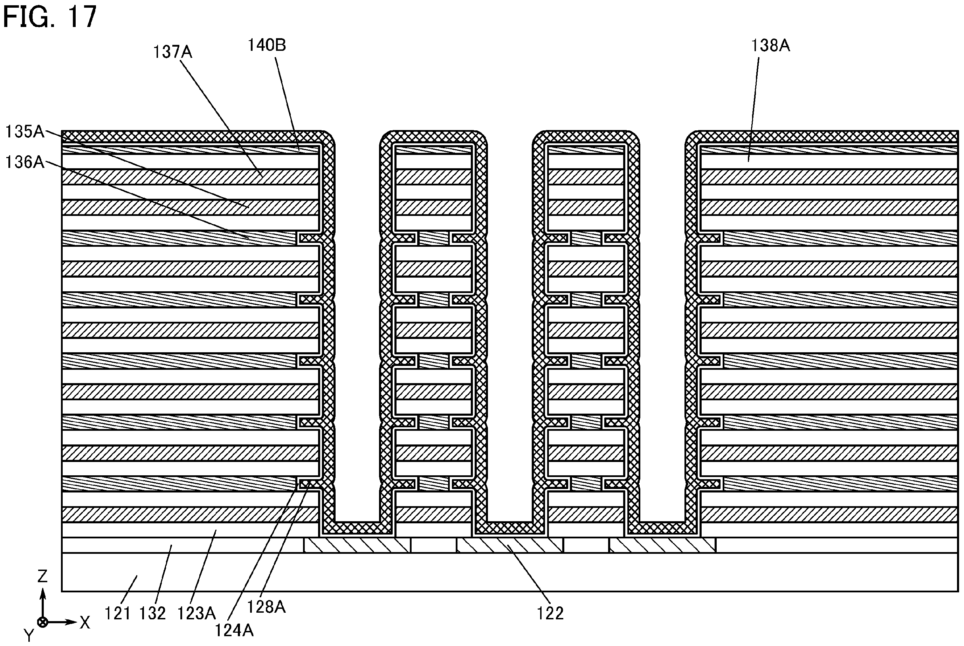

Next, isotropic etching is performed on the conductive films 136A to increase the diameters of openings of the conductive films 136A (see FIG. 17). By this treatment, the diameter of each of the openings of the conductive films 136A becomes larger than the diameters of the openings of the insulating film 138A, the insulating film 137A, the insulating films 123A, and the insulating films 135A. The conductive film 136A can be regarded as being depressed against a side surface of the insulating film 138A, the insulating film 137A, the insulating film 123A, or the insulating film 135A positioned over or under the conductive film 136A. As such processing, isotropic etching using dry etching with a gas, a radical, plasma, or the like, or isotropic etching using wet etching with a liquid can be used. A liquid used in wet etching may be referred to as an etchant. In the case where isotropic etching is performed using dry etching, a gas, a radical, plasma, or the like containing at least one of chlorine, bromine, and fluorine can be used. Isotropic etching is preferably performed without removal of the mask used for the formation of the first openings. The first opening obtained by the above treatment corresponds to the opening 141 illustrated in FIG. 12.

Next, an insulating film 124A and a conductive film 128A are formed over the insulating film 138A and the mask 140B and in the first openings (see FIG. 17). Although not illustrated, the insulating film 124A may have a stacked-layer structure. The insulating film 124A can be formed by a CVD method or an ALD method. It is particularly preferable to employ an ALD method, in which case a film with a uniform thickness can be formed even in a groove or an opening portion having a high aspect ratio. Alternatively, the insulating film 124A may be formed by a combination of an ALD method and a CVD method. In the case where the insulating film 124A has a stacked-layer structure, insulating films may be formed in the same deposition apparatus or different deposition apparatuses.

The insulating film 124A formed by the above-described method has high coverage and can also be formed in the depressed portions of the conductive films 136A. In other words, the insulating film 124A can be formed in contact with not only side surfaces of the insulating films 123A, the insulating films 135A, and the conductive films 136A but also part of the top surface and part of the bottom surfaces of the insulating films 123A.

The conductive film 128A is at least formed to fill the depressed portions of the conductive films 136A with the insulating film 124A positioned between the conductive film 128A and the conductive films 136A, and need not entirely fill the inside of the first openings. The conductive film 128A can be formed by a CVD method or an ALD method. It is particularly preferable to employ an ALD method, in which case a film with a uniform thickness can be formed even in a groove or an opening portion having a high aspect ratio. Alternatively, the conductive film 128A may be formed by a combination of an ALD method and a CVD method.

Next, the conductive film 128A is processed to form the conductors 128 (see FIG. 18). For the processing of the conductive film 128A, isotropic etching or anisotropic etching can be used. In the case where the formed conductive film 128A fills the depressed portions and does not completely fill the first openings as illustrated in FIG. 17, isotropic etching is preferably used for the processing of the conductive film 128A. By contrast, in the case where the conductive film 128A is formed to fill the depressed portions and the first openings, anisotropic etching is preferably used. By the above-described processing, the conductors 128 can be formed inside the depressed portions.

Then, the insulating film 124A formed in bottom portions of the first openings is removed to form the insulators 124. Anisotropic etching is preferably used to remove the insulating film 124A. At this time, the insulating film 124A over the insulating film 138A and the mask 140B are also removed; thus, the insulators 124 are provided only on the sidewalls of the first openings (see FIG. 18). The conductor 122 is exposed again by removal of the insulating film 124A in the bottom portions of the first openings.

Then, a semiconductor film 125A is formed in the first openings so as to be in contact with the conductor 122 (see FIG. 18). The semiconductor film 125A can be formed by a CVD method or an ALD method. It is particularly preferable to employ an ALD method, in which case a film with a uniform thickness can be formed even in a groove or an opening portion having a high aspect ratio. Alternatively, the semiconductor film 125A may be formed by a combination of an ALD method and a CVD method.

Here, in the case where a metal oxide is formed as the semiconductor film 125A by an ALD method, an In-Ga-Zn oxide is preferably formed using a precursor containing indium, a precursor containing gallium, and a precursor containing zinc. At this time, the precursors described in the above embodiment can be used as the precursor containing indium, the precursor containing gallium, and the precursor containing zinc.

Note that the semiconductor film 125A is preferably an oxide semiconductor having a CAAC structure. Thus, microwave treatment is preferably performed in an oxygen-containing atmosphere after the semiconductor film 125A is formed. Dotted lines shown in FIG. 18 and FIG. 19A indicate high-frequency oxygen plasma such as a microwave or RF, oxygen radicals, or the like. In the microwave treatment, for example, application of RF to the substrate side allows oxygen ions generated by the high-density plasma to be efficiently introduced into the metal oxide.

In the case where a metal oxide is formed by an ALD method, elements other than elements constituting the metal oxide is mixed into the metal oxide in some cases. Elements other than the elements constituting the metal oxide are elements included in the precursor. Examples of the elements included in the precursor include carbon, hydrogen, nitrogen, chlorine, or the like. These elements serve as impurities for the metal oxide. The metal oxide containing a large amount of impurities tends to have low crystallinity and has reduced resistance in some cases.

As described in the above embodiment, the impurity concentration and the amount of defects in the metal oxide can be reduced by performing microwave treatment in an oxygen-containing atmosphere. Furthermore, the rearrangement of the metal atoms and the oxygen atoms in the metal oxide can be promoted. Thus, the crystallinity of the metal oxide is improved, so that a metal oxide having a CAAC structure can be formed.

In the case where the semiconductor film 125A is an oxide semiconductor having a CAAC structure, c-axes of the semiconductor film 125A are aligned in the direction normal to a surface on which the semiconductor film 125A is formed, in the first opening. In this case, c-axes of the semiconductor film 125A positioned on the side surfaces of the insulating film 138A, the insulating film 137A, the insulating films 123A, the insulating films 135A, and the conductive films 136A with the insulators 124 therebetween are aligned toward an axis 185 indicated by a dashed-dotted line in FIG. 18 from the surface on which the semiconductor film 125A is formed. Note that the axis 185 can be referred to as a central axis of the first opening. Thus, the c-axes of the semiconductors 125 positioned as described above are aligned toward the axis 185 from the surface on which the semiconductors 125 are formed.

By performing the microwave treatment, the resistance of part of the semiconductor film 125A is increased, so that a high-resistance region (i-type region) can be formed. Note that the resistance value of a region of the semiconductor film 125A that is in contact with the conductors 128 remains low in some cases.

Next, heat treatment may be performed. The heat treatment is performed in an atmosphere containing nitrogen at higher than or equal to 200 °C and lower than or equal to 500 °C, preferably higher than or equal to 300 °C and lower than or equal to 400 °C. The atmosphere in which the heat treatment is performed is not limited to the above atmosphere as long as at least one of nitrogen, oxygen, and argon is contained. The heat treatment may be performed under a reduced pressure or under an atmospheric pressure.

The resistance of the semiconductor film 125A in contact with the conductors 128 can be decreased by the heat treatment, so that a low-resistance region (N-type region) can be formed. The heat treatment performed in the state where the semiconductor film 125A and the conductors 128 are in contact with each other sometimes forms a metal compound layer containing a metal element contained in the conductors 128 and a component of the semiconductor film 125A at interfaces between the conductors 128 and the semiconductor film 125A. The metal compound layer is preferably formed, in which case the resistance of the semiconductor film 125A in the region in contact with the conductors 128 is reduced. In addition, oxygen contained in the semiconductor film 125A is absorbed by the conductors 128 in some cases. The heat treatment performed in the state where the semiconductor film 125A and the conductors 128 are in contact with each other further reduces the resistance of the semiconductor film 125A. In addition, the crystallinity of the semiconductor film 125A is improved by the heat treatment in some cases. The heat treatment may also be performed before the microwave treatment.

The carrier concentration of the semiconductor film 125A after the above-described microwave treatment and/or the heat treatment is lower than 1 × 10¹⁸ /cm³, preferably lower than or equal to 1 × 10¹⁷ /cm³, further preferably lower than or equal to 1 × 10¹⁶ /cm³. The carrier concentration of the region of the semiconductor film 125A that is in contact with the conductors 128 is higher than or equal to 1 × 10¹⁸ /cm³, preferably higher than or equal to 1 × 10¹⁹ /cm³, further preferably higher than or equal to 1 × 10²⁰ /cm³.

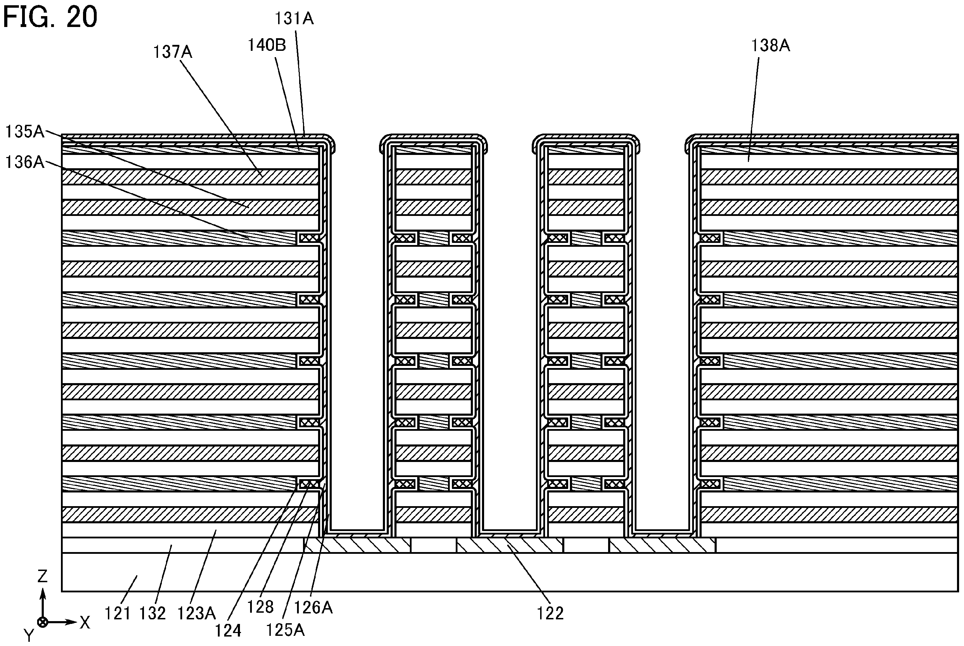

Next, an insulating film 126A is formed more inward than the semiconductor film 125A (see FIG. 20).

The insulating film 126A can be formed by a CVD method or an ALD method. It is particularly preferable to employ an ALD method, in which case a film with a uniform thickness can be formed even in a groove or an opening portion having a high aspect ratio. Alternatively, the insulating film 126A may be formed by a combination of an ALD method and a CVD method.

Here, microwave treatment may be performed as illustrated in FIG. 19B. Furthermore, heat treatment may be performed before the microwave treatment or after the microwave treatment. Note that the microwave treatment and/or the heat treatment performed after the insulating film 126A is formed may be performed under the above conditions.

Next, an insulator 131A is formed on the top surface of the insulating film 126A. The insulator 131A is preferably formed selectively so as not to be formed in the first openings. Alternatively, the insulator 131A may be formed on the top surface of the insulating film 126A and in the first openings, a mask may be formed over the top surface of the insulating film 126A with the insulator 131A therebetween, and the insulator 131A in the first openings may be removed selectively. As the insulator 131A, silicon nitride is preferably used. A PECVD method is preferably used to selectively form the insulator 131A on the top surface of the insulating film 126A. A mixed gas containing SiH₄ and N₂ is preferably used as a deposition gas, in which case the insulator 131A is inhibited from being formed in the first openings. When NH₃ is contained in the mixed gas, the insulator 131A is easily formed in the first openings; for this reason, it is preferable that NH₃ not be contained in the mixed gas. In the case where N₂ and NH₃ are contained in the mixed gas, the mixing rate of NH₃ is lower than or equal to 10 %, preferably lower than or equal to 5 %, further preferably lower than or equal to 1 % of the mixing rate of N₂. When the ratio (flow rate ratio) of N₂ to SiH₄ in the mixed gas is low, the amount of nitrogen contained in the insulator 131A is decreased, resulting in formation of amorphous silicon in some cases. For this reason, the ratio (flow rate ratio) of N₂ to SiH₄ is preferably greater than or equal to 100.

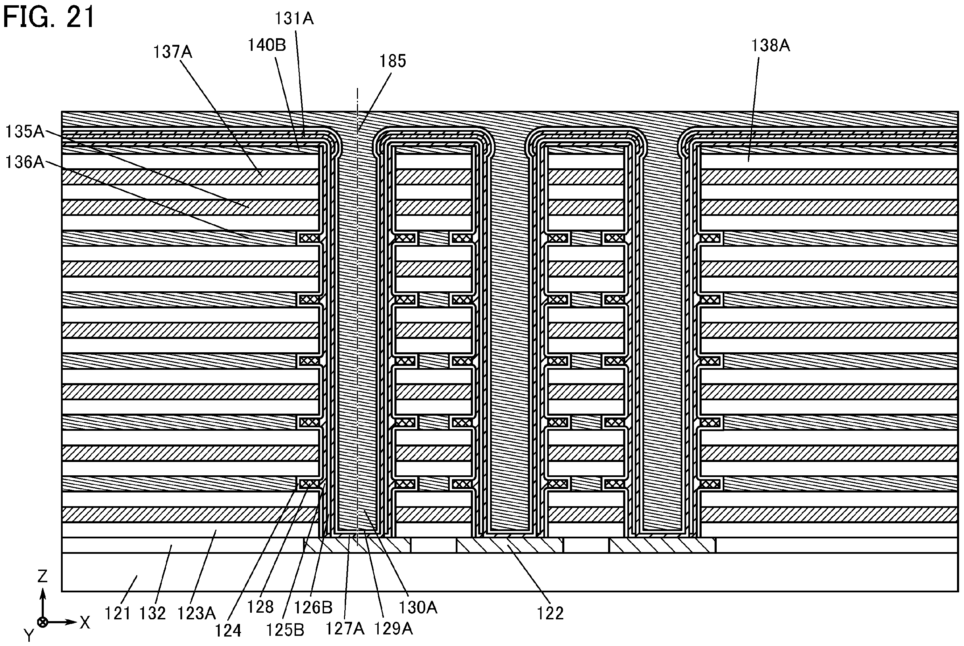

Next, the semiconductor film 125A and the insulating film 126A that are formed in the bottom portions of the first openings are removed to form a semiconductor 125B and an insulator 126B. The semiconductor film 125A and the insulating film 126A are preferably removed by anisotropic etching using the insulator 131A as a mask. In that case, the semiconductor film 125A and the insulating film 126A over the insulating film 138A and the mask 140B are not removed because they are covered with the insulator 131A (see FIG. 21). The conductor 122 is exposed again by the removal of the semiconductor film 125A and the insulating film 126A in the bottom portions of the first openings.

Then, a semiconductor film 127A is formed in the first openings so as to be in contact with the conductor 122 (see FIG. 21). At this time, the semiconductor film 127A is preferably formed so as to be in contact with the semiconductor 125B in the bottom portions of the first openings. The semiconductor film 127A can be formed by a CVD method or an ALD method. It is particularly preferable to employ an ALD method, in which case a film with a uniform thickness can be formed even in a groove or an opening portion having a high aspect ratio. Alternatively, the semiconductor film 127A may be formed by a combination of an ALD method and a CVD method.

Here, in the case where a metal oxide is formed as the semiconductor film 127A by an ALD method, an In-Ga-Zn oxide is preferably formed using a precursor containing indium, a precursor containing gallium, and a precursor containing zinc. At this time, the semiconductor film 127A can be formed by using a precursor that can be used for forming the semiconductor film 125A.

Note that the semiconductor film 127A is preferably an oxide semiconductor having a CAAC structure. Thus, microwave treatment is preferably performed in an oxygen-containing atmosphere after the semiconductor film 127A is formed. Note that the microwave treatment may be performed under the above-described conditions.

As described in the above embodiment, the impurity concentration and the amount of defects in the metal oxide can be reduced by performing microwave treatment in an oxygen-containing atmosphere. Furthermore, the rearrangement of the metal atoms and the oxygen atoms in the metal oxide can be promoted. Thus, the crystallinity of the metal oxide is improved, so that a metal oxide having a CAAC structure can be formed.

In the case where the semiconductor film 127A is an oxide semiconductor having a CAAC structure, c-axes of the semiconductor film 127A are aligned in the direction normal to a surface on which the semiconductor film 127A is formed, in the first opening. In this case, c-axes of the semiconductor film 127A positioned on the side surfaces of the first openings are aligned toward the axis 185 illustrated in FIG. 21 from the surface on which the semiconductor film 127A is formed. Thus, the c-axes of the semiconductors 127 positioned as described above are aligned toward the axis 185 from the surface on which the semiconductors 127 are formed.

Note that in the case where the crystallinity of the semiconductor film 125A can be improved by performing microwave treatment on the semiconductor film 127A, microwave treatment in the aforementioned step may be omitted.

Next, an insulating film 129A is formed more inward than the semiconductor film 127A and a conductive film 130A is formed more inward than the insulating film 129A (see FIG. 21). The insulating film 129A and the conductive film 130A can be formed by a CVD method or an ALD method. It is preferable to employ a CVD method or an ALD method, in which case a film with a uniform thickness can be formed even in a groove or an opening portion having a high aspect ratio. Alternatively, the films may be formed by a combination of an ALD method and a CVD method. Alternatively, the films may be formed using different deposition methods or different deposition apparatuses.

Next, heat treatment is performed. The heat treatment is preferably performed in an atmosphere containing nitrogen at higher than or equal to 200 °C and lower than or equal to 500 °C, preferably higher than or equal to 300 °C and lower than or equal to 400 °C. The atmosphere in which the heat treatment is performed is not limited to the above atmosphere as long as at least one of nitrogen, oxygen, and argon is contained. The heat treatment may be performed under a reduced pressure or under an atmospheric pressure. In addition, the crystallinity of the semiconductor film 127A is improved by heat treatment in some cases.

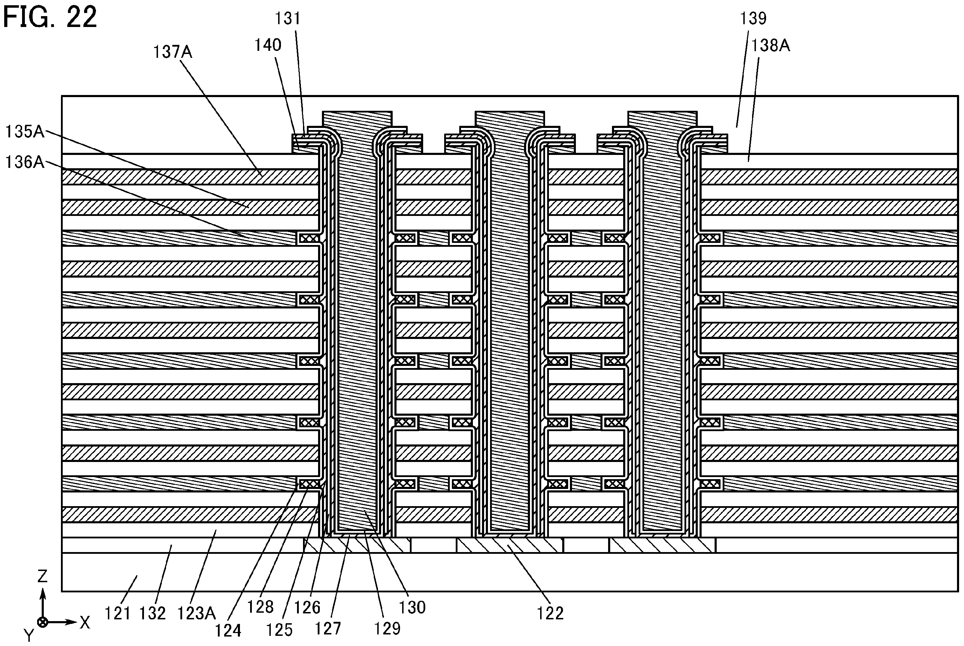

Next, the conductive film 130A, the insulating film 129A, the semiconductor film 127A, the insulator 131A, the insulator 126B, the semiconductor 125B, and the mask 140B are processed to form conductors 130, insulators 129, semiconductors 127, insulators 131, insulators 126, semiconductors 125, and masks 140 (see FIG. 22). For the processing, a dry etching method or a wet etching method can be employed. Processing by a dry etching method is suitable for microfabrication. The processing may be performed in the following order: the conductive film 130A is processed, the insulating film 129A and the semiconductor film 127A are processed, and then the insulator 131A, the insulator 126B, the semiconductor 125B, and the mask 140B are processed. In such a processing process, different masks may be formed for processing steps. Alternatively, the conductive film 130A, the insulating film 129A, the semiconductor film 127A, the insulator 131A, the insulator 126B, the semiconductor 125B, and the mask 140B may be processed using a mask for first processing; the conductive film 130A, the insulating film 129A, and the semiconductor film 127A may be processed again for second processing; and then the conductive film 130A may be processed again for third processing. In the second processing and the third processing, a mask obtained by processing the mask used in the first processing or a mask different from that used in the first processing may be formed.

Next, an insulator 139 is formed over the insulating film 138A so as to cover the conductors 130, the insulators 129, the semiconductors 127, the insulators 131, the insulators 126, the semiconductors 125, and the masks 140. The insulator 139 can be formed using a method and a material that can be used to form the insulator 132.

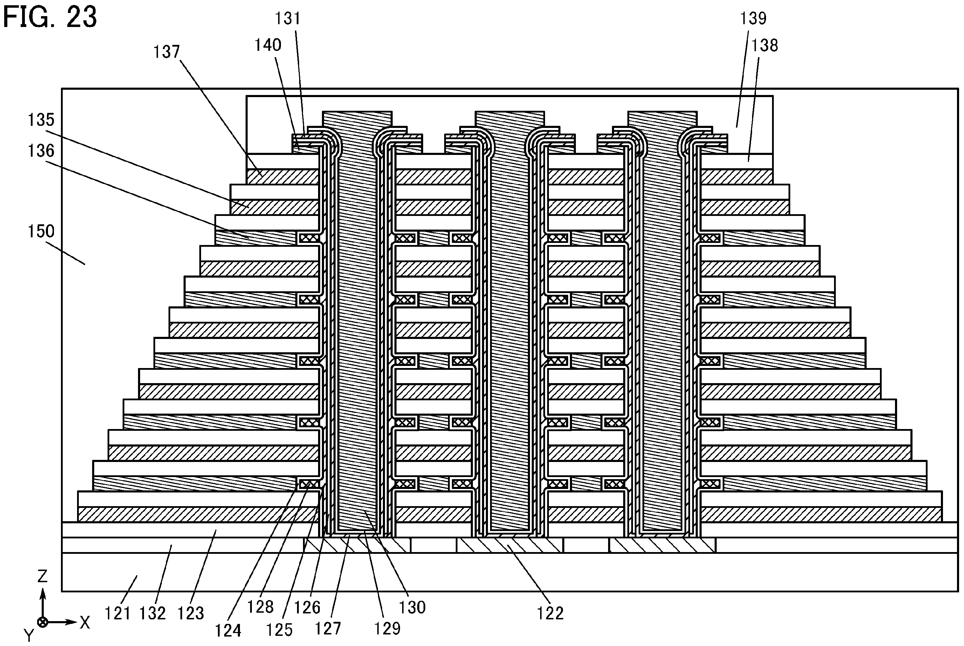

Then, the insulator 139, the insulating film 138A, the insulating film 137A, the insulating films 123A, the insulating films 135A, and the conductive films 136A are processed to form the insulator 139, an insulator 138, an insulator 137, insulators 123, insulators 135, and conductors 136 that have a step-like shape as illustrated in FIG. 23. In the processing of the insulator 139, the insulating film 138A, the insulating film 137A, the insulating films 123A, the insulating films 135A, and the conductive films 136A, etching of the insulator 139, the insulating film 138A, the insulating film 137A, the insulating films 123A, the insulating films 135A, and the conductive films 136A and slimming of a mask are alternately performed, whereby the insulator 139, the insulator 138, the insulator 137, the insulators 123, the insulators 135, and the conductors 136 that have a step-like shape can be formed.

Next, an insulator 150 is formed (see FIG. 23). The insulator 150 can be formed by a CVD method. The insulator 150 is preferably subjected to planarization treatment by a CMP method or a reflow method.

Next, in order to separate the memory strings 120 arranged in the Y direction, the insulator 150, the insulator 139, the insulator 138, the insulator 137, the insulators 123, the insulators 135, and the conductors 136 are processed to form slits. Note that the slits are not illustrated in FIG. 23 because they are formed in the Y direction of the cross section illustrated in FIG. 23. In addition, the slits are formed so as to extend in the X direction. Furthermore, each of the slits is preferably formed between the memory strings 120 arranged in the Y direction.

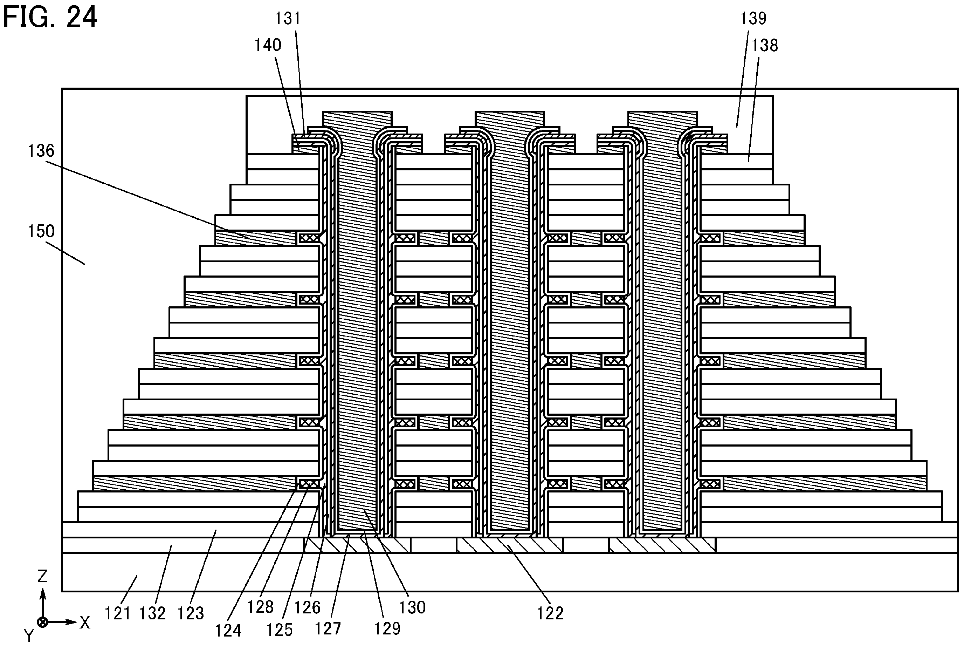

Next, the insulator 137 and the insulators 135 are removed (see FIG. 24). Wet etching or dry etching can be used to remove the insulator 137 and the insulators 135. An etchant used for wet etching or a gas used for dry etching is introduced from the slits, and the insulator 137 and the insulators 135 are removed by isotropic etching. At least one of CH₃F, CH₂F₂, and CHF₃ can be used as an etching gas of the insulator 137 and the insulators 135. Alternatively, a mixed gas containing at least one of the gases given above can be used. As an example of the mixed gas, a mixed gas containing at least one of the gases given above and a gas selected from He, Ne, Ar, Kr, Xe, and Rn is given. Phosphoric acid can be used as an etchant of the insulator 137 and the insulators 135. Note that in the case where wet etching is used to remove the insulator 137 and the insulators 135, the etching rate of the insulator 137 and the insulators 135 can be controlled by adjusting the temperature of the etchant. The insulator 137 and the insulators 135 are preferably etched with heated phosphoric acid.

The removal of the insulator 137 and the insulators 135 results in generation of a layer serving as a cavity between the insulators 123 positioned thereover and thereunder.

Conductors to be the conductors 182 and the conductor 183 are formed in regions where the insulator 137 and the insulators 135 have been removed. The conductor can be formed by a CVD method or an ALD method. It is particularly preferable to employ an ALD method, in which case a film with a uniform thickness can be formed even in a groove or an opening portion having a high aspect ratio. For the conductor, a material that can be used for the conductor 122 or the conductive films 136A can be used. The conductor may contain a material that is the same as or different from that for the conductor 122 or the conductive films 136A. In order to inhibit oxidation of the conductor, the insulators 181 are preferably formed before the formation of the conductor. The insulators 181 preferably have a barrier property against oxygen. The insulators 181 can be formed by an ALD method. An ALD method allows the insulators 181 to be formed on the top surfaces of the insulators 123, the bottom surfaces of the insulators 123, the side surfaces of the insulators 124, and the side surface of the insulator 150.

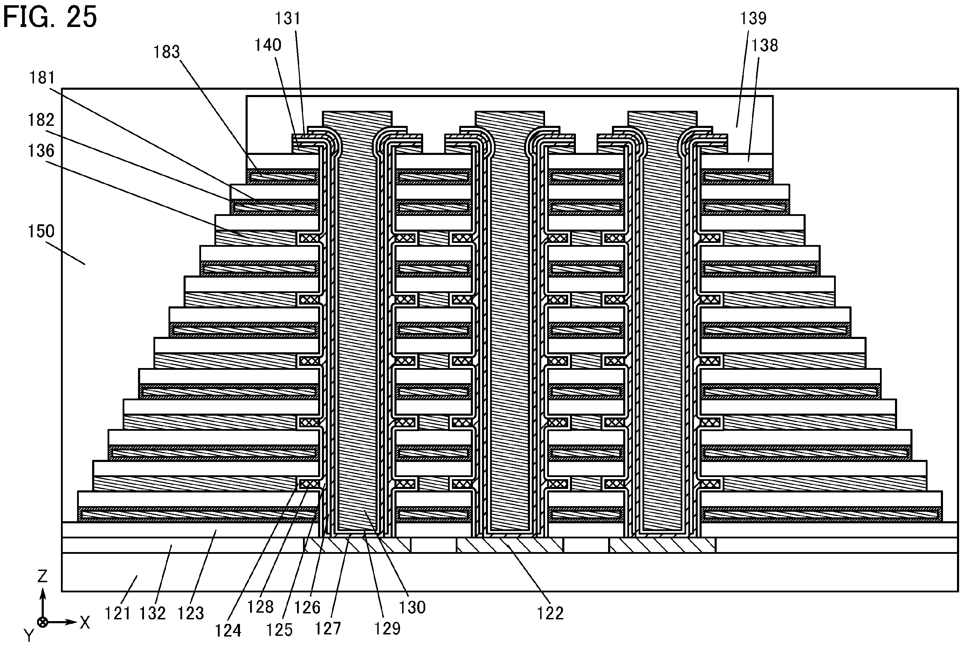

Next, the conductors positioned in the slits formed in the preceding step are subjected to anisotropic etching, so that the conductors 182 and the conductor 183 are formed (see FIG. 25). Here, the conductor formed in the region where the insulator 135 has been provided is the conductor 182, and the conductor formed in the region where the insulator 137 has been provided is the conductor 183. The conductors 182 and the conductor 183 are each covered with the insulator 181 except for a plane positioned on the slit side, that is, a plane perpendicular to the Y direction.

Next, an insulator is formed so as to fill the portions removed by the above processing, that is, the slit portions. The insulators can be formed by a CVD method or an ALD method. It is particularly preferable to employ an ALD method, in which case a film with a uniform thickness can be formed even in a groove or an opening portion having a high aspect ratio. Alternatively, the insulators may be formed by a combination of an ALD method and a CVD method. The insulator is preferably subjected to planarization treatment by a CMP method or a reflow method.

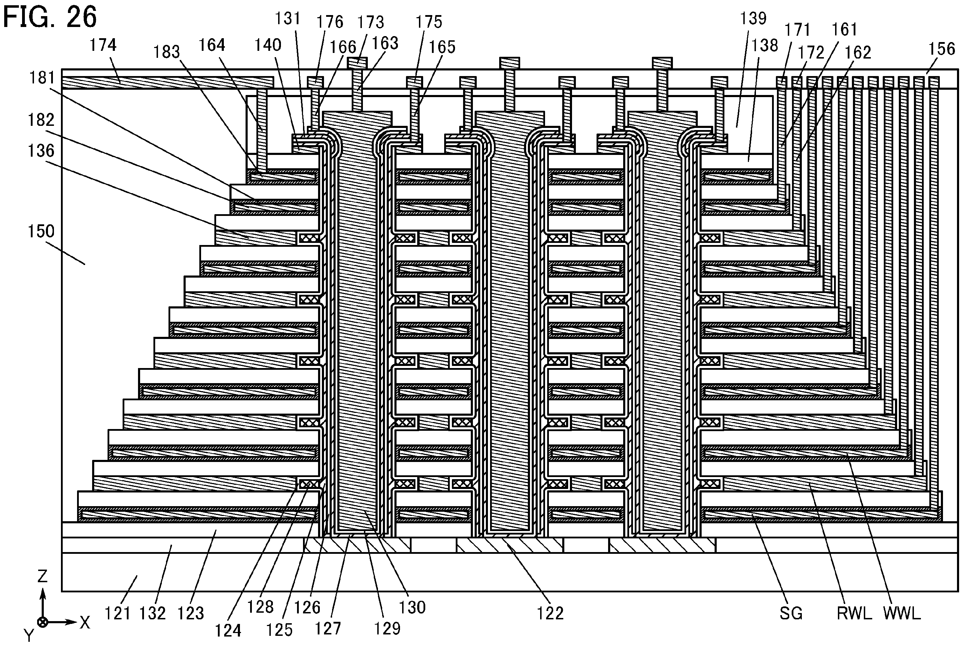

Next, the insulator 150, the insulator 139, the insulators 129, the insulators 131, the insulators 126, the insulator 138, and the insulators 181 are processed by a lithography method, whereby second openings are formed so as to expose the conductors 182, the conductors 136, the conductors 130, the conductor 183, the semiconductors 125, and the semiconductors 127. The second openings are formed for the respective conductors 182 and conductors 136 formed in the step-like shape (see FIG. 26).

Next, conductors 161 electrically connected to the conductors 182, conductors 162 electrically connected to the conductors 136, a conductor 164 electrically connected to the conductor 183, conductors 165 electrically connected to the semiconductors 125, and conductors 166 electrically connected to the semiconductors 127 are formed so as to fill the second openings (see FIG. 26). The conductors 161, the conductors 162, the conductor 164, the conductors 165, and the conductors 166 can be formed by a CVD method or an ALD method. It is particularly preferable to employ an ALD method, in which case a film with a uniform thickness can be formed even in a groove or an opening portion having a high aspect ratio. Alternatively, the conductors may be formed by a combination of an ALD method and a CVD method. The conductors 161, the conductors 162, the conductor 164, the conductors 165, and the conductors 166 may have a stacked-layer structure composed of a plurality of layers. The conductors 161, the conductors 162, the conductor 164, the conductors 165, and the conductors 166 can be formed in such a manner that a conductive film is formed over the insulator 150 and inside the second openings and unnecessary part of the conductive film is removed by CMP or the like.

Next, conductors 171 electrically connected to the conductors 161, conductors 172 electrically connected to the conductors 162, a conductor 174 electrically connected to the conductor 164, conductors 175 electrically connected to the conductors 165, and conductors 176 electrically connected to the conductors 166 are formed (see FIG. 26). The conductors 171, the conductors 172, the conductor 174, the conductors 175, and the conductors 176 can be formed in such a manner that a conductive film is formed over the insulator 150 and processed by a lithography method. For the processing, a dry etching method or a wet etching method can be employed. Processing by a dry etching method is suitable for microfabrication.

The conductors 171, the conductors 161, and the conductors 182 function as the conductor SG or the conductor WWL. The conductors 172, the conductors 162, and the conductors 136 function as the conductor RWL. The conductor 174, the conductor 164, and the conductor 183 function as the conductor SEL. The conductors 175 and the conductors 165 function as a conductor WBL. The conductors 176 and the conductors 166 function as a conductor RBL.

Next, an insulator 156 is formed so as to cover the insulator 150, the insulator formed so as to fill the slits, the conductors 171, the conductors 172, the conductor 174, the conductors 175, and the conductors 176 (see FIG. 26). The insulator 156 can be formed by a CVD method, an ALD method, a sputtering method, or the like.

Then, the insulator 156, the insulator 150, and the insulator 139 are processed by a lithography method, whereby third openings are formed so as to expose the conductors 130 (see FIG. 26).

Next, conductors 163 electrically connected to the conductors 130 are formed so as to fill the third openings (see FIG. 26). The conductors 163 can be formed by a CVD method or an ALD method. It is particularly preferable to employ an ALD method, in which case a film with a uniform thickness can be formed even in a groove or an opening portion having a high aspect ratio. Alternatively, the conductors may be formed by a combination of an ALD method and a CVD method. The conductors 163 may have a stacked-layer structure composed of a plurality of layers. The conductors 163 can be formed in such a manner that a conductive film is formed over the insulator 156 and inside the third openings and unnecessary part of the conductive film is removed by CMP or the like.

Next, conductors 173 electrically connected to the conductors 163 are formed (see FIG. 26). The conductors 173 can be formed in such a manner that a conductive film is formed over the insulator 156 and is processed by a lithography method. For the processing, a dry etching method or a wet etching method can be employed. Processing by a dry etching method is suitable for microfabrication.

The conductors 173, the conductors 163, and the conductors 130 function as a conductor BG.

Through the above-described steps, the transistor STr1 that includes the semiconductor 127 functioning as a channel formation region and the conductor 182 functioning as a gate; the transistor STr2 that includes the semiconductor 125 and the semiconductor 127 functioning as a channel formation region and the conductor 183 functioning as a gate; the transistor WTr that includes the semiconductor 125 functioning as a channel formation region and the conductor 182 functioning as a gate; and the transistor RTr that includes the semiconductor 127 functioning as a channel formation region, the conductor 136 functioning as a gate, the conductor 130 functioning as a back gate, and the conductor 128 between the semiconductor 127 and the conductor 136 can be manufactured. Furthermore, the memory device including the transistor STr1, the transistor STr2, the transistor WTr, and the transistor RTr can be manufactured.

This embodiment can be implemented in an appropriate combination with the structures described in the other embodiments and the like.

### (Embodiment 3)

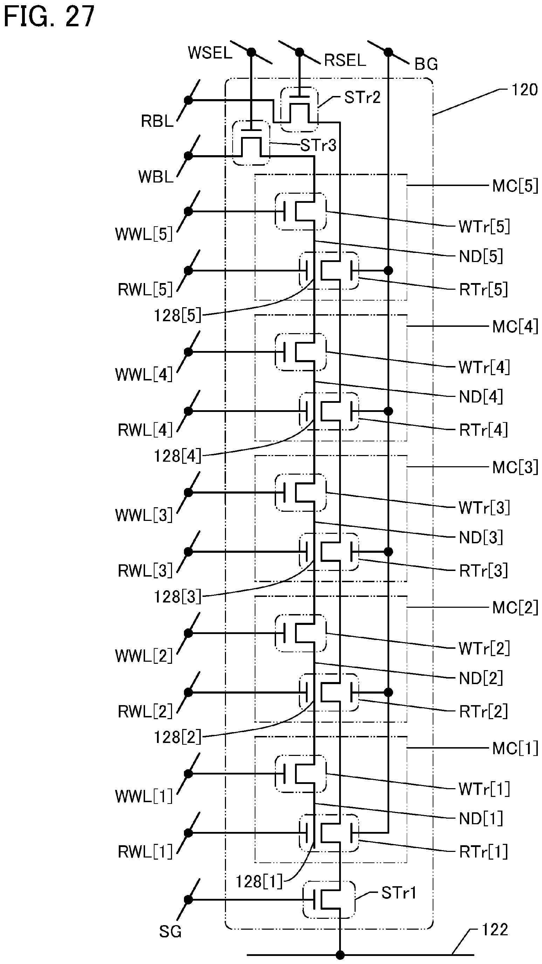

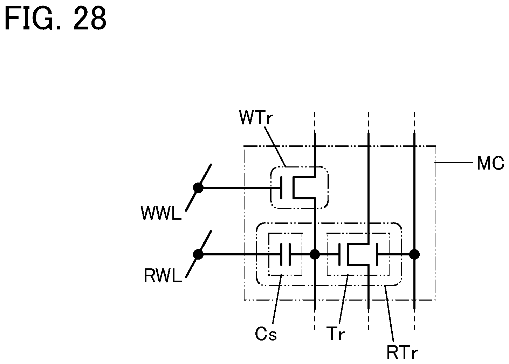

In this embodiment, a circuit configuration and operations of the memory string 120 that is a memory device will be described. FIG. 27 illustrates a circuit configuration example of the memory string 120. FIG. 28 illustrates an equivalent circuit diagram of the memory element MC.

### <Circuit configuration example of memory string>

FIG. 27 illustrates a circuit configuration example of the memory string 120 including five memory elements MC. The memory elements MC each include the transistor WTr and the transistor RTr. In FIG. 27, the transistor WTr included in the memory element MC[1] is denoted as a transistor WTr[1], and the transistor RTr included in the memory element MC[1] is denoted as a transistor RTr[1]. Thus, the memory string 120 illustrated in FIG. 27 includes the transistor WTr[1] to a transistor WTr[5] and the transistor RTr[1] to a transistor RTr[5]. Furthermore, the memory string 120 illustrated in FIG. 27 includes the transistor STr1, the transistor STr2, and a transistor STr3. The memory string 120 is a NAND memory device.

The transistor WTr is a normally-off transistor. The transistor RTr is a normally-on transistor. As described in the above embodiment, the transistor RTr includes the conductor 128 between the gate and the semiconductor layer. The conductor 128 can function as a floating gate of the transistor RTr. For example, the conductor 128 included in the transistor RTr[1] is referred to as a conductor 128[1].

A contact where the conductor 128 and one of a source and a drain of the transistor WTr are electrically connected to each other is referred to as a node ND. For example, a contact where the conductor 128[1] and one of a source and a drain of the transistor WTr[1] are electrically connected to each other is referred to as a node ND[1].

One of a source and a drain of the transistor RTr[1] is electrically connected to one of a source and a drain of the transistor STr1, and the other of the source and the drain of the transistor RTr[1] is electrically connected to one of a source and a drain of the transistor RTr[2]. A gate of the transistor RTr[1] is electrically connected to the conductor RWL[1]. A back gate of the transistor RTr[1] is electrically connected to the conductor BG. The one of the source and the drain of the transistor WTr[1] is electrically connected to the conductor 128[1] and the other of the source and the drain of the transistor WTr[1] is electrically connected to a conductor 128[2]. A gate of the transistor WTr[1] is electrically connected to the conductor WWL[1]. Furthermore, the other of the source and the drain of the transistor STr1 is electrically connected to the conductor 122, and a gate of the transistor STr1 is electrically connected to the conductor SG.

Here, as illustrated in FIG. 28, the transistor RTr can be represented by being replaced with a capacitor Cs and a transistor Tr. A gate of the transistor Tr is electrically connected to the conductor RWL through the capacitor Cs.

One of a source and a drain of the transistor RTr[5] is electrically connected to the other of a source and a drain of a transistor RTr[4], and the other of the source and the drain of the transistor RTr[5] is electrically connected to one of a source and a drain of the transistor STr2. A gate of the transistor RTr[5] is electrically connected to the conductor RWL[5]. A back gate of the transistor RTr[5] is electrically connected to the conductor BG. One of a source and a drain of the transistor WTr[5] is electrically connected to a conductor 128[5], and the other of the source and the drain of the transistor WTr[5] is electrically connected to one of a source and a drain of the transistor STr3. A gate of the transistor WTr[5] is electrically connected to the conductor WWL[5]. The other of the source and the drain of the transistor STr2 is electrically connected to the conductor RBL, and a gate of the transistor STr2 is electrically connected to the conductor RSEL. The other of the source and the drain of the transistor STr3 is electrically connected to the conductor WBL, and a gate of the transistor STr3 is electrically connected to the conductor WSEL.

In the case where the memory string 120 includes *n* memory elements MC (*n* is an integer greater than or equal to 1), in an *i*-th (*i* is an integer greater than or equal to 1 and less than or equal to *n*) memory element MC[*i*] that is neither the first nor n-th memory element MC, one of a source and a drain of a transistor RTr[*i*] is electrically connected to the other of a source and a drain of a transistor RTr[*i*-1], and the other of the source and the drain of the transistor RTr[*i*] is electrically connected to one of a source and a drain of a transistor RTr[*i*+1]. A gate of the transistor RTr[*i*] is electrically connected to a conductor RWL[*i*]. A back gate of the transistor RTr[*i*] is electrically connected to the conductor BG. One of a source and a drain of a transistor WTr[*i*] is electrically connected to a conductor 128[*i*] and the other of the source and the drain of the transistor WTr[*i*] is electrically connected to a conductor 128[*i*-1]. A gate of the transistor WTr[*i*] is electrically connected to a conductor WWL[*i*].

### <Operation example of memory string>

Next, an operation example of the memory string 120 illustrated in FIG. 27 is described.

### [Writing operation]

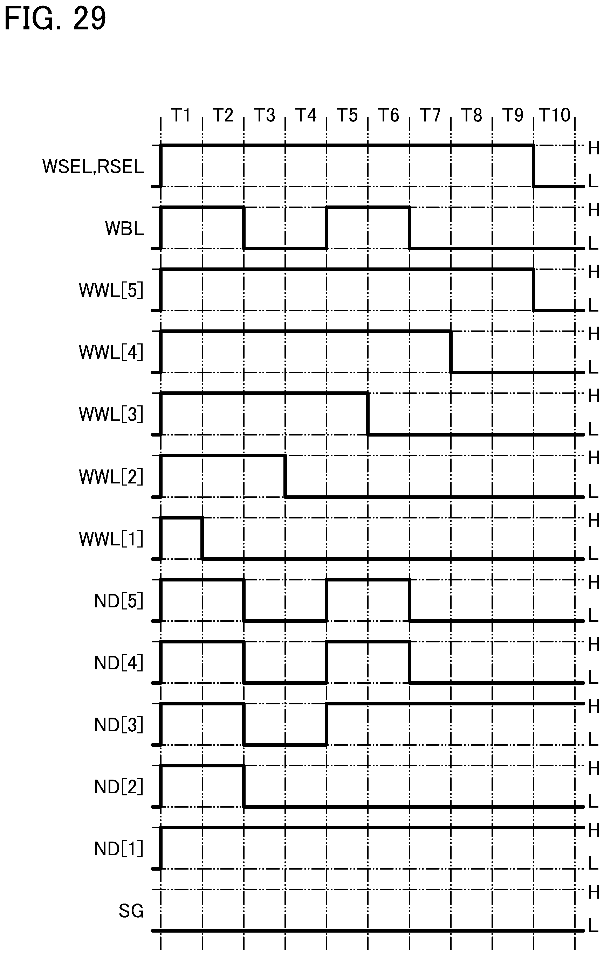

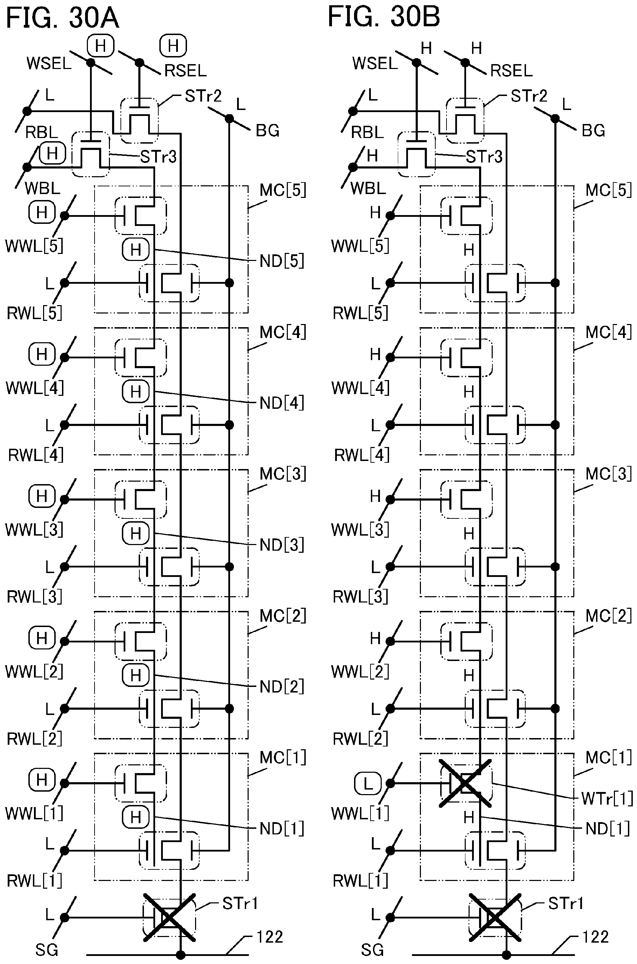

In this embodiment, an operation example of the case where the H potential is written to the memory element MC[1] and a memory element MC[3] and the L potential is written to the other memory elements MC is described. FIG. 29 is a timing chart showing a writing operation. FIG. 30A to FIG. 34B are circuit diagrams for explaining the writing operation.

In an initial state, it is assumed that the L potential is written to the memory element MC[1] to the memory element MC[5]. Furthermore, it is assumed that the L potential is supplied to the conductor WWL[1] to the conductor WWL[5], the conductor RWL[1] to the conductor RWL[5], the conductor WSEL, the conductor RSEL, the conductor BG, the conductor WBL, the conductor RBL, the conductor SG, and the conductor 122. Note that the conductor BG can control the threshold of the transistor RTr. The potential to be supplied to the conductor BG may be adjusted appropriately so that the transistor RTr can be a desired normally-on transistor. Although description is made assuming that the conductor WSEL and the conductor RSEL are one conductor, they may be different conductors.

### [Period T1]

In Period T1, the H potential is supplied to the conductor WWL[1] to the conductor WWL[5], the conductor WBL, and the conductor WSEL (and the conductor RSEL) (see FIG. 30A). Then, the node ND[1] to a node ND[5] have the H potential.

### [Period T2]

In Period T2, the L potential is supplied to the conductor WWL[1] (see FIG. 30B). This brings the transistor WTr[1] into an off state, and charge written to the node ND[1] is retained. Here, the charge corresponding to the H potential is retained.

### [Period T3]

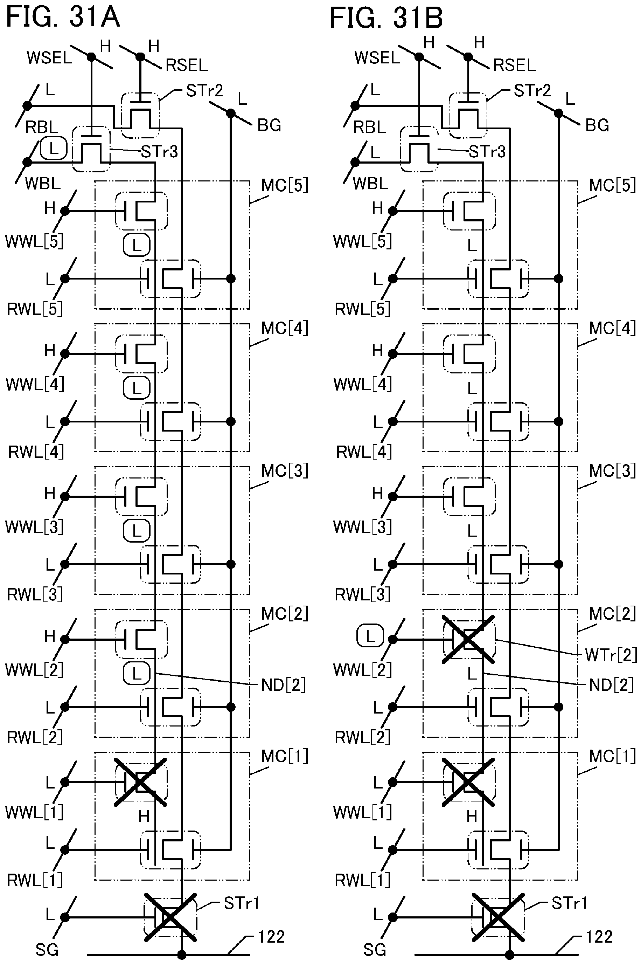

In Period T3, the L potential is supplied to the conductor WBL (see FIG. 31A). This brings the potentials of the node ND[2] to the node ND[5] into the L potential. In this case, the conductor 128[2] to the conductor 128[5] are also brought to have the L potential; however, since the transistors RTr are normally-on transistors, the transistor RTr[2] to the transistor RTr[5] are not brought into an off state.

### [Period T4]

In Period T4, the L potential is supplied to the conductor WWL[2] (see FIG. 31B). This brings the transistor WTr[2] into an off state, and charge written to the node ND[2] is retained. Here, the charge corresponding to the L potential is retained.

### [Period T5]

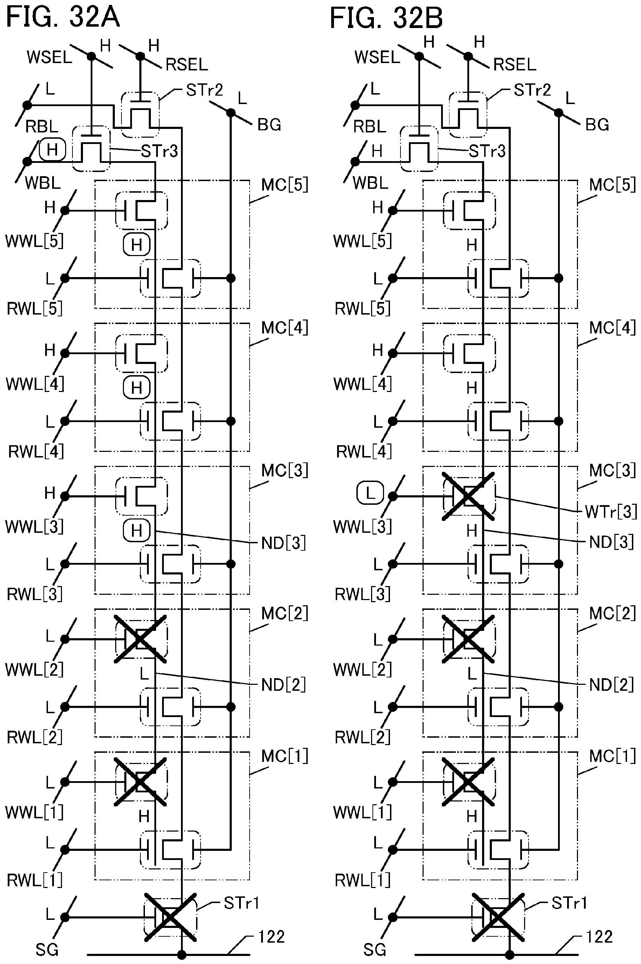

In Period T5, the H potential is supplied to the conductor WBL (see FIG. 32A). This brings the potentials of the node [3] to the node [5] into the H potential.

### [Period T6]

In Period T6, the L potential is supplied to the conductor WWL[3] (see FIG. 32B). This brings the transistor WTr[3] into an off state, and charge written to the node ND[3] is retained. Here, the charge corresponding to the H potential is retained.

### [Period T7]

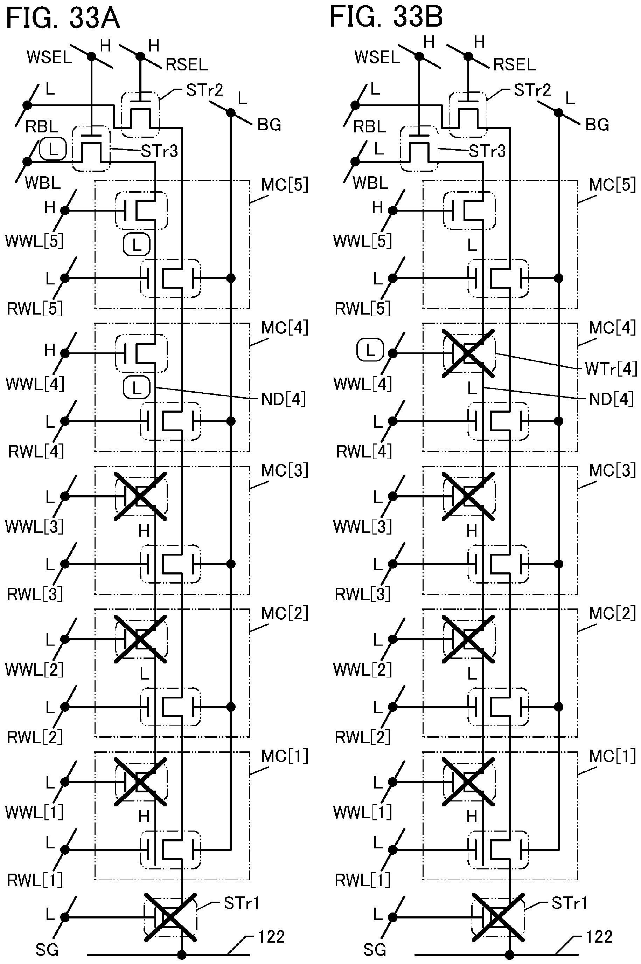

In Period T7, the L potential is supplied to the conductor WBL (see FIG. 33A). This brings the potentials of the node ND[4] and the node ND[5] into the L potential.

### [Period T8]

In Period T8, the L potential is supplied to the conductor WWL[4] (see FIG. 33B). This brings the transistor WTr[4] into an off state, and charge written to the node ND[4] is retained. Here, the charge corresponding to the L potential is retained.

### [Period T9]

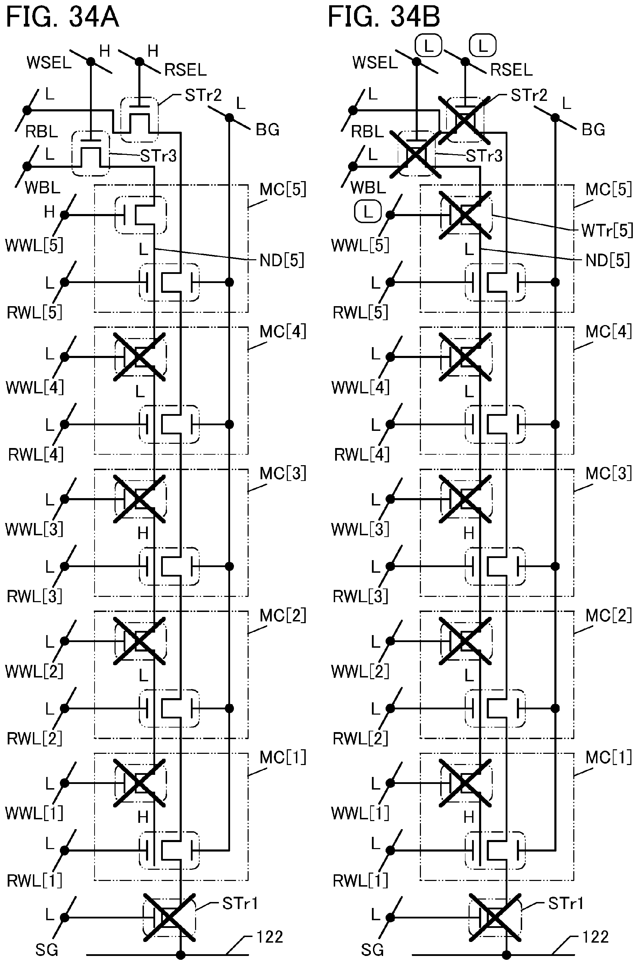

In Period T9, the conductor WBL remains at the L potential (see FIG. 34A). Thus, the potential of the node ND[5] also remains at the L potential.

### [Period T10]

In Period T10, the L potential is supplied to the conductor WWL[5] (see FIG. 34B). This brings the transistor WTr[5] into an off state, and charge written to the node ND[5] is retained. Here, the charge corresponding to the L potential is retained. Furthermore, the L potential is supplied to the conductor WSEL (and the conductor RSEL).

In this manner, data can be written to the memory elements MC.

Note that in the case where data is written to the i-th (except for *i* = 1) memory element MC among the plurality of memory elements MC, a data writing operation for the memory elements MC up to the (*i*-1)-th memory element can be omitted. For example, in the case where data is written to the memory element MC[4], a data writing operation for the memory element MC[1] to the memory element MC[3] may be omitted. In other words, the writing operation from Period T1 to Period T6 described in this embodiment can be omitted. Therefore, the time and power consumption for the writing operation of the memory device can be reduced.

### [Reading operation]

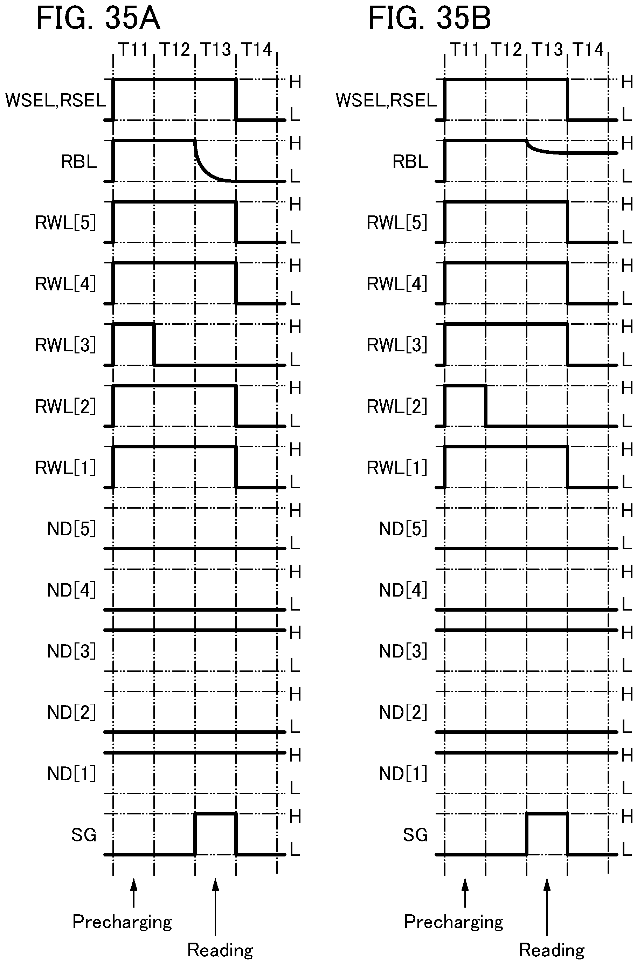

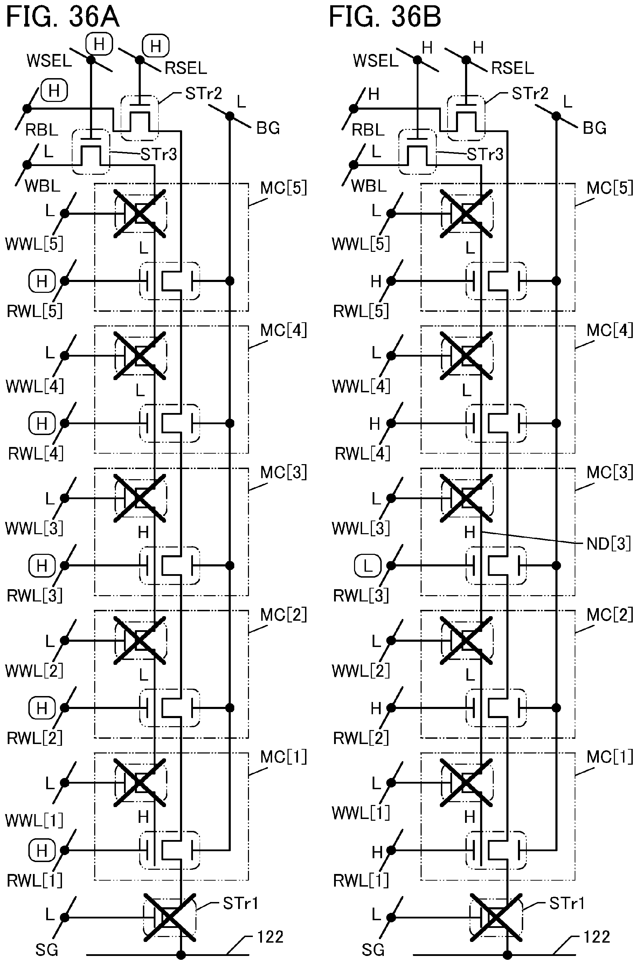

A reading operation example of the memory string 120 with the above-described circuit configuration is described. It is assumed that in an initial state, the H potential is retained in the memory element MC[1] and the memory element MC[3]. Furthermore, it is assumed that the L potential is supplied to the conductor WWL[1] to the conductor WWL[5], the conductor RWL[1] to the conductor RWL[5], the conductor WSEL, the conductor RSEL, the conductor BG, the conductor WBL, the conductor RBL, the conductor SG, and the conductor 122. FIG. 35A and FIG. 35B are timing charts showing a reading operation. FIG. 36A to FIG. 37B are circuit diagrams for explaining the reading operation.

### <When retained potential is H potential>

First, a reading operation for the memory element MC[3] where the H potential is retained is described.

### [Period T11]

In Period T11, the H potential is supplied to the conductor RWL[1] to the conductor RWL[5] and the conductor RSEL (and the conductor WSEL) (see FIG. 36A). This brings the transistor STr2 (and the transistor STr3) into an on state, and the semiconductor 127 included in the transistors RTr and the conductor RBL are brought into conduction. In this state, the conductor RBL and the semiconductor 127 are precharged with the H potential and both brought into a floating state.

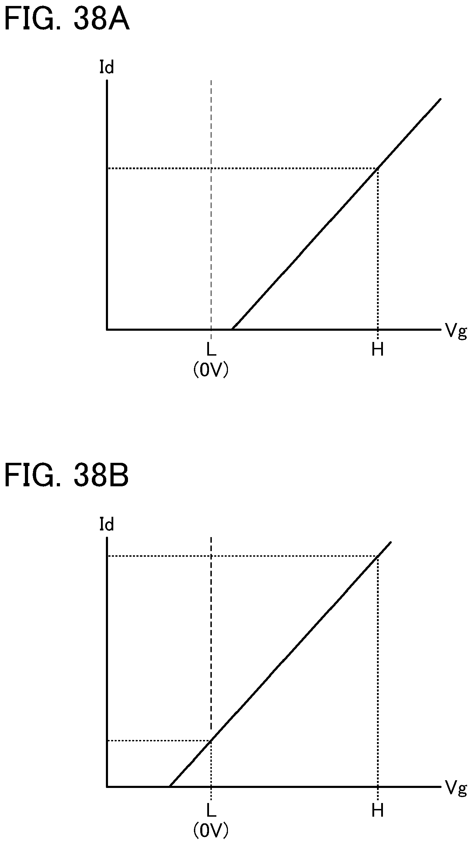

Here, Id-Vg characteristics of transistors are described. FIG. 38A and FIG. 38B are diagrams showing the Id-Vg characteristics of transistors. In FIG. 38A and FIG. 38B, the horizontal axis represents the gate voltage (Vg) and the vertical axis represents the drain current (Id). FIG. 38A shows the Id-Vg characteristics of a normally-off transistor, and FIG. 38B shows the Id-Vg characteristics of a normally-on transistor.

The H potential is a potential higher than the L potential. When the L potential is 0 V, the H potential is a positive voltage. In a normally-off transistor, the channel resistance (channel resistance between the source and the drain) at the time when Vg is the L potential (0 V) is extremely high and Id hardly flows. Furthermore, when Vg becomes the H potential, the channel resistance decreases and Id increases (see FIG. 38A).

In a normally-on transistor, even when Vg is the L potential, the channel resistance is low and a large amount of Id flows compared with the case of the normally-off transistor. Furthermore, when Vg becomes the H potential, the channel resistance further decreases and Id further increases (see FIG. 38B).

Since the transistors RTr are normally-on transistors, even with the potential of the conductors RWL kept at the L potential, precharging of the semiconductor 127 is possible. However, supplying the H potential to the conductors RWL decreases the on resistance of the transistors RTr, and therefore, the time and power consumption necessary for precharging can be reduced.

### [Period T12]

In Period T12, the L potential is supplied to the conductor RWL[3] (see FIG. 36B). Since the H potential is retained in the node ND[3], even when the potential of the conductor RWL[3] becomes the L potential, the channel resistance of the transistor RTr[3] remains low.

### [Period T13]

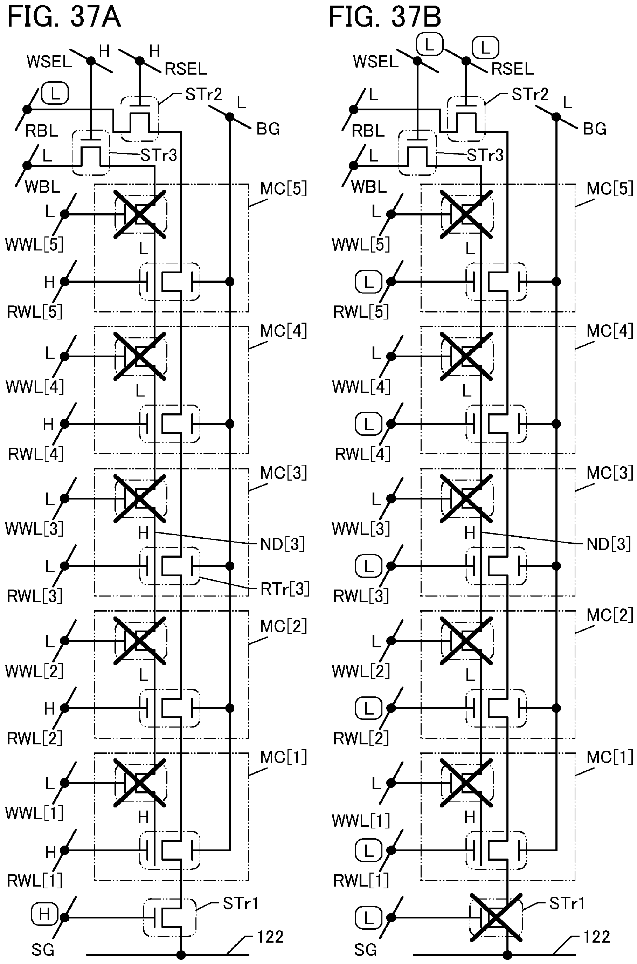

In Period T13, the H potential is supplied to the conductor SGto bring the transistor STr1 into an on state (see FIG. 37A). This brings the conductor RBL and the conductor 122 into conduction. In this case, since the H potential is supplied to the conductor RWL[1], the conductor RWL[2], the conductor RWL[4], and the conductor RWL[5], the channel resistances of the transistor RTr[1], the transistor RTr[2], the transistor RTr[4], and the transistor RTr[5] are low regardless of the potentials of the nodes ND. Although the L potential is supplied to the conductor RWL[3], the H potential is retained in the node ND[3] and thus the channel resistance of the transistor RTr[3] is also low. Hence, the potential of the conductor RBL in a floating state changes abruptly from the H potential to the L potential (see FIG. 35A).

### [Period T14]

In Period T14, the L potential is supplied to the conductor RSEL (and the conductor WSEL), the conductors RWL, and the conductor SG (see FIG. 37B).

### <When retained potential is L potential>

Next, a reading operation for the memory element MC[2] where the L potential is retained is described. In the case where the data (potential) retained in the memory element MC[2] is read, the potential of the conductor RWL[2] is set at the L potential in Period T12 (see FIG. 35B). In this case, since the L potential is retained in the node ND[2], the channel resistance of the transistor RTr[2] remains high.

Next, in Period T13, the H potential is supplied to the conductor SG to bring the conductor RBL and the conductor 122 into conduction. In this case, since the channel resistance of the transistor RTr[2] is high, the potential of the conductor RBL gently changes from the H potential to the L potential.

In this manner, by setting the potential of the conductor RWL connected to the memory element MC of a reading target at the L potential in Period T13, data retained in the memory element MC can be found.

### <Variation>

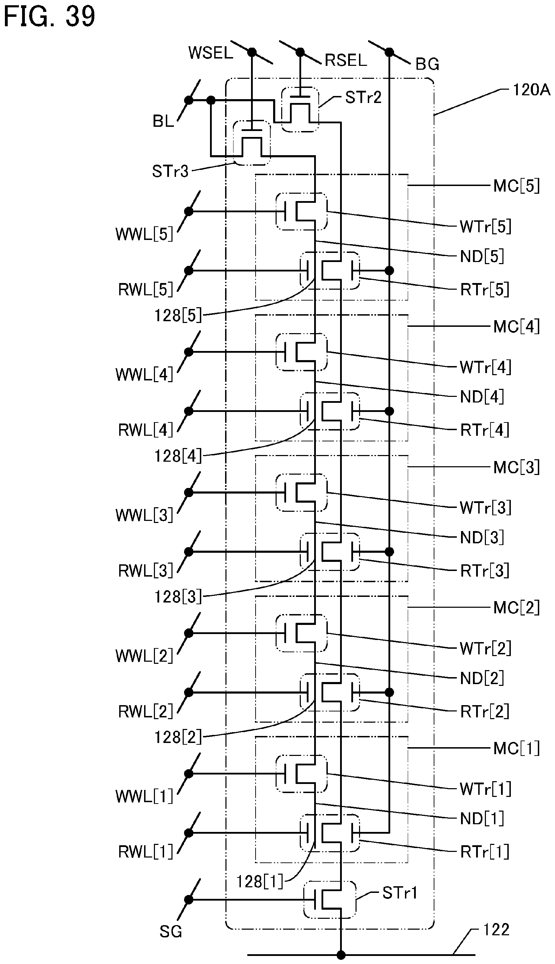

FIG. 39 illustrates a circuit configuration example of a memory string 120A, which is a variation of the memory string 120.

In the memory string 120A illustrated in FIG. 39, the other of the source and the drain of the transistor STr3 is electrically connected to the conductor BL. The other of the source and the drain of the transistor STr2 is electrically connected to the conductor BL.

In the writing operation, the transistor STr3 is in an on state and the transistor STr2 is in an off state. In the reading operation, the transistor STr3 is in an off state and the transistor STr2 is in an on state. To perform writing or reading of data through the conductor BL, the data transmission paths can be switched with the dedicated transistors. Thus, the operation of the memory device is stabilized and the reliability of the memory device can be increased.

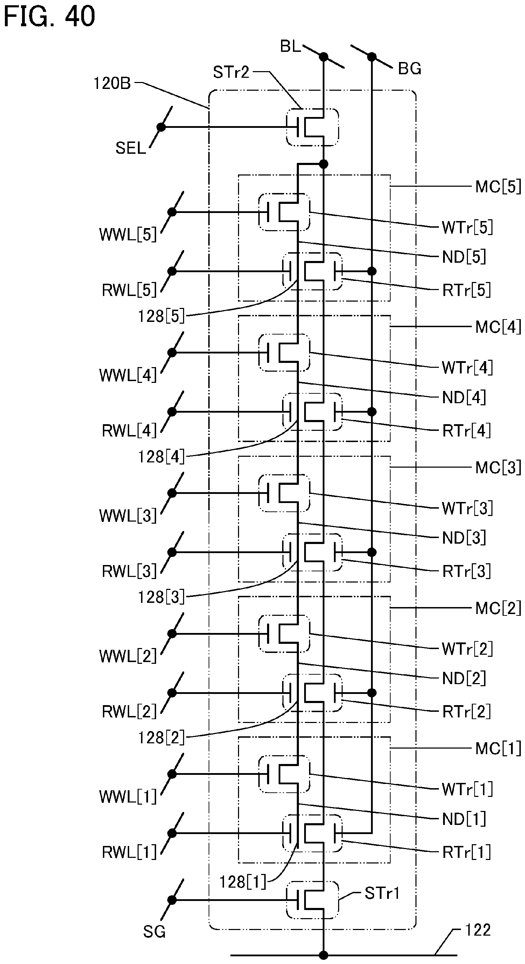

As in a memory string 120B illustrated in FIG. 40, the transistor STr2 and the transistor STr3 may be used in common. In that case, the other of the source and the drain of the transistor STr2 is electrically connected to the conductor BL. In the writing operation and the reading operation, data is written and read through the conductor BL. By providing the common conductor BL for the writing operation and the reading operation, the number of wirings can be reduced.

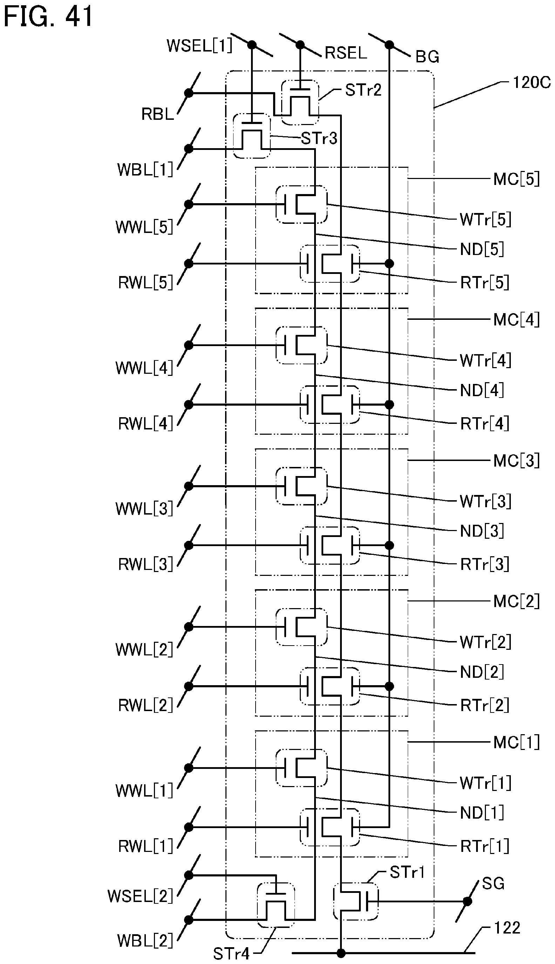

A memory string 120C illustrated in FIG. 41 has a circuit configuration of the memory string 120 to which a transistor STr4 is added. One of a source and a drain of the transistor STr4 is electrically connected to the one of the source and the drain of the transistor WTr[1], and the other of the source and the drain of the transistor STr4 is electrically connected to the conductor WBL[2]. A gate of the transistor STr4 is electrically connected to a conductor WSEL[2].

Furthermore, in the memory string 120C, the gate of the transistor STr3 is electrically connected to a conductor WSEL[1], and the other of the source and the drain of the transistor STr3 is electrically connected to a conductor WBL[1]. As illustrated in FIG. 39, the circuit configuration where the transistor STr2 and the transistor STr3 are electrically connected to the conductor BL may also be employed.

In the memory string 120C, data can be written from both the conductor WBL[1] and the conductor WBL[2]. Thus, the data writing speed can be increased. Moreover, charge corresponding to data to be written can be supplied more reliably.

Furthermore, in the case where data is written to the i-th memory element MC, when *i* is close to *n*, data is written from the conductor WBL[1] side, so that the data writing operation for the first to (*i* - 1)-th memory elements MC can be omitted. When *i* is close to 1, data is written from the conductor WBL[2] side, so that the data writing operation for the (i + 1)-th to n-th memory elements MC can be omitted. The memory string 120C can further reduce the time and power consumption for the writing operation.

This embodiment can be implemented in an appropriate combination with the structures described in the other embodiments and the like.

### (Embodiment 4)

In this embodiment, a structure example of a semiconductor device 200 including the memory device 100 will be described.

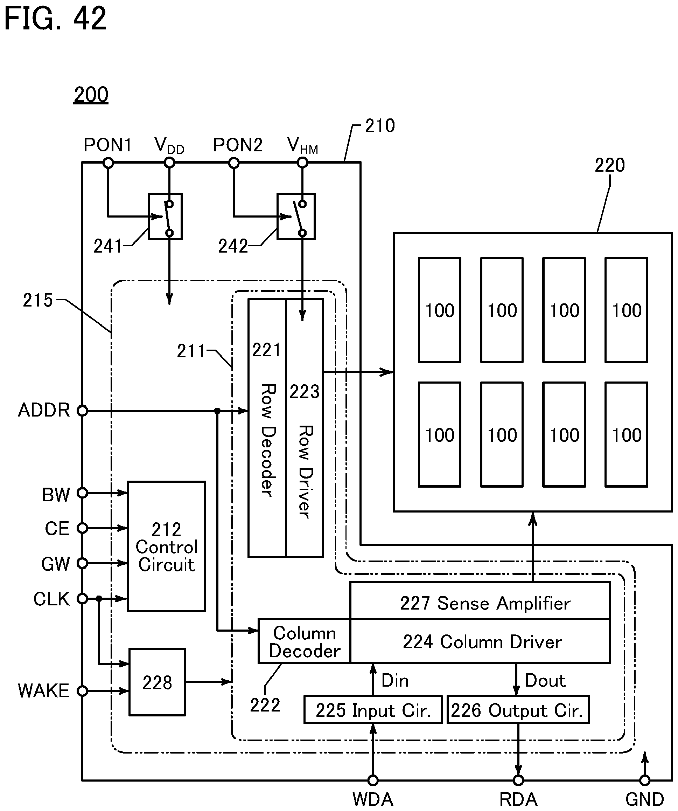

FIG. 42 is a block diagram illustrating a structure example of the semiconductor device 200 of one embodiment of the present invention. The semiconductor device 200 illustrated in FIG. 42 includes a driver circuit 210 and a memory array 220. The memory array 220 includes one or more memory devices 100. FIG. 42 illustrates an example in which the memory array 220 includes a plurality of memory devices 100 arranged in a matrix.

The driver circuit 210 includes a PSW 241 (power switch), a PSW 242, and a peripheral circuit 215. The peripheral circuit 215 includes a peripheral circuit 211, a control circuit 212, and a voltage generation circuit 228. Note that the semiconductor device 200 includes elements, circuits, and the like having a variety of functions such as the memory array 220, the PSW 241, the PSW 242, the peripheral circuit 211, the control circuit 212, and the voltage generation circuit 228. Thus, the semiconductor device 200 may be referred to as a system or a subsystem.

In the semiconductor device 200, each circuit, each signal, and each voltage can be appropriately selected as needed. Alternatively, another circuit or another signal may be added. A signal BW, a signal CE, a signal GW, a signal CLK, a signal WAKE, a signal ADDR, a signal WDA, a signal PON1, and a signal PON2 are signals input from the outside, and a signal RDA is a signal output to the outside. The signal CLK is a clock signal.

The signal BW, the signal CE, and the signal GW are control signals. The signal CE is a chip enable signal, the signal GW is a global write enable signal, and the signal BW is a byte write enable signal. The signal ADDR is an address signal. The signal WDA is write data, and the signal RDA is read data. The signal PON1 and the signal PON2 are power gating control signals. Note that the signal PON1 and the signal PON2 may be generated in the control circuit 212.

The control circuit 212 is a logic circuit having a function of controlling the overall operation of the semiconductor device 200. For example, the control circuit performs a logical operation on the signal CE, the signal GW, and the signal BW to determine an operation mode of the semiconductor device 200 (e.g., a writing operation or a reading operation). Alternatively, the control circuit 212 generates a control signal for the peripheral circuit 211 so that the operation mode is executed.

The voltage generation circuit 228 has a function of generating a negative voltage. The signal WAKE has a function of controlling the input of the signal CLK to the voltage generation circuit 228. For example, when an H-level signal is supplied as the signal WAKE, the signal CLK is input to the voltage generation circuit 228, and the voltage generation circuit 228 generates a negative voltage.

The peripheral circuit 211 is a circuit for writing and reading data to/from the memory device 100. The peripheral circuit 211 includes a row decoder 221, a column decoder 222, a row driver 223, a column driver 224, an input circuit 225 (Input Cir.), an output circuit 226 (Output Cir.), and a sense amplifier 227.

The row decoder 221 and the column decoder 222 have a function of decoding the signal ADDR. The row decoder 221 is a circuit for specifying a row to be accessed, and the column decoder 222 is a circuit for specifying a column to be accessed. The row driver 223 has a function of selecting the wiring specified by the row decoder 221. The column driver 224 has a function of writing data to the memory device 100, a function of reading data from the memory device 100, a function of retaining the read data, and the like.

The input circuit 225 has a function of retaining the signal WDA. Data retained by the input circuit 225 is output to the column driver 224. Data output from the input circuit 225 is data (Din) to be written to the memory device 100. Data (Dout) read from the memory device 100 by the column driver 224 is output to the output circuit 226. The output circuit 226 has a function of retaining Dout. In addition, the output circuit 226 has a function of outputting Dout to the outside of the semiconductor device 200. Data output from the output circuit 226 is the signal RDA.

The PSW 241 has a function of controlling the supply of V_{DD} to the peripheral circuit 215. The PSW 242 has a function of controlling the supply of V_{HM} to the row driver 223. Here, in the semiconductor device 200, a high power supply voltage is V_{DD} and a low power supply voltage is GND (a ground potential). In addition, V_{HM} is a high power supply voltage used to set the word line to the high level and is higher than V_{DD}. The on/off of the PSW 241 is controlled by the signal PON1, and the on/off of the PSW 242 is controlled by the signal PON2. The number of power domains to which V_{DD} is supplied is one in the peripheral circuit 215 in FIG. 42 but can be more than one. In that case, a power switch is provided for each power domain.

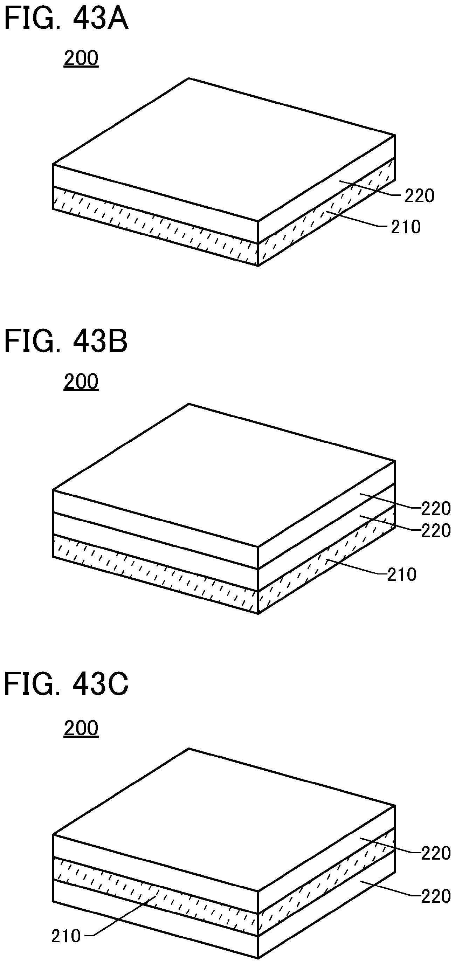

The driver circuit 210 and the memory array 220 may be provided on the same plane. As illustrated in FIG. 43A, the driver circuit 210 and the memory array 220 may be provided so as to overlap with each other. When the driver circuit 210 and the memory array 220 overlap with each other, the signal transmission distance can be shortened. Alternatively, a plurality of memory arrays 220 may be provided over the driver circuit 210 as illustrated in FIG. 43B.

As illustrated in FIG. 43C, the memory arrays 220 may be provided over and under the driver circuit 210. FIG. 43C illustrates an example in which one memory array 220 is provided in each of the layers over and under the driver circuit 210. Providing a plurality of memory arrays 220 such that the driver circuit 210 is sandwiched therebetween can further shorten the signal propagation distance. The number of memory arrays 220 stacked over the driver circuit 210 and the number of memory arrays 220 stacked under the driver circuit 210 may each be one or more. The number of memory arrays 220 stacked over the driver circuit 210 is preferably equal to the number of memory arrays 220 stacked under the driver circuit 210.

### <Cross-sectional structure example of semiconductor device 200>

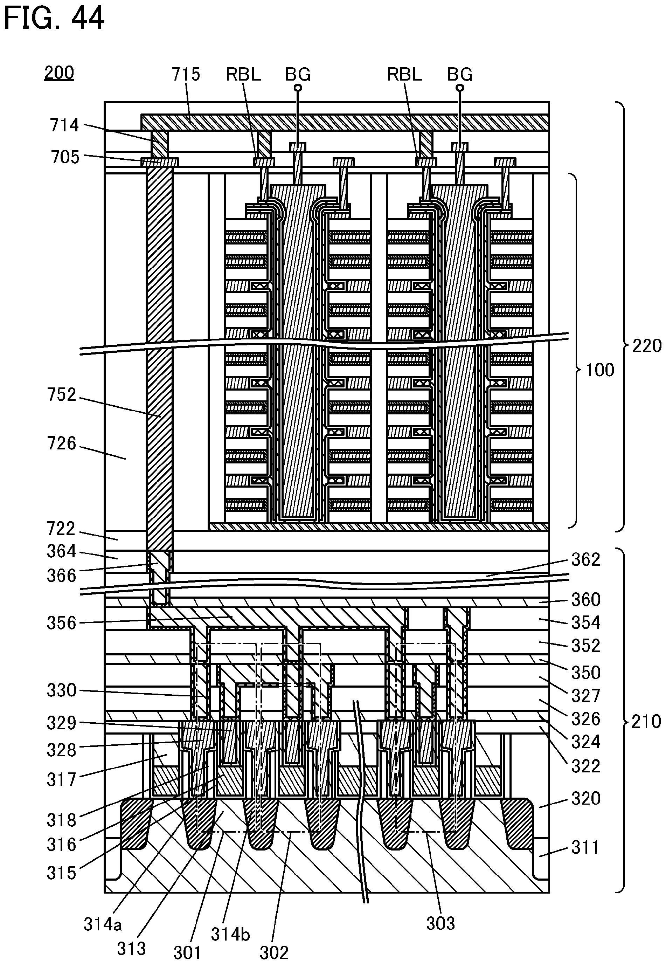

FIG. 44 illustrates a cross-sectional structure example of the semiconductor device 200 illustrated in FIG. 43A. FIG. 44 illustrates part of the semiconductor device 200 illustrated in FIG. 43A.

FIG. 44 illustrates a transistor 301, a transistor 302, and a transistor 303 included in the driver circuit 210. Note that the transistor 301 and the transistor 302 function as part of the sense amplifier 227. Furthermore, the transistor 303 functions as a column selection switch. Specifically, the conductor RBL included in the memory array 220 is electrically connected to one of a source and a drain of the transistor 301, a gate of the transistor 301 is electrically connected to one of a source and a drain of the transistor 302, and a gate of the transistor 302 is electrically connected to the other of the source and the drain of the transistor 301. The one of the source and the drain of the transistor 301 and the other of the source and the drain of the transistor 302 are electrically connected to one of a source and a drain of the transistor 303 functioning as the column selection switch. Accordingly, the layout area of the semiconductor device 200 can be reduced. Note that an example where five memory elements MC are provided per memory string is illustrated in FIG. 44. However, the number of memory elements MC provided in one memory string is not limited thereto. For example, the number of memory elements MC provided in one memory string may be 32, 64, 128, or 200 or more.

The conductor RBL of the memory array 220 is electrically connected to the sense amplifier 227 or the transistor 303 functioning as the column selection switch through a conductor 715, a conductor 714, a conductor 705, and a conductor 752 that is formed so as to be embedded in an insulator 726, an insulator 722, and the like. Note that circuits and transistors included in the driver circuit 210 are examples and the circuit configurations and the transistor structures are not limited to these examples. In addition to the above, a transistor and a circuit such as a control circuit, a row decoder, a row driver, a source line driver, or an input-output circuit can be provided as appropriate in accordance with the structure and driving method of the semiconductor device 200.

The transistor 301, the transistor 302, and the transistor 303 are provided on a substrate 311 and each include a conductor 316, an insulator 315, a semiconductor region 313 that is part of the substrate 311, and a low-resistance region 314a and a low-resistance region 314b each functioning as a source region or a drain region. Note that as illustrated in FIG. 44, one low-resistance region may be used in common for a source region or a drain region of one of the transistor 301 and the transistor 302 and a source region or a drain region of the other of the transistor 301 and the transistor 302.

In each of the transistor 301, the transistor 302, and the transistor 303, the semiconductor region 313 (part of the substrate 311) in which a channel is formed has a convex shape. In addition, the conductor 316 is provided so as to cover a side surface and the top surface of the semiconductor region 313 with the insulator 315 therebetween. Note that a material adjusting the work function may be used for the conductor 316. The transistor 301, the transistor 302, and the transistor 303 that are described above are also referred to as FIN-type transistors because they utilize convex portions of a semiconductor substrate. Note that an insulator functioning as a mask for forming the convex portion may be included in contact with an upper portion of the convex portion. Although the case where the convex portion is formed by processing part of the semiconductor substrate is described here, a semiconductor film having a convex shape may be formed by processing an SOI substrate.

Although each of the transistor 301, the transistor 302, and the transistor 303 may be either a p-channel transistor or an n-channel transistor, the transistor 301 and the transistor 302 are preferably transistors having different polarities.

A region of the semiconductor region 313 where a channel is formed, a region in the vicinity thereof, the low-resistance region 314a and the low-resistance region 314b each functioning as a source region or a drain region, and the like preferably contain a semiconductor such as a silicon-based semiconductor, and preferably contain single crystal silicon. Alternatively, the regions may be formed using a material containing Ge (germanium), SiGe (silicon germanium), GaAs (gallium arsenide), GaAlAs (gallium aluminum arsenide), or the like. A structure may be employed in which silicon whose effective mass is controlled by applying stress to the crystal lattice and changing the lattice spacing is used. Alternatively, the transistor 301, the transistor 302, and the transistor 303 may be an HEMT (High Electron Mobility Transistor) with the use of GaAs and GaAlAs, or the like.

The low-resistance region 314a and the low-resistance region 314b contain an element which imparts n-type conductivity, such as arsenic or phosphorus, or an element which imparts p-type conductivity, such as boron, in addition to the semiconductor material used for the semiconductor region 313.

The insulator 315 functions as a gate insulating film of each of the transistor 301, the transistor 302, and the transistor 303.

For the conductor 316 functioning as a gate electrode, a semiconductor material such as silicon containing the element which imparts n-type conductivity, such as arsenic or phosphorus, or the element which imparts p-type conductivity, such as boron, or a conductive material such as a metal material, an alloy material, or a metal oxide material can be used.

Note that the work function depends on a material of the conductor; thus, the threshold voltage can be adjusted by changing the material of the conductor. Specifically, it is preferable to use a material such as titanium nitride or tantalum nitride for the conductor. Moreover, in order to ensure both conductivity and embeddability, it is preferable to use stacked layers of metal materials such as tungsten or aluminum for the conductor, and it is particularly preferable to use tungsten in terms of heat resistance.

An insulator 317 functioning as an etching stopper is preferably provided above the conductor 316. In addition, an insulator 318 functioning as a spacer is preferably provided on a side surface of the insulator 315. When the insulator 317 and the insulator 318 are provided, regions where the low-resistance region 314a and the low-resistance region 314b and a conductor 328 are electrically connected to each other can be defined in a self-aligned manner. Thus, even when misalignment occurs in forming the openings for exposing part of the low-resistance region 314a and the low-resistance region 314b, the openings for exposing the intended regions can be formed. The conductor 328 provided in the openings formed in this manner can provide a favorable contact with reduced contact resistance between the low-resistance region 314a and the low-resistance region 314b and the conductor 328. The contact between the low-resistance region 314a and the low-resistance region 314b and the conductor 328 which is formed in this manner may be referred to as a self-aligned contact. Furthermore, a conductor 329 electrically connected to the conductor 316 may be provided so as to be embedded in the insulator 317 and an insulator 322.

An insulator 320, the insulator 322, an insulator 324, an insulator 326, and an insulator 327 are stacked in this order so as to cover the transistor 301, the transistor 302, and the transistor 303.

The insulator 320, the insulator 322, the insulator 324, the insulator 326, and the insulator 327 can be formed using, for example, silicon oxide, silicon oxynitride, silicon nitride oxide, silicon nitride, aluminum oxide, aluminum oxynitride, aluminum nitride oxide, or aluminum nitride.

The insulator 322 may have a function of a planarization film for eliminating a level difference caused by the transistor 301 or the like provided below the insulator 322. For example, the top surface of the insulator 322 may be planarized by planarization treatment using a chemical mechanical polishing (CMP) method or the like to increase the planarity.

For the insulator 324, a film having a barrier property that prevents diffusion of hydrogen and impurities from the substrate 311, the transistor 301, or the like into the region where the memory array 220 is provided is preferably used.

For the film having a barrier property against hydrogen, silicon nitride formed by a CVD method can be used, for example. Here, diffusion of hydrogen into a semiconductor element including an oxide semiconductor, such as the memory elements MC, degrades the characteristics of the semiconductor element in some cases. Therefore, a film that inhibits hydrogen diffusion is preferably used between the memory elements MC and the transistor 301 and the like. The film that inhibits hydrogen diffusion is specifically a film from which a small amount of hydrogen is released.

The amount of released hydrogen can be analyzed by thermal desorption spectroscopy (TDS) or the like, for example. The amount of hydrogen released from the insulator 324 that is converted into hydrogen atoms per area of the insulator 324 is less than or equal to 10 × 10¹⁵ atoms/cm², preferably less than or equal to 5 × 10¹⁵ atoms/cm², in the TDS analysis in a film-surface temperature range of 50 °C to 500 °C, for example.

Note that the permittivity of each of the insulator 326 and the insulator 327 is preferably lower than that of the insulator 324. For example, the relative permittivity of each of the insulator 326 and the insulator 327 is preferably lower than 4, further preferably lower than 3. The relative permittivity of each of the insulator 326 and the insulator 327 is, for example, preferably less than or equal to 0.7 times, further preferably less than or equal to 0.6 times the relative permittivity of the insulator 324. When a material with a low permittivity is used for an interlayer film, the parasitic capacitance generated between wirings can be reduced.

The conductor 328, the conductor 329, a conductor 330, and the like that are electrically connected to the memory array 220 are embedded in the insulator 320, the insulator 322, the insulator 324, the insulator 326, and the insulator 327. Note that the conductor 328, the conductor 329, and the conductor 330 function as plugs or wirings. A plurality of conductors functioning as plugs or wirings are collectively denoted by the same reference numeral in some cases. Furthermore, in this specification and the like, a wiring and a plug electrically connected to the wiring may be a single component. That is, part of a conductor functions as a wiring in some cases and part of a conductor functions as a plug in other cases.

As a material for each of the plugs and wirings (the conductor 328, the conductor 329, the conductor 330, and the like), a single layer or a stacked layer of a conductive material such as a metal material, an alloy material, a metal nitride material, or a metal oxide material can be used. It is preferable to use a high-melting-point material that has both heat resistance and conductivity, such as tungsten or molybdenum, and it is preferable to use tungsten. Alternatively, it is preferable to form the plugs and wirings with a low-resistance conductive material such as aluminum or copper. The use of a low-resistance conductive material can reduce wiring resistance.

A wiring layer may be provided over the insulator 327 and the conductor 330. For example, in FIG. 44, an insulator 350, an insulator 352, and an insulator 354 are stacked in this order. Furthermore, a conductor 356 is formed in the insulator 350, the insulator 352, and the insulator 354. The conductor 356 functions as a plug or a wiring. Note that the conductor 356 can be provided using a material similar to those for the conductor 328, the conductor 329, and the conductor 330.

Note that for example, as the insulator 350, like the insulator 324, an insulator having a barrier property against hydrogen is preferably used. Furthermore, the conductor 356 preferably contains a conductor having a barrier property against hydrogen. In particular, the conductor having a barrier property against hydrogen is formed in an opening portion of the insulator 350 having a barrier property against hydrogen. With this structure, the transistor 301 and the like and the memory elements MC can be separated by the barrier layer, so that the diffusion of hydrogen from the transistor 301 and the like into the memory elements MC can be inhibited.

Note that for the conductor having a barrier property against hydrogen, tantalum nitride or the like is preferably used, for example. In addition, the use of a stack including tantalum nitride and tungsten, which has high conductivity, can inhibit the diffusion of hydrogen from the transistor 301 and the like while the conductivity of a wiring is maintained. In that case, a structure is preferable in which a tantalum nitride layer having a barrier property against hydrogen is in contact with the insulator 350 having a barrier property against hydrogen.

A wiring layer may be provided over the insulator 354 and the conductor 356. For example, in FIG. 44, an insulator 360, an insulator 362, and an insulator 364 are stacked in this order. Furthermore, a conductor 366 is formed in the insulator 360, the insulator 362, and the insulator 364. The conductor 366 functions as a plug or a wiring. Note that the conductor 366 can be provided using a material similar to those for the conductor 328, the conductor 329, and the conductor 330.

Note that for example, as the insulator 360, like the insulator 324, an insulator having a barrier property against hydrogen is preferably used. Furthermore, the conductor 366 preferably contains a conductor having a barrier property against hydrogen. In particular, the conductor having a barrier property against hydrogen is formed in an opening portion of the insulator 360 having a barrier property against hydrogen. With this structure, the transistor 301 and the like and the memory elements MC can be separated by the barrier layer, so that the diffusion of hydrogen from the transistor 301 and the like into the memory elements MC can be inhibited.

The insulator 722 is provided over the insulator 364 and the conductor 366, and the memory array 220 is provided above the insulator 722. A barrier film formed using a material similar to that for the insulator 324 may be provided between the insulator 364 and the insulator 722.

This embodiment can be implemented in an appropriate combination with the structures described in the other embodiments and the like.

### (Embodiment 5)

In this embodiment, application examples of the memory device of one embodiment of the present invention will be described.

A computer generally includes, as its components, a processor, a main memory, storage, and the like on a motherboard, which are electrically connected to one another through a bus line, for example. Thus, the parasitic resistance increases as the bus line lengthens, resulting in increasing power consumption required for signal transmission.

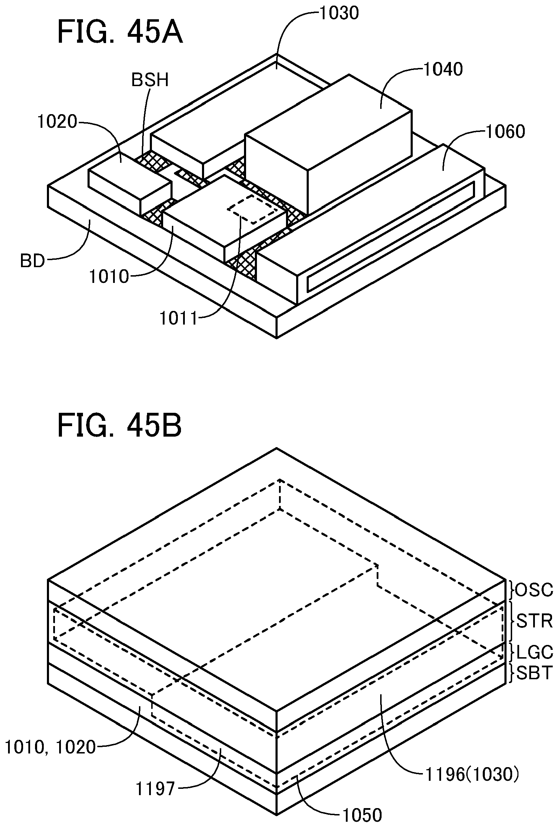

Specifically, the computer has a structure illustrated in FIG. 45A, for example. The computer includes a motherboard BD, and an arithmetic processing device (a processor, a CPU, or the like) 1010, a main memory (a DRAM (Dynamic Random Access Memory) or the like) 1030, storage (a three-dimensional NAND memory device (3D NAND type), a 3D OS NAND memory device, or the like) 1040, an interface 1060, and the like are provided on the motherboard BD. Although an SRAM (Static Random Access Memory) 1020 that also functions as a main memory is illustrated in FIG. 45, it is not necessarily provided on the motherboard BD.

Note that FIG. 45 illustrates a structure in which the arithmetic processing device 1010 includes a register 1011.

In FIG. 45A, the arithmetic processing device 1010 is electrically connected to the SRAM 1020, the main memory 1030, the storage 1040, and the interface 1060. The main memory 1030 is electrically connected to the SRAM 1020 and the storage 1040.

Note that the components of the computer in FIG. 45A are electrically connected to one another through a bus line BSH. This means that as the number of components of the computer increases or the motherboard BD increases in size, the bus line BSH to be routed lengthens; thus, the power consumption required for signal transmission increases.

The components of the computer in FIG. 45A may be integrated into one chip to form a monolithic IC (Integrated Circuit). In this case, the memory device in FIG. 10 or the like described in the above embodiment can be used as the main memory 1030 and the storage 1040. The case where the computer in FIG. 45A is made as a monolithic IC in this manner is illustrated in FIG. 45B.

The monolithic IC in FIG. 45B includes a circuit layer LGC over a semiconductor substrate containing Si. The monolithic IC also includes a memory layer STR over the circuit layer LGC and a circuit layer OSC over the memory layer STR.

The circuit layer LGC includes a plurality of circuits including Si transistors formed on a semiconductor substrate SBT containing Si, for example. As part of the plurality of circuits, the arithmetic processing device 1010, the SRAM 1020, and the like in FIG. 45A can be used, for example. In the case where the memory device in FIG. 10 or the like is used as the main memory 1030 and the storage 1040, part of the plurality of circuits can be a controller 1197 included in a data processing device 1050.

In particular, by using a Si transistor for the SRAM 1020, for example, the drive frequency of the SRAM can be increased.

The memory layer STR functions as a memory unit including a Si transistor and/or an OS transistor. The memory layer STR can be, for example, a three-dimensional NAND memory circuit, a 3D OS NAND memory circuit, or the like. Thus, the memory layer STR includes the memory device in FIG. 10, the storage 1040 in FIG. 45A, and the like.

The use of the 3D OS NAND memory circuit can reduce the power consumption of the monolithic IC in FIG. 45B.

The circuit layer OSC includes a plurality of circuits including OS transistors, for example. As part of the plurality of circuits, for example, a circuit that is different from the circuits included in the circuit layer LGC, such as the arithmetic processing device 1010 and the SRAM 1020, can be used.

In the monolithic IC in FIG. 45B, the bus line BSH to be routed on the motherboard is not provided, resulting in short lines electrically connecting the components. Accordingly, the power consumption required for signal transmission can be reduced.

The monolithic IC in FIG. 45B also includes the data processing device 1050. Thus, the data processing device 1050 functions as both the storage 1040 and the main memory 1030 in FIG. 45A. Therefore, in the monolithic IC in FIG. 45B, the memory unit 1196 of the memory layer STR can function as the main memory 1030.

The bus line BSH is not provided and the memory unit 1196 is used as an alternative to the main memory 1030, whereby the circuit area in the monolithic IC in FIG. 45B can be smaller than that in the computer in FIG. 45A.

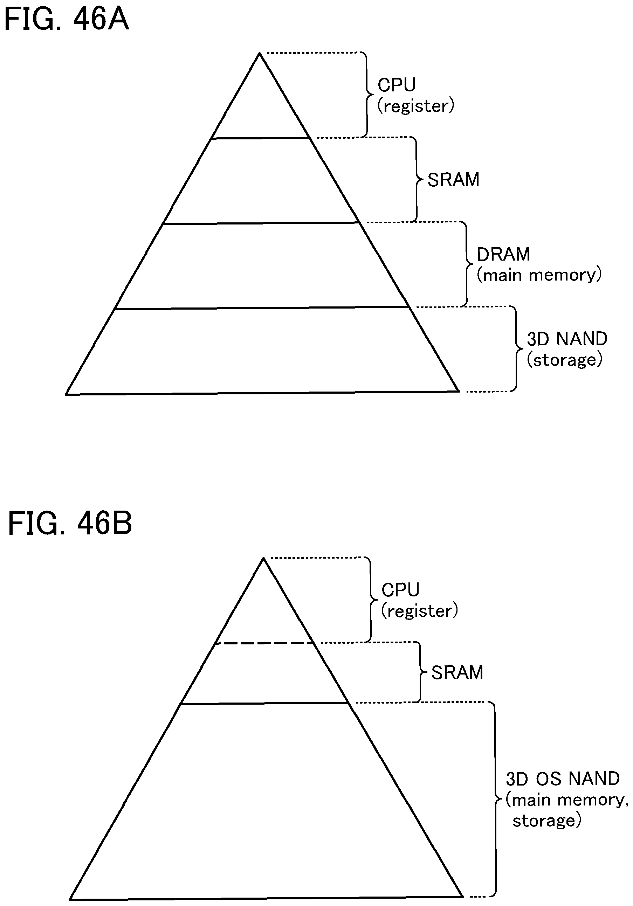

FIG. 46A and FIG. 46B show memory hierarchy examples of the computer in FIG. 45A and the monolithic IC in FIG. 45B, respectively.

In a general memory hierarchy, memory devices at the upper levels require higher operation speed, and memory devices at the lower levels require larger storage capacity and higher record density. For example, FIG. 46A shows, in order from the top, a register included in the CPU (the arithmetic processing device 1010), the SRAM, the DRAM included in the main memory 1030, and the three-dimensional NAND memory circuit included in the storage 1040.

The register included in the arithmetic processing device 1010 and the SRAM are used for temporary storage of arithmetic operation results, for example, and thus are frequently accessed by the arithmetic processing device 1010. Accordingly, high operation speed is required rather than memory capacity. The register also has a function of retaining setting information of the arithmetic processing device, for example.

The DRAM included in the main memory 1030 has a function of retaining a program and data read from the storage 1040, for example. The record density of the DRAM is approximately 0.1 Gbit/mm² to 0.3 Gbit/mm².

The storage 1040 has a function of retaining data that needs to be stored for a long time and a variety of programs used in the arithmetic processing device, for example. Therefore, the storage 1040 needs to have large storage capacity and high record density rather than operation speed. The record density of a memory device used for the storage 1040 is approximately 0.6 Gbit/mm² to 6.0 Gbit/mm². Thus, a three-dimensional NAND memory circuit, a hard disk drive (HDD), or the like is used as the storage 1040.

Since the monolithic IC in FIG. 45B functions as the storage 1040 and the main memory 1030 in FIG. 45A, the memory hierarchy of the monolithic IC in FIG. 45B is as shown in FIG. 46B.

In other words, in the monolithic IC in FIG. 45B, a memory cell included in the memory unit of the data processing device 1050 can be used not only as a cache memory of the memory unit but also as the main memory 1030 in the computer in FIG. 45A. Accordingly, the main memory 1030 such as a DRAM does not need to be provided in the monolithic IC in FIG. 45B, resulting in a smaller circuit area in the monolithic IC in FIG. 45B and lower power consumption required for the operation of the main memory 1030 such as a DRAM.

Note that the structure of the monolithic IC illustrated in FIG. 45B is an example and is not limited to one embodiment of the present invention. The structure of the monolithic IC illustrated in FIG. 45B may be changed depending on the situation. For example, in the case where a high-speed memory of 1 GHz or higher is required as the SRAM in the monolithic IC in FIG. 45B, the SRAM may be included in the arithmetic processing device.

Note that this embodiment can be combined as appropriate with any of the other embodiments in this specification.

### (Embodiment 6)

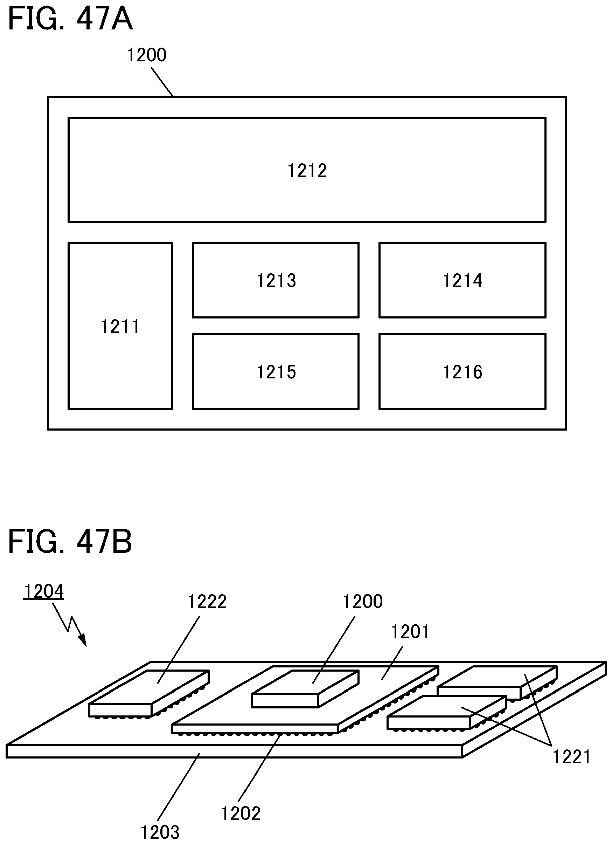

In this embodiment, an example of a chip 1200 that is a kind of semiconductor device on which the memory device of the present invention is mounted will be described with reference to FIG. 47A and FIG. 47B. A plurality of circuits (systems) are mounted on the chip 1200. The technology for integrating a plurality of circuits (systems) into one chip is referred to as system on chip (SoC) in some cases.

As illustrated in FIG. 47A, the chip 1200 includes a CPU 1211, a GPU 1212, one or a plurality of analog arithmetic units 1213, one or a plurality of memory controllers 1214, one or a plurality of interfaces 1215, one or a plurality of network circuits 1216, and the like.

A bump (not illustrated) is provided on the chip 1200, and as illustrated in FIG. 47B, the chip 1200 is connected to a first surface of a printed circuit board (PCB) 1201. A plurality of bumps 1202 are provided on the rear side of the first surface of the PCB 1201, whereby the PCB 1201 is connected to a motherboard 1203.

Memory devices such as DRAMs 1221 and a flash memory 1222 may be provided over the motherboard 1203. As the flash memory 1222, any of the semiconductor devices described in the above embodiments is preferably used. When any of the semiconductor devices described in the above embodiments is used as the flash memory 1222, the flash memory 1222 can have large storage capacity.

The CPU 1211 preferably includes a plurality of CPU cores. The GPU 1212 preferably includes a plurality of GPU cores. The CPU 1211 and the GPU 1212 may each include a memory for temporarily storing data. Alternatively, a common memory for the CPU 1211 and the GPU 1212 may be provided on the chip 1200. Moreover, the GPU 1212 is suitable for parallel computation of a number of data and thus can be used for image processing and a product-sum operation. When an image processing circuit and a product-sum operation circuit are provided in the GPU 1212, image processing and a product-sum operation can be performed with low power consumption.

Since the CPU 1211 and the GPU 1212 are provided on the same chip, a wiring between the CPU 1211 and the GPU 1212 can be shortened; accordingly, the data transfer from the CPU 1211 to the GPU 1212, the data transfer between the memories included in the CPU 1211 and the GPU 1212, and the transfer of arithmetic operation results from the GPU 1212 to the CPU 1211 after the arithmetic operation in the GPU 1212 can be performed at high speed.

The analog arithmetic unit 1213 includes one or both of an A/D (analog/digital) converter circuit and a D/A (digital/analog) converter circuit. Furthermore, the product-sum operation circuit may be provided in the analog arithmetic unit 1213.

The memory controller 1214 includes a circuit functioning as a controller of the DRAM 1221 and a circuit functioning as an interface of the flash memory 1222.

The interface 1215 includes an interface circuit for an external connection device such as a display device, a speaker, a microphone, a camera, or a controller. Examples of the controller include a mouse, a keyboard, and a game controller. As such an interface, a USB (Universal Serial Bus), an HDMI (registered trademark) (High-Definition Multimedia Interface), or the like can be used.

The network circuit 1216 includes a network circuit for the connection to a LAN (Local Area Network) or the like. The network circuit 1216 may further include a circuit for network security.

The circuits (systems) can be formed on the chip 1200 through the same manufacturing process. Therefore, even when the number of circuits needed for the chip 1200 increases, there is no need to increase the number of steps in the manufacturing process; thus, the chip 1200 can be manufactured at low cost.

The motherboard 1203 provided with the PCB 1201 on which the chip 1200 including the GPU 1212 is mounted, the DRAMs 1221, and the flash memory 1222 can be referred to as a GPU module 1204.

The GPU module 1204 includes the chip 1200 using the SoC technology, and thus can have a small size. In addition, the GPU module 1204 is excellent in image processing, and thus is suitably used in a portable electronic device such as a smartphone, a tablet terminal, a laptop PC, or a portable (mobile) game machine. Furthermore, the product-sum operation circuit using the GPU 1212 can perform a method such as a deep neural network (DNN), a convolutional neural network (CNN), a recurrent neural network (RNN), an autoencoder, a deep Boltzmann machine (DBM), or a deep belief network (DBN); hence, the chip 1200 can be used as an AI chip or the GPU module 1204 can be used as an AI system module.

The structure described in this embodiment can be used in an appropriate combination with the structures described in the other embodiments and the like.

### (Embodiment 7)

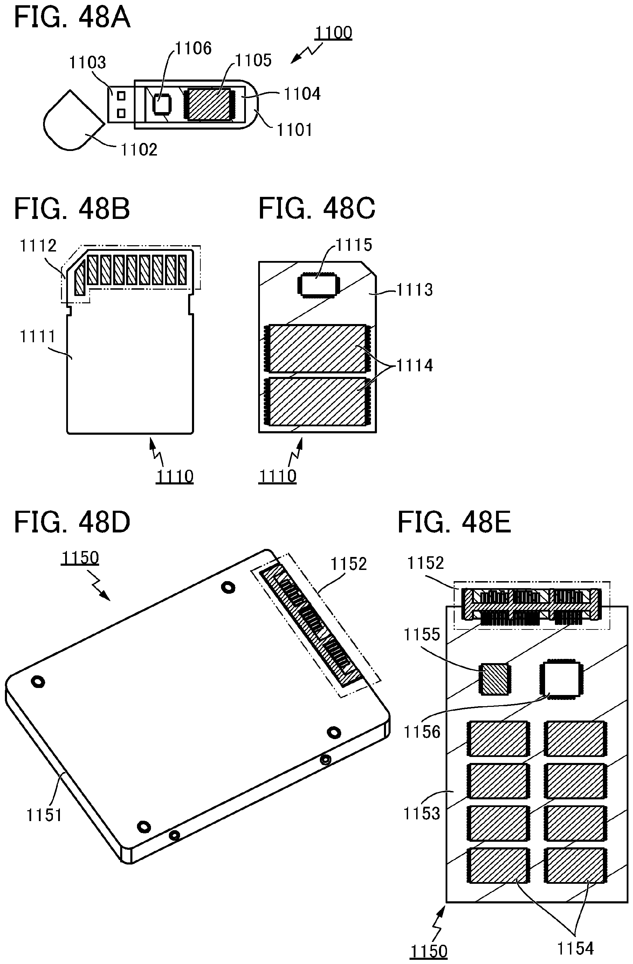

In this embodiment, application examples of the semiconductor device using the memory device described in the above embodiment will be described. The memory device described in the above embodiment can be used for a variety of removable memory devices such as memory cards (e.g., SD cards), USB memories, and SSDs (solid state drives). FIG. 48A to FIG. 48E schematically illustrate some structure examples of removable memory devices. The semiconductor device described in the above embodiment is processed into a packaged memory chip and used in a variety of storage devices and removable memories, for example.

FIG. 48A is a schematic diagram of a USB memory. A USB memory 1100 includes a housing 1101, a cap 1102, a USB connector 1103, and a substrate 1104. The substrate 1104 is held in the housing 1101. The substrate 1104 is provided with a memory chip 1105 and a controller chip 1106, for example. The memory device or the semiconductor device described in the above embodiment can be incorporated in the memory chip 1105 or the like.

FIG. 48B is a schematic external diagram of an SD card, and FIG. 48C is a schematic diagram of the internal structure of the SD card. An SD card 1110 includes a housing 1111, a connector 1112, and a substrate 1113. The substrate 1113 is held in the housing 1111. The substrate 1113 is provided with a memory chip 1114 and a controller chip 1115, for example. When the memory chip 1114 is also provided on the back side of the substrate 1113, the capacity of the SD card 1110 can be increased. In addition, a wireless chip with a radio communication function may be provided on the substrate 1113. In that case, data can be read from and written to the memory chip 1114 through radio communication between a host device and the SD card 1110. The memory device or the semiconductor device described in the above embodiment can be incorporated in the memory chip 1114 or the like.

FIG. 48D is a schematic external diagram of an SSD, and FIG. 48E is a schematic diagram of the internal structure of the SSD. An SSD 1150 includes a housing 1151, a connector 1152, and a substrate 1153. The substrate 1153 is held in the housing 1151. The substrate 1153 is provided with a memory chip 1154, a memory chip 1155, and a controller chip 1156, for example. The memory chip 1155 is a work memory of the controller chip 1156, and a DOSRAM chip can be used, for example. When the memory chip 1154 is also provided on the back side of the substrate 1153, the capacity of the SSD 1150 can be increased. The memory device or the semiconductor device described in the above embodiment can be incorporated in the memory chip 1154 or the like.

This embodiment can be implemented in an appropriate combination with the structures described in the other embodiments and the like.

### (Embodiment 8)

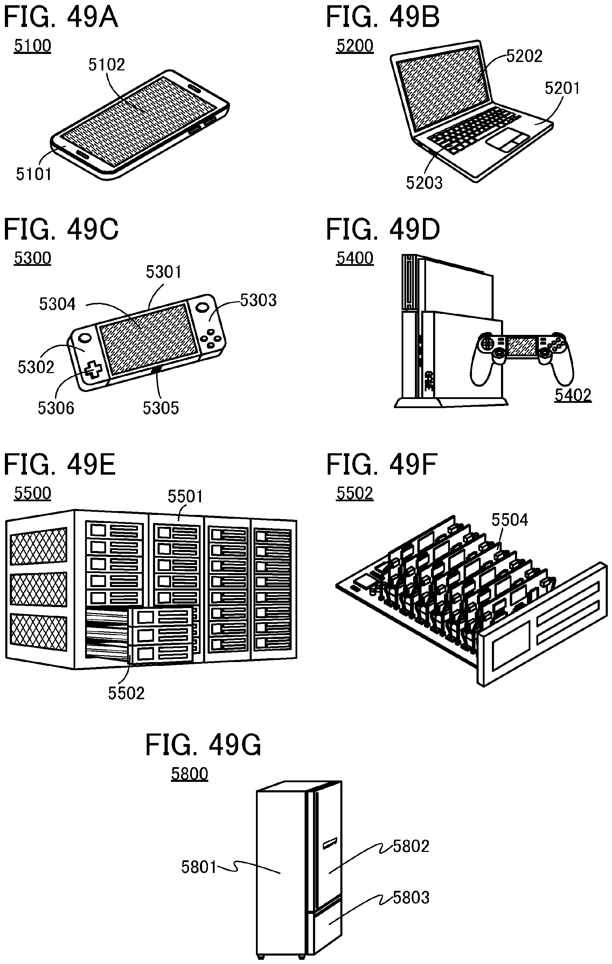

FIG. 49A to FIG. 49G illustrate specific examples of electronic devices each provided with the memory device or the semiconductor device of one embodiment of the present invention.

### <Electronic device and system>

The memory device or the semiconductor device of one embodiment of the present invention can be mounted on a variety of electronic devices. Examples of electronic devices include an information terminal, a computer, a smartphone, an e-book reader, a television device, digital signage, a large game machine such as a pachinko machine, a digital camera, a digital video camera, a digital photo frame, a mobile phone, a portable game machine, a video recording/reproducing device, a navigation system, and an audio reproducing device. Here, the computer refers not only to a tablet computer, a notebook computer, and a desktop computer, but also to a large computer such as a server system.

The electronic device of one embodiment of the present invention may include an antenna. When a signal is received by the antenna, a video, data, or the like can be displayed on a display portion. When the electronic device includes an antenna and a secondary battery, the antenna may be used for contactless power transmission.

The electronic device of one embodiment of the present invention may include a sensor (a sensor having a function of measuring force, displacement, position, speed, acceleration, angular velocity, rotational frequency, distance, light, liquid, magnetism, temperature, a chemical substance, sound, time, hardness, an electric field, current, voltage, power, radioactive rays, flow rate, humidity, a gradient, oscillation, odor, or infrared rays).

The electronic device of one embodiment of the present invention can have a variety of functions. For example, the electronic device can have a function of displaying a variety of data (a still image, a moving image, a text image, or the like) on the display portion, a touch panel function, a function of displaying a calendar, date, time, and the like, a function of executing a variety of software (programs), a wireless communication function, and a function of reading out a program or data stored in a recording medium.

### [Information terminal]

With the memory device or the semiconductor device of one embodiment of the present invention, a memory device for storing a microcontroller program can be configured. Thus, according to one embodiment of the present invention, a microcontroller chip can be downsized.

FIG. 49A illustrates a mobile phone (smartphone), which is a type of information terminal. An information terminal 5100 includes a housing 5101 and a display portion 5102. As input interfaces, a touch panel is provided in the display portion 5102, and a button is provided in the housing 5101. The use of a downsized microcontroller of one embodiment of the present invention allows effective use of a limited space in the mobile phone. The memory device of one embodiment of the present invention may be used for storage of the mobile phone. This results in an increase in the storage capacity per unit area of the storage.

FIG. 49B illustrates a notebook information terminal 5200. The notebook information terminal 5200 includes a main body 5201 of the information terminal, a display portion 5202, and a keyboard 5203. The use of a downsized microcontroller of one embodiment of the present invention allows effective use of a limited space in the notebook information terminal. The memory device of one embodiment of the present invention may be used for storage of the notebook information terminal. This results in an increase in the storage capacity per unit area of the storage.

Note that although FIG. 49A and FIG. 49B illustrate a smartphone and a notebook information terminal, respectively, as examples of the electronic device in the above description, an information terminal other than a smartphone and a notebook information terminal can be used. Examples of information terminals other than a smartphone and a notebook information terminal include a PDA (Personal Digital Assistant), a desktop information terminal, and a workstation.

### [Game machines]

FIG. 49C illustrates a portable game machine 5300 as an example of a game machine. The portable game machine 5300 includes a housing 5301, a housing 5302, a housing 5303, a display portion 5304, a connection portion 5305, an operation key 5306, and the like. The housing 5302 and the housing 5303 can be detached from the housing 5301. When the connection portion 5305 provided in the housing 5301 is attached to another housing (not illustrated), an image to be output to the display portion 5304 can be output to another video device (not illustrated). In that case, the housing 5302 and the housing 5303 can each function as an operating unit. Thus, a plurality of players can play a game at the same time. The memory device, the semiconductor device, or the like of one embodiment of the present invention can be incorporated into a chip provided on a substrate in the housing 5301, the housing 5302, and the housing 5303, for example.

FIG. 49D illustrates a stationary game machine 5400 as an example of a game machine. A controller 5402 is connected to the stationary game machine 5400 through wired or wireless connection.

The use of a downsized microcontroller of one embodiment of the present invention for the game machine such as the portable game machine 5300 or the stationary game machine 5400 allows effective use of a limited space in the game machine. The memory device, the semiconductor device, or the like of one embodiment of the present invention may be used for storage of the portable game machine. This results in an increase in the storage capacity per unit area of the storage.

Although the portable game machine and the stationary game machine are illustrated as examples of game machines in FIG. 49C and FIG. 49D, the game machine using the microcontroller of one embodiment of the present invention is not limited thereto. Examples of game machines using the microcontroller of one embodiment of the present invention include an arcade game machine installed in entertainment facilities (a game center, an amusement park, or the like) and a throwing machine for batting practice installed in sports facilities.

### [Large computer]

The memory device, the semiconductor device, or the like of one embodiment of the present invention can be used in a large computer.

FIG. 49E is a diagram illustrating a supercomputer 5500 as an example of a large computer. FIG. 49F is a diagram illustrating a rack-mount computer 5502 included in the supercomputer 5500.

The supercomputer 5500 includes a rack 5501 and a plurality of rack-mount computers 5502. The plurality of computers 5502 are stored in the rack 5501. The computers 5502 are provided with a plurality of substrates 5504, and a microcontroller of one embodiment of the present invention can be mounted on the substrates. The use of a downsized microcontroller of one embodiment of the present invention allows effective use of a limited space in the large computer. The memory device, the semiconductor device, or the like of one embodiment of the present invention may be used for storage of the large computer. This results in an increase in the storage capacity per unit area of the storage.

Although the supercomputer is illustrated as an example of a large computer in FIG. 49E and FIG. 49F, a large computer using the microcontroller of one embodiment of the present invention is not limited thereto. Examples of a large computer using the microcontroller of one embodiment of the present invention include a computer that provides service (a server) and a large general-purpose computer (a mainframe).

### [Household appliance]

FIG. 49G illustrates an electric refrigerator-freezer 5800 as an example of a household appliance. The electric refrigerator-freezer 5800 includes a housing 5801, a refrigerator door 5802, a freezer door 5803, and the like.

The memory device, the semiconductor device, or the like of one embodiment of the present invention can also be used for the electric refrigerator-freezer 5800. For example, the use of a downsized microcontroller of one embodiment of the present invention for the electric refrigerator-freezer 5800 allows effective use of a limited space in the electric refrigerator-freezer.

Although the electric refrigerator-freezer is described as an example of a household appliance, other examples of a household appliance include a vacuum cleaner, a microwave oven, an electric oven, a rice cooker, a water heater, an IH cooker, a water server, a heating-cooling combination appliance such as an air conditioner, a washing machine, a drying machine, and an audio visual appliance.

The electronic devices, the functions of the electronic devices, their effects, and the like described in this embodiment can be combined as appropriate with the description of another electronic device.

This embodiment can be implemented in an appropriate combination with the structures described in the other embodiments and the like.

### [Reference Numerals]

21: layer, 31: layer, 41: layer, 50: structure body, 53: region, 58: region, 60: oxide, 64: oxide, 100: memory device, 105: region, 110: memory cell array, 120: memory string, 120A: memory string, 120B: memory string, 120C: memory string, 121: substrate, 122: conductor, 123: insulator, 123A: insulating film, 124: insulator, 124A: insulating film, 125: semiconductor, 125A: semiconductor film, 125B: semiconductor, 126: insulator, 126A: insulating film, 126B: insulator, 127: semiconductor, 127A: semiconductor film, 128: conductor, 128A: conductive film, 129: insulator, 129A: insulating film, 130: conductor, 130A: conductive film, 131: insulator, 131A: insulator, 132: insulator, 135: insulator, 135A: insulating film, 136: conductor, 136A: conductive film, 137: insulator, 137A: insulating film, 138: insulator, 138A: insulating film, 139: insulator, 140: mask, 140A: mask, 140B: mask, 141: opening, 142: region, 143: region, 150: insulator, 156: insulator, 161: conductor, 162: conductor, 163: conductor, 164: conductor, 165: conductor, 166: conductor, 171: conductor, 172: conductor, 173: conductor, 174: conductor, 175: conductor, 176: conductor, 181: insulator, 182: conductor, 183: conductor, 185: axis, 200: semiconductor device, 210: driver circuit, 211: peripheral circuit, 212: control circuit, 215: peripheral circuit, 220: memory array, 221: row decoder, 222: column decoder, 223: row driver, 224: column driver, 225: input circuit, 226: output circuit, 227: sense amplifier, 228: voltage generation circuit, 241: PSW, 242: PSW, 301: transistor, 302: transistor, 303: transistor, 311: substrate, 313: semiconductor region, 314a: low-resistance region, 314b: low-resistance region, 315: insulator, 316: conductor, 317: insulator, 318: insulator, 320: insulator, 322: insulator, 324: insulator, 326: insulator, 327: insulator, 328: conductor, 329: conductor, 330: conductor, 350: insulator, 352: insulator, 354: insulator, 356: conductor, 360: insulator, 362: insulator, 364: insulator, 366: conductor, 705: conductor, 714: conductor, 715: conductor, 722: insulator, 726: insulator, 752: conductor, 1010: arithmetic processing device, 1011: register, 1020: SRAM, 1030: main memory, 1040: storage, 1050: data processing device, 1060: interface, 1100: USB memory, 1101: housing, 1102: cap, 1103: USB connector, 1104: substrate, 1105: memory chip, 1106: controller chip, 1110: SD card, 1111: housing, 1112: connector, 1113: substrate, 1114: memory chip, 1115: controller chip, 1150: SSD, 1151: housing, 1152: connector, 1153: substrate, 1154: memory chip, 1155: memory chip, 1156: controller chip, 1196: memory unit, 1197: controller, 1200: chip, 1201: PCB, 1202: bump, 1203: motherboard, 1204: GPU module, 1211: CPU, 1212: GPU, 1213: analog arithmetic unit, 1214: memory controller, 1215: interface, 1216: network circuit, 1221: DRAM, 1222: flash memory, 2700: manufacturing apparatus, 2701: atmosphere-side substrate supply chamber, 2702: atmosphere-side substrate transfer chamber, 2703a: load lock chamber, 2703b: unload lock chamber, 2704: transfer chamber, 2706a: chamber, 2706b: chamber, 2706c: chamber, 2706d: chamber, 2761: cassette port, 2762: alignment port, 2763a: transfer robot, 2763b: transfer robot, 2801: gas supply source, 2802: valve, 2803: high-frequency generator, 2804: waveguide, 2805: mode converter, 2806: gas pipe, 2807: waveguide, 2808: slot antenna plate, 2809: dielectric plate, 2810: high-density plasma, 2811: substrate, 2811_*n*: substrate, 2811_*n*-1: substrate, 2811_*n*-2: substrate, 2811_1: substrate, 2811_2: substrate, 2811_3: substrate, 2812: substrate holder, 2813: heating mechanism, 2815: matching box, 2816: high-frequency power source, 2817: vacuum pump, 2818: valve, 2819: exhaust port, 2820: lamp, 2821: gas supply source, 2822: valve, 2823: gas inlet, 2824: substrate, 2825: substrate holder, 2826: heating mechanism, 2828: vacuum pump, 2829: valve, 2830: exhaust port, 2900: microwave treatment apparatus, 2901: quartz tube, 2902: substrate holder, 2903: heating means, 4000: deposition apparatus, 4002: carrying-in/out chamber, 4004: carrying-in/out chamber, 4006: transfer chamber, 4008: deposition chamber, 4009: deposition chamber, 4010: deposition chamber, 4014: transfer arm, 4020: chamber, 4021: source material supply portion, 4021a: source material supply portion, 4021b: source material supply portion, 4022a: high-speed valve, 4022b: high-speed valve, 4023: source material introduction port, 4023a: source material introduction port, 4023b: source material introduction port, 4024: source material exhaust port, 4025: evacuation unit, 4026: substrate holder, 4027: heater, 4028: plasma generation apparatus, 4029: coil, 4030: substrate, 4031: source material supply portion, 4033: source material introduction port, 4100: plasma ALD apparatus, 4111: plasma generation chamber, 4120: reaction chamber, 4123: source material introduction port, 4124: source material exhaust port, 4126: substrate holder, 4128: plasma generation apparatus, 4130: substrate, 4131: plasma, 4133: source material introduction port, 4200: plasma ALD apparatus, 4213: electrode, 4214: shower head, 4215: power source, 4217: capacitor, 4220: chamber, 4223: source material introduction port, 4224: source material exhaust port, 4226: substrate holder, 4230: substrate, 4231: plasma, 4300: plasma ALD apparatus, 4313: electrode, 4314: shower head, 4315: power source, 4317: capacitor, 4319: mesh, 4320: chamber, 4321: power source, 4322: capacitor, 4323: source material introduction port, 4324: source material exhaust port, 4326: substrate holder, 4330: substrate, 4331: plasma, 5100: information terminal, 5101: housing, 5102: display portion, 5200: notebook information terminal, 5201: main body, 5202: display portion, 5203: keyboard, 5300: portable game machine, 5301: housing, 5302: housing, 5303: housing, 5304: display portion, 5305: connection portion, 5306: operation key, 5400: stationary game machine, 5402: controller, 5500: supercomputer, 5501: rack, 5502: computer, 5504: substrate, 5800: electric refrigerator-freezer, 5801: housing, 5802: refrigerator door, 5803: freezer door

## Claims

1. A method for depositing a metal oxide, comprising:
a first step of introducing a first precursor into a first chamber and introducing an oxidizer in a plasma state into the first chamber;
a second step of introducing a second precursor into the first chamber and introducing the oxidizer in the plasma state into the first chamber;
a third step of introducing a third precursor into the first chamber and introducing the oxidizer in the plasma state into the first chamber; and
a fourth step of performing microwave treatment,
wherein performing each of the first to third steps one or more times is regarded as one cycle,
wherein the fourth step is performed in a second chamber after the one cycle is repeated a plurality of times,
wherein the first to third precursors are different kinds of precursors,
wherein the microwave treatment is performed using an oxygen gas and an argon gas,
wherein the metal oxide comprises a crystal region, and
wherein a c-axis of the crystal region is substantially parallel to a normal vector of a surface where the metal oxide is formed or a normal vector of a surface of the metal oxide.

2. A method for depositing a metal oxide, comprising:
a first step of introducing a first precursor into a first chamber and introducing an oxidizer into the first chamber;
a second step of introducing a second precursor into the first chamber and introducing the oxidizer into the first chamber;
a third step of introducing a third precursor into the first chamber and introducing the oxidizer into the first chamber; and
a fourth step of performing microwave treatment,
wherein performing each of the first to third steps one or more times is regarded as one cycle,
wherein the fourth step is performed in a second chamber after the one cycle is repeated a plurality of times,
wherein the first to third precursors are different kinds of precursors,
wherein the microwave treatment is performed using an oxygen gas and an argon gas,
wherein the metal oxide comprises a crystal region, and
wherein a c-axis of the crystal region is substantially parallel to a normal vector of a surface where the metal oxide is formed or a normal vector of a surface of the metal oxide.

3. A method for depositing a metal oxide, comprising:
a first step of introducing a first precursor into a chamber and introducing an oxidizer in a plasma state into the chamber;
a second step of introducing a second precursor into the chamber and introducing the oxidizer in the plasma state into the chamber; and
a third step of introducing a third precursor into the chamber and introducing the oxidizer in the plasma state into the chamber,
wherein the oxidizer turns into a plasma state by being applied with a microwave with a frequency of 2.45 GHz,
wherein performing each of the first to third steps one or more times is regarded as one cycle and the one cycle is repeated a plurality of times,
wherein the first to third precursors are different kinds of precursors,
wherein the metal oxide comprises a crystal region, and
wherein a c-axis of the crystal region is substantially parallel to a normal vector of a surface where the metal oxide is formed or a normal vector of a surface of the metal oxide.

4. The method for depositing a metal oxide, according to claim 1 or claim 2,
wherein the one cycle is repeated a plurality of times after the fourth step.

5. The method for depositing a metal oxide, according to any one of claim 1 to claim 4,
wherein the first precursor comprises indium,
wherein the second precursor comprises an element *M* (*M* is any one or more of gallium, aluminum, and yttrium),
wherein the third precursor comprises zinc, and
wherein the oxidizer comprises one or more selected from ozone, oxygen, and water.

6. A method for manufacturing a memory device, the memory device comprising:
a first insulator;
a first conductor comprising a first opening over the first insulator;
a second insulator comprising a second opening over the first conductor;
a second conductor comprising a third opening over the second insulator;
a third insulator over the second conductor; and
a metal oxide provided in the first opening to the third opening, the method for manufacturing a memory device comprising:
a step of forming the first insulator;
a step of forming the first conductor over the first insulator;
a step of forming the second insulator over the first conductor;
a step of forming a fourth insulator over the second insulator;
a step of forming the third insulator over the fourth insulator;
a step of forming the third opening in the fourth insulator;
a step of forming the second opening in the second insulator;
a step of forming the first opening in the first conductor;
a step of forming the metal oxide by an ALD method in the first opening to the third opening;
a step of performing microwave treatment;
a step of removing the fourth insulator; and
a step of forming the second conductor between the second insulator and the third insulator,
wherein the microwave treatment is performed using an oxygen gas and an argon gas,
wherein the metal oxide comprises a crystal region, and
wherein a c-axis of the crystal region is parallel to a normal vector of a surface where the metal oxide is formed or a normal vector of a surface of the metal oxide.

7. The method for manufacturing a memory device, according to claim 6,
wherein a diameter of the first opening is larger than a diameter of the second opening, and
wherein the diameter of the first opening is larger than a diameter of the third opening.
